# EUROPEAN PATENT SPECIFICATION

(11) **EP 4 373 243 B1**
(45) Date of publication and mention of the grant of the patent: **20.08.2025**
(21) Application number: 23737442.6
(22) Date of filing: 06.01.2023
(51) Int. Cl.: C09K 11/06, H10K 85/60, H10K 50/11

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 07.01.2022 KR 20220002929; 05.01.2023 KR 20230001789
(43) Date of publication of application: 22.05.2024
(73) Proprietor: LG Chem, Ltd., Seoul 07336 (KR)
(72) Inventor: KIM, Young Seok, Daejeon 34122 (KR); KIM, Minjun, Daejeon 34122 (KR); SUH, Sang Duk, Daejeon 34122 (KR); LEE, Dong Hoon, Daejeon 34122 (KR); LEE, Jungha, Daejeon 34122 (KR); OH, Mintaek, Daejeon 34122 (KR)
(74) Representative: Hoffmann Eitle
(86) International application number: PCT/KR2023/000302
(87) International publication number: WO 2023/132694

(56) References cited:
- WO-A1-2020/027389
- KR-A- 20170 125 555
- KR-A- 20180 099 487
- KR-A- 20180 099 487
- KR-A- 20210 098 316
- KR-A- 20210 109 436
- KR-A- 20210 109 436

## Description

### [TECHNICAL FIELD]

The present disclosure relates to an organic light emitting device having improved driving voltage, efficiency and lifetime.

### CROSS-REFERENCE TO RELATED APPLICATION(S)

This application claims the benefit of Korean Patent Application No. 10-2022-0002929 filed on January 7, 2022 and Korean Patent Application No. 10-2023-0001789 filed on January 5, 2023 in the Korean Intellectual Property Office.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again. Document KR20210109436 (A) discloses an OLED comprising two hosts in the light emitting layer and suggests the use of a three host system in the said layer.

There is a continuing need for the development of a new material for an organic material used in the organic light emitting device as described above.

### [Prior Art Literature]

### [Patent Literature]

(Patent Literature 1) Korean Unexamined Patent Publication No. 10-2000-0051826

### [DETAILED DESCRIPTION OF THE INVENTION]

### [Technical Problem]

It is an object of the present disclosure to provide an organic light emitting device having improved driving voltage, efficiency and lifetime.

### [Technical Solution]

The present disclosure provides the following organic light emitting device:
An organic light emitting device comprising:
an anode; a cathode; and a light emitting layer interposed between the anode and the cathode,
wherein the light emitting layer includes,
one or more compounds represented by the following Chemical Formula 1,
one or more compounds represented by the following Chemical Formula 2, and
one or more compounds represented by the following Chemical Formula 3:
in Chemical Formula 1,
Ar₁ and Ar₂ are each independently a substituted or unsubstituted C₆₋₆₀ aryl; or a substituted or unsubstituted C₂₋₆₀ heteroaryl containing one or more selected from the group consisting of N, O and S,
L₁ to L₃ are each independently a single bond; or a substituted or unsubstituted C₆₋₆₀ arylene,
each R₁ is independently hydrogen; deuterium; a substituted or unsubstituted C₆₋₆₀ aryl; or a substituted or unsubstituted C₂₋₆₀ heteroaryl containing one or more selected from the group consisting of N, O and S, and
a is an integer of 0 to 7,
in Chemical Formula 2,
X'₁ is N and X'₂ is O; or X'₁ is O, and X'₂ is N,
any one of R'₁ to R'₇ is linked with the following Chemical Formula 2A, and the rest are each independently hydrogen; deuterium; a substituted or unsubstituted C₆₋₆₀ aryl; or a substituted or unsubstituted C₂₋₆₀ heteroaryl containing one or more selected from the group consisting of N, O and S,
in Chemical Formula 2A,
L'₁ to L'₃ are each independently a single bond; or a substituted or unsubstituted C₆₋₆₀ arylene, and
Ar'₁ and Ar'₂ are each independently a substituted or unsubstituted C₆₋₆₀ aryl; or a substituted or unsubstituted C₂₋₆₀ heteroaryl containing one or more selected from the group consisting of N, O and S,
in Chemical Formula 3,
X" is O or S, and
any one of R"₁ to R"₁₀ is linked with the following Chemical formula 3A, and the rest are hydrogen or deuterium,
in Chemical Formula 3A,
L"₁ to L"₃ are each independently a single bond; or a substituted or unsubstituted C₆₋₆₀ arylene, and
Ar"₁ and Ar"₂ are each independently a substituted or unsubstituted C₆₋₆₀ aryl; or a substituted or unsubstituted C₂₋₆₀ heteroaryl containing one or more selected from the group consisting of N, O and S.

### [Advantageous Effects]

The organic light emitting device described above includes one or more compounds represented by Chemical Formula 1, one or more compounds represented by Chemical Formula 2 and one or more compounds represented by Chemical Formula 3 and thus, can improve the efficiency, achieve low driving voltage and/or improve lifetime characteristics in the organic light emitting device.

### [BRIEF DESCRIPTION OF THE DRAWINGS]

FIG. 1 shows an example of an organic light emitting device comprising a substrate 1, an anode 2, a light emitting layer 3, and a cathode 4.
FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron injection and transport layer 9, and a cathode 4.

### [DETAILED DESCRIPTION OF THE EMBODIMENTS]

Hereinafter, embodiments of the present disclosure will be described in more detail to facilitate understanding of the invention.

As used herein, the notation means a bond linked to another substituent group.

As used herein, the term "substituted or unsubstituted" means being unsubstituted or substituted with one or more substituent groups selected from the group consisting of deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent group to which two or more substituent groups of the above-exemplified substituent groups are linked. For example, "a substituent group in which two or more substituents are linked" may be a biphenyl group. Namely, a biphenyl group may be an aryl group, or it may be interpreted as a substituent group in which two phenyl groups are connected.

In the present disclosure, the carbon number of a carbonyl group is not particularly limited, but is preferably 1 to 40. Specifically, the carbonyl group may be a substituent group having the following structural formulas, but is not limited thereto.

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a substituent group having the following structural formulas, but is not limited thereto.

In the present disclosure, the carbon number of an imide group is not particularly limited, but is preferably 1 to 25. Specifically, the imide group may be a substituent group having the following structural formulas, but is not limited thereto.

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

**In** the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthrenyl group, a pyrenyl group, a perylenyl group, a chrysenyl group, or the like, but is not limited thereto.

In the present disclosure, the fluorenyl group may be substituted, and two substituent groups may be linked with each other to form a spiro structure. In the case where the fluorenyl group is substituted, and the like can be formed. However, the structure is not limited thereto.

In the present disclosure, a heterocyclic group is a heterocyclic group containing one or more of O, N, Si and S as a heteroatom, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can be applied to the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heterocyclic group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocycle is not a monovalent group but formed by combining two substituent groups.

Meanwhile, when the number of deuterium substitutions of a specific compound is made to be shown herein, it can be represented by '[structural formula]_{Dn}'. Here, 'Dn' means that n hydrogens of the compound represented by the 'structural formula' are replaced with deuterium.

Hereinafter, the present disclosure will be described in detail for each configuration.

### Anode and Cathode

An anode and a cathode used in the present disclosure mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Hole injection layer

The organic light emitting device according to the present disclosure may further include a hole injection layer on the anode, if necessary.

The hole injection layer is a layer injecting holes from an electrode, and the hole injection material is preferably a compound which has a capability of transporting the holes, has a hole injection effect in the anode and an excellent hole injection effect to the light emitting layer or the light emitting material, prevents movement of an exciton generated in the light emitting layer to the electron injection layer or the electron injection material, and is excellent in the ability to form a thin film. Further, it is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Hole Transport Layer

The organic light emitting device according to the present disclosure may include a hole transport layer on the anode (or on the hole injection layer if the hole injection layer exists), if necessary.

The hole transport layer is a layer that receives holes from a hole injection layer and transports the holes to the light emitting layer. The hole transport material is suitably a material having large mobility to the holes, which can receive injection of holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

### Electron Blocking Layer

The organic light emitting device according to the present disclosure includes an electron blocking layer on the hole transport layer, if necessary.

The electron blocking layer means a layer provided between the hole transport layer and the light emitting layer in order to prevent the electrons injected in the cathode from being transferred to the hole transport layer without being recombined in the light emitting layer, which may also be referred to as an electron stopping layer or an electron inhibition layer. The electron blocking layer is preferably a material having the smaller electron affinity than the electron transport layer.

### Light Emitting Layer

The light emitting layer used in the present disclosure is a layer that can emit light in the visible light region by combining holes and electrons transported from the anode and the cathode. Generally, the light emitting layer includes a host material and a dopant material, and in the present disclosure, the one or more compounds represented by Chemical Formula 1, the one or more compounds represented by Chemical Formula 2, and the one or more compounds represented by Chemical Formula 3 are included as a host.

Preferably, the compound represented by Chemical Formula 1 may be represented by any one of the following Chemical Formula 1-1 to Chemical Formula 1-3:
in Chemical Formula 1-1 to Chemical Formula 1-3,
Ar₁, Ar₂ and L₁ to L₃ are as defined in Chemical Formula 1, and
R₁ is deuterium; a substituted or unsubstituted C₆₋₆₀ aryl; or a substituted or unsubstituted a substituted or unsubstituted C₂₋₆₀ heteroaryl containing one or more selected from the group consisting of N, O and S.

Preferably, Ar₁ and Ar₂ may be each independently a substituted or unsubstituted C₆₋₂₀ aryl; or a substituted or unsubstituted C₂₋₂₀ heteroaryl containing one or more selected from the group consisting of N, O and S.

More preferably, Ar₁ and Ar₂ may be each independently phenyl, triphenylsilyl phenyl, biphenylyl, terphenylyl, naphthyl, phenanthrenyl, chrysenyl, benzo[c]phenanthrenyl, dibenzofuranyl, or dibenzothiophenyl, wherein the Ar₁ and Ar₂ may be each independently unsubstituted or substituted with at least one deuterium.

Most preferably, Ar₁ and Ar₂ may be each independently any one selected from the group consisting of the following, wherein hydrogen of each substituent in the following groups may be independently substituted with deuterium:

Preferably, L₁ to L₃ may be each independently a single bond; or a substituted or unsubstituted C₆₋₂₀ arylene.

More preferably, L₁ to L₃ may be each independently a single bond, phenylene, biphenyldiyl, naphthalenediyl, phenyl naphthalenediyl, or naphthyl naphthalenediyl, wherien when the L₁ to L₃ are phenylene, biphenyldiyl, naphthalenediyl, phenyl naphthalenediyl, or naphthyl naphthalenediyl, L₁ to L₃ may be unsubstituted or substituted with at least one deuterium.

Most preferably, L₁ to L₃ may be each independently a single bond, or any one selected from the group consisting of the following, wherein hydrogen of each linker in the following groups may be independently substituted with deuterium:

Preferably, each R₁ may be independently hydrogen; deuterium; a substituted or unsubstituted C₆₋₂₀ aryl; or a substituted or unsubstituted C₂₋₂₀ heteroaryl containing one or more selected from the group consisting of N, O and S.

More preferably, each R₁ may be independently hydrogen, deuterium, phenyl, biphenylyl, terphenylyl, naphthyl, phenanthrenyl, triphenylenyl, naphthyl phenyl, phenyl naphthyl, fluoranthenyl, dibenzofuranyl, dibenzothiophenyl, benzonaphthofuranyl, or benzonaphthothiophenyl, wherein when the R₁ is phenyl, biphenylyl, terphenylyl, naphthyl, phenanthrenyl, triphenylenyl, naphthyl phenyl, phenyl naphthyl, fluoranthenyl, dibenzofuranyl, dibenzothiophenyl, benzonaphthofuranyl, or benzonaphthothiophenyl, each R₁ may be independently unsubstituted or substituted with at least one deuterium.

Preferably, at least one of Ar₁, Ar₂ and R₁ may be phenyl, naphthyl, phenyl naphthyl, naphthyl phenyl, phenanthrenyl, fluoranthenyl, dibenzofuranyl, dibenzothiophenyl, benzonaphthofuranyl, or benzonaphthothiophenyl, wherein the Ar₁, Ar₂ and R₁ may be each independently unsubstituted or substituted with at least one deuterium.

More preferably, at least one of Ar₁, Ar₂ and R₁ may be phenyl, naphthyl, phenyl naphthyl, naphthyl phenyl, dibenzofuranyl, benzonaphthofuranyl, or benzonaphthothiophenyl, wherein the Ar₁, Ar₂ and R₁ may be each independently unsubstituted or substituted with at least one deuterium.

Preferably, a may be 0 or 1. More preferably, a may be 1.

Meanwhile, when the number of deuterium substitutions of the compound is made to be shown, it can be represented by the following Chemical Formula 1D:
in Chemical Formula 1D,
Dn means that n hydrogens are replaced with deuterium,
wherein, n is an integer of 13 or more,
Ar_{1d}, Ar_{2d}, L_{1d} to L_{3d} means Ar₁, Ar₂, L₁ to L₃ substituents, respectively, which are not substituted with deuterium,
R_{1d} is a substituted or unsubstituted C₆₋₆₀ aryl which is not substituted with deuterium; or a substituted or unsubstituted C₂₋₆₀ heteroaryl containing one or more selected from the group consisting of N, O and S, which are not substituted with deuterium, and
a is an integer of 0 to 7.

In one example, in Chemical Formula 1D, n of Dn may be13 or more, 14 or more, 15 or more, 16 or more, 17 or more, 18 or more, or 19 or more and 50 or less, 45 or less, 40 or less, 38 or less, 36 or less, 34 or less, 32 or less, 30 or less, 28 or less, 26 or less, 24 or less, 23 or less, 22 or less, 21 or less, or 20 or less.

Representative examples of the compound represented by Chemical Formula 1 are as follows:

The compound represented by Chemical Formula 1 wherein R₁ is hydrogen or deuterium can be prepared by a preparation method as shown in the following Reaction Scheme 1-1 as an example, the compound wherein R₁ is not hydrogen or deuterium can be prepared by a preparation method as shown in the following Reaction Scheme 1-2 as an example, and the other remaining compounds can be prepared in a similar manner.

In Reaction Schemes 1-1 and 1-2, Ar₁, Ar₂ and L₁ to L₃ are the same as defined in Chemical Formula 1, Z₁ to Z₃ are each independently halogen, preferably Z₁ to Z₃ are each independently chloro or bromo.

Reaction Schemes 1-1 and 1-2 are Suzuki coupling reactions, which are preferably carried out in the presence of a palladium catalyst and a base, and a reactive group for the Suzuki coupling reaction can be changed as known in the art. The preparation method can be further embodied in Preparation Examples described hereinafter.

Preferably, the compound represented by Chemical Formula 2 may be represented by either the following Chemical Formula 2-1 or Chemical Formula 2-2:
in Chemical Formula 2-1 and Chemical Formula 2-2,
R'₁ to R'₆ are hydrogen or deuterium,
R'₇ is a substituted or unsubstituted C₆₋₆₀ aryl; or a substituted or unsubstituted C₂₋₆₀ heteroaryl containing one or more selected from the group consisting of N, O and S, and
X'₁, X'₂, L'₁ to L'₃, Ar'₁ and Ar'₂ are as defined in Chemical Formula 2 and Chemical Formula 2A.

Preferably, any one of R'₁ to R'₇ is linked with Chemical Formula 2A, and the rest may be each independently hydrogen; deuterium; a substituted or unsubstituted C₆₋₂₀ aryl; or a substituted or unsubstituted C₂₋₂₀ heteroaryl containing one or more selected from the group consisting of N, O and S,

More preferably, any one of R'₁ to R'₇ is Chemical Formula 2A, and the rest may be each independently hydrogen, deuterium, phenyl, biphenylyl, or naphthyl, wherein the phenyl, biphenylyl and naphthyl may be each independently unsubstituted or substituted with at least one deuterium.

Preferably, L'₁ to L'₃ may be each independently a single bond; or a substituted or unsubstituted C₆₋₂₀ arylene.

More preferably, L'₁ to L'₃ may be each independently a single bond, phenylene, biphenyldiyl, terphenyldiyl, naphthalenediyl, or phenyl naphthalenediyl, wherein the phenylene, biphenyldiyl, terphenyldiyl, naphthalenediyl and phenyl naphthalenediyl may be each independently unsubstituted or substituted with at least one deuterium.

Preferably, Ar'₁ and Ar'₂ may be each independently a substituted or unsubstituted C₆₋₂₀ aryl; or a substituted or unsubstituted C₂₋₂₀ heteroaryl containing one or more selected from the group consisting of N, O and S.

More preferably, Ar'₁ and Ar'₂ may be each independently phenyl, biphenylyl, terphenylyl, naphthyl, phenyl naphthyl, phenanthrenyl, dimethylfluorenyl, dibenzofuranyl, dibenzothiophenyl, carbazolyl, or phenyl carbazolyl, wherein the Ar'₁ and Ar'₂ may be unsubstituted or substituted with at least one deuterium.

Representative examples of the compound represented by Chemical Formula 2 are as follows:

The compound represented by Chemical Formula 2 wherein L'₁ is not a single bond can be prepared by a preparation method as shown in the following Reaction Scheme 2-1 as an example, the compound wherein L'₁ is a single bond can be prepared by a preparation method as shown in the following Reaction Scheme 2-2 as an example, and the other remaining compounds can be prepared in a similar manner.

In Reaction Schemes 2-1 and 2-2, R'₁ to R'₆, X'₁, X'₂, Ar'₁, Ar'₂, and L'₁ to L'₃ are the same as defined in Chemical Formulas 2 and 2A, and Z'₁ and Z'₂ are halogen, preferably Z'₁ and Z'₂ are chloro or bromo.

Reaction Scheme 2-1 is a Suzuki coupling reaction, which is preferably carried out in the presence of a palladium catalyst and a base, and a reactive group for the Suzuki coupling reaction can be changed as known in the art. Reaction Scheme 2-2 is an amine substitution reaction, which is preferably carried out in the presence of a palladium catalyst and a base, and a reactive group for the amine substitution reaction can be changed as known in the art. The preparation method can be further embodied in Preparation Examples described hereinafter.

Preferably, Chemical Formula 3A may be linked with any one of R"₁, R"₂, R"₄, R"₅, and R"₈ to R"₁₀ of Chemical Formula 3.

Preferably, L"₁ to L"₃ may be each independently a single bond; or a substituted or unsubstituted C₆₋₂₀ arylene.

More preferably, L"₁ to L"₃ may be each independently a single bond, phenylene, biphenyldiyl, naphthalenediyl, or dimethylfluorenediyl, wherein the phenylene, biphenyldiyl, naphthalenediyl and dimethylfluorenediyl is each independently unsubstituted or substituted with at least one deuterium.

Preferably, Ar"₁ and Ar"₂ may be each independently a substituted or unsubstituted C₆₋₂₀ aryl; or a substituted or unsubstituted C₂₋₂₀ heteroaryl containing one or more selected from the group consisting of N, O and S.

More preferably, Ar"₁ and Ar"₂ may be each independently phenyl, triphenylsilyl phenyl, biphenylyl, terphenylyl, naphthyl, phenanthrenyl, dimethylfluorenyl, spirobifluorenyl, dibenzofuranyl, dibenzothiophenyl, or phenylcarbazolyl, wherein the Ar"₁ and Ar"₂ may be each independently unsubstituted or substituted with at least one deuterium.

Representative examples of the compound represented by Chemical Formula 3 are as follows:

The compound represented by Chemical Formula 3 wherein Chemical Formula 3A is linked with R"₁₀ and L"₁ is not a single bond can be prepared by a preparation method as shown in the following Reaction Scheme 3-1 as an example, the compound wherein Chemical Formula 3A is linked with R"₁₀ and L"₁ is a single bond can be prepared by a preparation method as shown in the following Reaction Scheme 3-2 as an example, and the other remaining compounds can be prepared in a similar manner.

In Reaction Schemes 3-1 and 3-2, R"₁ to R"₉, X", Ar"₁, Ar"₂, L"₁ to L"₃ are the same as defined in Chemical Formulas 3 and 3A, and Z"₁ and Z"₂ are halogen, preferably Z"₁ and Z"₂ are chloro or bromo.

Reaction Scheme 3-1 is a Suzuki coupling reaction, which is preferably carried out in the presence of a palladium catalyst and a base, and a reactive group for the Suzuki coupling reaction can be changed as known in the art. Reaction Scheme 3-2 is an amine substitution reaction, which is preferably carried out in the presence of a palladium catalyst and a base, and a reactive group for the amine substitution reaction can be changed as known in the art. The preparation method can be further embodied in Preparation Examples described hereinafter.

Preferably, the weight ratio of the compound represented by Chemical Formula 1 and the compound represented by Chemical Formula 2 in the light emitting layer may be 10:90 to 90:10, more preferably 20:80 to 80:20, 30: 70 to 70:30 or 40:60 to 60:40.

Also, preferably, the weight ratio of the compound represented by Chemical Formula 1 and the compound represented by Chemical Formula 3 in the light emitting layer may be 10:90 to 90:10, more preferably 20:80 to 80:20, 30: 70 to 70:30 or 40:60 to 60:40.

Meanwhile, the light emitting layer may further include a dopant in addition to the host. The dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having an arylamino group, examples thereof include pyrene, anthracene, chrysene, and periflanthene having the arylamino group, and the like. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

### Hole Blocking Layer

The organic light emitting device according to the present disclosure may include a hole blocking layer on the light emitting layer, if necessary.

The hole blocking layer is a layer provided between the electron transport layer and the light emitting layer in order to prevent the holes injected in the anode from being transferred to the electron transport layer without being recombined in the light emitting layer, which may also be referred to as a hole inhibition layer or a hole stopping layer. The hole blocking layer is preferably a material having the large ionization energy.

### Electron Transport Layer

The organic light emitting device according to the present disclosure may include an electron transport layer on the light emitting layer, if necessary.

The electron transport layer is a layer that receives the electrons from the cathode or the electron injection layer formed on the cathode and transports the electrons to the light emitting layer, and that suppress the transfer of holes from the light emitting layer, and an electron transport material is suitably a material which may receive well injection of electrons from a cathode and transfer the electrons to a light emitting layer, and has a large mobility for electrons.

Specific examples of the electron transport material include: an Al complex of 8-hydroxyquinoline; a complex including Alq₃; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present disclosure may further include an electron injection layer on the light emitting layer (or on the electron transport layer, if the electron transport layer exists), if necessary.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

On the other hand, in the present disclosure, the "electron injection and transport layer" is a layer that performs both the roles of the electron injection layer and the electron transport layer, and the materials that perform the roles of each layer may be used alone or stacked and used in combination, without being limited thereto.

### Organic Light Emitting Device

The structure of the organic light emitting device according to the present disclosure is illustrated in FIGS. 1 and 2. FIG. 1 shows an example of an organic light emitting device comprising a substrate 1, an anode 2, a light emitting layer 3, and a cathode 4. FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron injection and transport layer 9, and a cathode 4.

The organic light emitting device according to the present disclosure can be manufactured by sequentially stacking the above-described structures. In this case, the organic light emitting device may be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon. In addition to such a method, the organic light emitting device may be manufactured by sequentially depositing from the cathode material to the anode material on a substrate in the reverse order of the above-mentioned configuration (WO 2003/012890). Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

Meanwhile, the organic light emitting device according to the present disclosure may be a bottom emission device, a top emission device, or a double-sided light emitting device, and particularly, may be a bottom emission device that requires relatively high luminous efficiency.

Below, preferable embodiments are presented to assist in the understanding of the present disclosure. The following examples are only provided for a better understanding of the present disclosure, and is not intended to limit the content of the present disclosure.

### Synthesis Example 1-1

(2-Chlorodibenzo[b,d]furan-1-yl)boronic acid (15 g, 60.9 mmol) and Compound Trz1 (26.7 g, 63.9 mmol) were added to 300 ml of **THF,** and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.5 g of Compound 1-1_P1. (Yield: 69 %, MS: [M+H]⁺= 584)

Compound 1-1_P1 (15 g, 25.7 mmol) and naphthalen-2-ylboronic acid (4.6 g, 27 mmol) were added to 300 ml of THF, and the mixture was stirred and refluxed. Then, potassium carbonate (10.6 g, 77 mmol) was dissolved in 32 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12.1 g of Compound 1-1. (Yield: 70 %, MS: [M+H]⁺= 676)

### Synthesis Example 1-2

(2-Chlorodibenzo[b,d]furan-1-yl)boronic acid (15 g, 60.9 mmol) and Compound Trz2 (30.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.5 g of Compound 1-2_P1. (Yield:67 %, MS: [M+H]⁺= 650)

Compound 1-2_P1 (15 g, 23.1 mmol) and dibenzo[b,d]furan-2-ylboronic acid (5.1 g, 24.2 mmol) were added to 300 ml of THF, and the mixture was stirred and refluxed. Then, potassium carbonate (9.6 g, 69.2 mmol) was dissolved in 29 ml of water and added thereto, and the mixture was sufficiently stirred and then bis(tri-tert-butylphosphine)palladium(0) (0.1 g, 0.2 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 13.2 g of Compound 1-2. (Yield:73 %, MS: [M+H]⁺= 782)

### Synthesis Example 1-3

(2-Chlorodibenzo[b,d]furan-1-yl)boronic acid (15 g, 60.9 mmol) and Compound Trz3 (26.7 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.3 g of Compound 1-3_P1. (Yield: 66 %, MS: [M+H]⁺= 580)

Compound 1-3_P1 (15 g, 25.4 mmol) and [1,1'-biphenyl]-4-ylboronic acid (5.3 g, 26.7 mmol) were added to 300 ml of THF, and the mixture was stirred and refluxed. Then, potassium carbonate (10.5 g, 76.3 mmol) was dissolved in 32 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 13.5 g of Compound 1-3. (Yield: 75 %, MS: [M+H]⁺= 708)

### Synthesis Example 1-4

(3-Chlorodibenzo[b,d]furan-1-yl)boronic acid (15 g, 60.9 mmol) and Compound Trz4(28.4 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.4 g of Compound 1-4_P1. (Yield: 74 %, MS: [M+H]⁺= 610)

Compound 1-4_P1 (15 g, 24.6 mmol) and naphthalen-2-ylboronic acid (4.4 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.2 g of Compound 1-4. (Yield: 65 %, MS: [M+H]⁺= 702)

### Synthesis Example 1-5

(3-Chlorodibenzo[b,d]furan-1-yl)boronic acid (15 g, 60.9 mmol) and Compound Trz5 (17.1 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.7 g of Compound 1-5_P1. (Yield: 71 %, MS: [M+H]⁺= 434)

Compound 1-5_P1 (15 g, 34.6 mmol) and fluoranthen-3-ylboronic acid (8.9 g, 36.3 mmol) were added to 300 ml of THF, and the mixture was stirred and refluxed. Then, potassium carbonate (14.3 g, 103.7 mmol) was dissolved in 43 ml of water and added thereto, and the mixture was sufficiently stirred and then bis(tri-tert-butylphosphine)palladium(0) (0.2 g, 0.3 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 14.9 g of Compound 1-5. (Yield: 72 %, MS: [M+H]⁺= 600)

### Synthesis Example 1-6

Compound 1-5_P1 (15 g, 34.6 mmol) and naphtho[2,3-b]benzofuran-1-ylboronic acid (9.5 g, 36.3 mmol) were added to 300 ml of THF, and the mixture was stirred and refluxed. Then, potassium carbonate (14.3 g, 103.7 mmol) was dissolved in 43 ml of water and added thereto, and the mixture was sufficiently stirred and then bis(tri-tert-butylphosphine)palladium(0) (0.2 g, 0.3 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 13.8 g of Compound 1-6. (Yield: 65 %, MS: [M+H]⁺= 616)

### Synthesis Example 1-7

(3-Chlorodibenzo[b,d]furan-1-yl)boronic acid (15 g, 60.9 mmol) and Compound Trz6 (32.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.4 g of Compound 1-7_P1. (Yield: 71 %, MS: [M+H]⁺= 636)

Compound 1-7_P1 (15 g, 23.6 mmol) and naphthalen-2-ylboronic acid (4.3 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.5 g of Compound 1-7. (Yield: 67 %, MS: [M+H]⁺= 728)

### Synthesis Example 1-8

Trifluoromethanesulfonic anhydride (30.1 g, 106.6 mmol) and deuterium oxide (10.7 g, 532.8 mmol) were added at 0°C, and the mixture was stirred for 5 hours to prepare a solution. 1-Bromo-4-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-4-chlorodibenzo[b,d]furan and 1,2,4-trichlorobenzene, and the mixture was stirred while heating up to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound Sub1-1-1. (Yield: 43 %, MS: [M+H]⁺= 283)

Compound Sub1-1-1 (15 g, 52.9 mmol) and bis(pinacolato)diboron (14.8 g, 58.2 mmol) was added to 300 ml of 1,4-dioxane, and the mixture was stirred under reflux. Then, potassium acetate (7.8 g, 79.4 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 10.8 g of Compound Sub1-1-2. (Yield: 62%, MS: [M+H]⁺= 331)

Compound Sub1-1-2(15 g, 45.4 mmol) and Compound Trz7(28.1 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.3 g of Compound 1-8_P1. (Yield: 72 %, MS: [M+H]⁺= 714)

Compound 1-8_P1 (15 g, 21 mmol) and phenylboronic acid (2.7 g, 22.1 mmol) were added to 300 ml of THF, and the mixture was stirred and refluxed. Then, potassium carbonate (8.7 g, 63 mmol) was dissolved in 26 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 10 g of Compound 1-8. (Yield: 63 %, MS: [M+H]⁺= 756)

### Synthesis Example 1-9

Compound Sub1-1-2 (15 g, 45.4 mmol) and Compound Trz8 (29.6 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.3 g of Compound 1-9_P1. (Yield: 75 %, MS: [M+H]⁺= 744)

Compound 1-9_P1 (15 g, 20.2 mmol) and phenylboronic acid (2.6 g, 21.2 mmol) were added to 300 ml of THF, and the mixture was stirred and refluxed. Then, potassium carbonate (8.4 g, 60.5 mmol) was dissolved in 25 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.1 g of Compound 1-9. (Yield: 70 %, MS: [M+H]⁺= 786)

### Synthesis Example 1-10

Trifluoromethanesulfonic anhydride (60.1 g, 213.1 mmol) and deuterium oxide (21.4 g, 1065.6 mmol) were added at 0°C, and the mixture was stirred for 5 hours to prepare a solution. 1-Bromo-4-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-4-chlorodibenzo[b,d]furan and 1,2,4-trichlorobenzene, and the mixture was stirred while heating up to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.3 g of Compound Sub1-2-1. (Yield: 35 %, MS: [M+H]⁺= 285)

Compound Sub1-2-1 (15 g, 52.5 mmol) and bis(pinacolato)diboron (14.7 g, 57.8 mmol) was added to 300 ml of 1,4-dioxane, and the mixture was stirred under reflux. Then, potassium acetate (7.7 g, 78.8 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 11 g of Compound Sub1-2-2. (Yield: 63 %, MS: [M+H]⁺= 333)

Compound Sub1-2-2(15 g, 45.1 mmol) and Compound Trz9(15.8 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 14.6 g of Compound 1-10_P1. (Yield: 66 %, MS: [M+H]⁺= 493)

Compound 1-10_P1 (15 g, 30.4 mmol) and dibenzo[b,d]furan-1-ylboronic acid (6.8 g, 31.9 mmol) were added to 300 ml of THF, and the mixture was stirred and refluxed. Then, potassium carbonate (12.6 g, 91.3 mmol) was dissolved in 38 ml of water and added thereto, and the mixture was sufficiently stirred and then bis(tri-tert-butylphosphine)palladium(0) (0.2 g, 0.3 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 13.3 g of Compound 1-10. (Yield: 70 %, MS: [M+H]⁺= 625)

### Synthesis Example 1-11

(3-Chlorodibenzo[b,d]furan-1-yl)boronic acid (15 g, 60.9 mmol) and Compound Trz10(25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.1 g of Compound 1-11_P1. (Yield: 62 %, MS: [M+H]⁺= 560)

Compound 1-11_P1 (15 g, 26.8 mmol) and phenylboronic acid (3.4 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.8 g of Compound 1-11_P2. (Yield: 73 %, MS: [M+H]⁺= 602)

Compound 1-11_P2(10 g, 16.6 mmol), PtO₂(1.1 g, 5 mmol) and D₂O (83 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.1 g of Compound 1-11. (Yield: 30 %, MS: [M+H]⁺= 626)

### Synthesis Example 1-12

(3-Chlorodibenzo[b,d]furan-1-yl)boronic acid (15 g, 60.9 mmol) and Compound Trz11 (23.5 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.4 g of Compound 1-12_P1. (Yield: 72 %, MS: [M+H]⁺= 534)

Compound 1-12_P1 (15 g, 28.1 mmol) and dibenzo[b,d]thiophen-4-ylboronic acid (6.7 g, 29.5 mmol) were added to 300 ml of THF, and the mixture was stirred and refluxed. Then, potassium carbonate (11.6 g, 84.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12.4 g of Compound 1-12_P2. (Yield: 65 %, MS: [M+H]⁺= 682)

Compound 1-12_P2(10 g, 14.7 mmol), PtO₂(1 g, 4.4 mmol) and D₂O (73 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 5.1 g of Compound 1-12. (Yield: 49 %, MS: [M+H]⁺= 706)

### Synthesis Example 1-13

(4-Chlorodibenzo[b,d]furan-1-yl)boronic acid (15 g, 60.9 mmol) and Compound Trz12(30 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.4g of Compound 1-13_P1. (Yield: 63 %, MS: [M+H]⁺= 636)

Compound 1-13_P1 (15 g, 23.6 mmol) and naphthalen-2-ylboronic acid (4.3 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 10.5 g of Compound 1-13. (Yield: 61 %, MS: [M+H]⁺= 728)

### Synthesis Example 1-14

(4-Chlorodibenzo[b,d]furan-1-yl)boronic acid (15 g, 60.9 mmol) and Compound Trz13 (22 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.3 g of Compound 1-14_P1. (Yield: 72 %, MS: [M+H]⁺= 510)

Compound 1-14_P1 (15 g, 29.4 mmol) and naphtho[2,3-b]benzofuran-4-ylboronic acid (8.1 g, 30.9 mmol) were added to 300 ml of THF, and the mixture was stirred and refluxed. Then, potassium carbonate (12.2 g, 88.2 mmol) was dissolved in 37 ml of water and added thereto, and the mixture was sufficiently stirred and then bis(tri-tert-butylphosphine)palladium(0) (0.2 g, 0.3 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 14.2 g of Compound 1-14. (Yield: 70 %, MS: [M+H]⁺= 692)

### Synthesis Example 1-15

(4-Chlorodibenzo[b,d]furan-1-yl)boronic acid (15 g, 60.9 mmol) and Compound Trz14(26.1 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.8 g of Compound 1-15_P1. (Yield: 71 %, MS: [M+H]⁺= 574)

Compound 1-15_P1 (15 g, 26.1 mmol) and dibenzo[b,d]furan-1-ylboronic acid (5.8 g, 27.4 mmol) were added to 300 ml of THF, and the mixture was stirred and refluxed. Then, potassium carbonate (10.8 g, 78.4 mmol) was dissolved in 33 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.1 g of Compound 1-15. ( Yield: 60 %, MS: [M+H]⁺= 706)

### Synthesis Example 1-16

Trifluoromethanesulfonic anhydride (45.1 g, 159.8 mmol) and deuterium oxide (16 g, 799.2 mmol) were added at 0°C, and the mixture was stirred for 5 hours to prepare a solution. 1-Bromo-4-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-4-chlorodibenzo[b,d]furan and 1,2,4-trichlorobenzene, and the mixture was stirred while heating up to 140°C and then keeping that temperature. After the reaction for 7 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.6 g of Compound Sub1-3-1. (Yield: 37%, MS: [M+H]⁺= 284)

Compound Sub1-3-1 (15 g, 52.7 mmol) and bis(pinacolato)diboron (14.7 g, 58 mmol) was added to 300 ml of 1,4-dioxane, and the mixture was stirred under reflux. Then, potassium acetate (7.8 g, 79.1 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 10.1 g of Compound Sub1-3-2. (Yield: 58 %, MS: [M+H]⁺= 332)

Compound Sub1-3-2 (15 g, 45.2 mmol) and Compound Trz15 (17.7 g, 47.5 mmol) were added to 300 ml of THF, and the mixture was stirred and refluxed. Then, potassium carbonate (18.8 g, 135.7 mmol) was dissolved in 56 ml of water and added thereto, and the mixture was sufficiently stirred and then bis(tri-tert-butylphosphine)palladium(0) (0.2 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 15.4 g of Compound 1-16_P1. (Yield: 63 %, MS: [M+H]⁺= 542)

Compound 1-16_P1 (15 g, 27.7 mmol) and (phenyl-d5)boronic acid (3.7 g, 29.1 mmol) were added to 300 ml of THF, and the mixture was stirred and refluxed. Then, potassium carbonate (11.5 g, 83 mmol) was dissolved in 34 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.9 g of Compound 1-16. (Yield: 73 %, MS: [M+H]⁺= 589)

### Synthesis Example 1-17

(6-Chlorodibenzo[b,d]furan-1-yl)boronic acid (15 g, 60.9 mmol) and Compound Trz16 (23.5 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.4 g of Compound 1-17_P1. (Yield: 72 %, MS: [M+H]⁺= 534)

Compound 1-17_P1 (15 g, 28.1 mmol) and naphthalen-2-ylboronic acid (5.1 g, 29.5 mmol) were added to 300 ml of THF, and the mixture was stirred and refluxed. Then, potassium carbonate (11.6 g, 84.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12.5 g of Compound 1-17. (Yield: 71 %, MS: [M+H]⁺= 626)

### Synthesis Example 1-18

(6-Chlorodibenzo[b,d]furan-1-yl)boronic acid (15 g, 60.9 mmol) and Compound Trz17 (29.7 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.6 g of Compound 1-18_P1. (Yield: 69 %, MS: [M+H]⁺= 586)

Compound 1-18_P1 (15 g, 25.6 mmol) and naphthalen-2-ylboronic acid (4.6 g, 26.9 mmol) were added to 300 ml of THF, and the mixture was stirred and refluxed. Then, potassium carbonate (10.6 g, 76.8 mmol) was dissolved in 32 ml of water and added thereto, and the mixture was sufficiently stirred and then bis(tri-tert-butylphosphine)palladium(0) (0.1 g, 0.3 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 10.9 g of Compound 1-18. (Yield: 63 %, MS: [M+H]⁺= 678)

### Synthesis Example 1-19

(6-Chlorodibenzo[b,d]furan-1-yl)boronic acid (15 g, 60.9 mmol) and Compound Trz18 (31.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.5 g of Compound 1-19_P1. (Yield: 66 %, MS: [M+H]⁺= 610)

Compound 1-19_P1 (15 g, 24.6 mmol) and naphthalen-2-ylboronic acid (4.4 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.4 g of Compound 1-19. (Yield: 66 %, MS: [M+H]⁺= 702)

### Synthesis Example 1-20

(6-Chlorodibenzo[b,d]furan-1-yl)boronic acid (15 g, 60.9 mmol) and Compound Trz19 (20.3 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.1 g of Compound 1-20_P1. (Yield: 65 %, MS: [M+H]⁺= 484)

Compound 1-20_P1 (15 g, 31 mmol) and phenanthren-9-ylboronic acid (7.2 g, 32.5 mmol) were added to 300 ml of THF, and the mixture was stirred and refluxed. Then, potassium carbonate (12.9 g, 93 mmol) was dissolved in 39 ml of water and added thereto, and the mixture was sufficiently stirred and then bis(tri-tert-butylphosphine)palladium(0) (0.2 g, 0.3 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12 g of Compound 1-20. (Yield: 62 %, MS: [M+H]⁺= 626)

### Synthesis Example 1-21

Trifluoromethanesulfonic anhydride (30.1 g, 106.6 mmol) and deuterium oxide (10.7 g, 532.8 mmol) were added at 0°C, and the mixture was stirred for 5 hours to prepare a solution. 1-bromo-6-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-6-chlorodibenzo[b,d]furan and 1,2,4-trichlorobenzene, and the mixture was stirred while heating up to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.8 g of Compound Sub2-1-1. (Yield: 45 %, MS: [M+H]⁺= 283)

Compound Sub2-1-1 (15 g, 52.9 mmol) and bis(pinacolato)diboron (14.8 g, 58.2 mmol) was added to 300 ml of 1,4-dioxane, and the mixture was stirred under reflux. Then, potassium acetate (7.8 g, 79.4 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 13.1 g of Compound Sub2-1-2. (Yield: 75 %, MS: [M+H]⁺= 331)

Compound Sub2-1-2 (15 g, 45.4 mmol) and Compound Trz20 (22.6 g, 47.6 mmol) were added to 300 ml of **THF,** and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 17.8 g of Compound 1-21_P1. (Yield: 61 %, MS: [M+H]⁺= 643)

Compound 1-21_P1 (15 g, 23.3 mmol) and (phenyl-d5)boronic acid (3.1 g, 24.5 mmol) were added to 300 ml of THF, and the mixture was stirred and refluxed. Then, potassium carbonate (9.7 g, 70 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.9 g of Compound 1-21. (Yield: 74 %, MS: [M+H]⁺= 690)

### Synthesis Example 1-22

Compound Sub2-1-2 (15 g, 45.4 mmol) and Compound Trz21 (21.1 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.6 g of Compound 1-22_P1. (Yield: 67 %, MS: [M+H]⁺= 612)

Compound 1-22_P1 (15 g, 24.5 mmol) and (phenyl-d5)boronic acid (3.3 g, 25.7 mmol) were added to 300 ml of THF, and the mixture was stirred and refluxed. Then, potassium carbonate (10.2 g, 73.5 mmol) was dissolved in 30 ml of water and added thereto, and the mixture was sufficiently stirred and then bis(tri-tert-butylphosphine)palladium(0) (0.1 g, 0.2 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 10 g of Compound 1-22. (Yield: 62 %, MS: [M+H]⁺= 659)

### Synthesis Example 1-23

Trifluoromethanesulfonic anhydride (60.1 g, 213.1 mmol) and deuterium oxide (21.4 g, 1065.6 mmol) were added at 0°C, and the mixture was stirred for 5 hours to prepare a solution. 1-bromo-6-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-6-chlorodibenzo[b,d]furan and 1,2,4-trichlorobenzene, and the mixture was stirred while heating up to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound Sub2-2-1. (Yield: 43 %, MS: [M+H]⁺= 285)

Compound Sub2-2-1(15 g, 52.5 mmol) and bis(pinacolato)diboron (14.7 g, 57.8 mmol) was added to 300 ml of 1,4-dioxane, and the mixture was stirred under reflux. Then, potassium acetate (7.7 g, 78.8 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 5 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 13.1 g of Compound Sub2-2-2. (Yield: 75 %, MS: [M+H]⁺= 333)

Compound Sub2-2-2 (15 g, 60.9 mmol) and Compound Trz22 (36.1 g, 63.9 mmol) were added to 300 ml of **THF,** and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 28.9 g of Compound 1-23_P1. (Yield: 69 %, MS: [M+H]⁺= 690)

Compound 1-23_P1 (15 g, 21.7 mmol) and phenylboronic acid (2.8 g, 22.8 mmol) were added to 300 ml of THF, and the mixture was stirred and refluxed. Then, potassium carbonate (9 g, 65.2 mmol) was dissolved in 27 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 9.5 g of Compound 1-23. (Yield: 60 %, MS: [M+H]⁺= 732)

### Synthesis Example 1-24

Compound 1-18 (10 g, 14.8 mmol), PtO₂ (1 g, 4.4 mmol) and D₂O (74 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 5.1 g of Compound 1-24. (Yield: 49 %, MS: [M+H]⁺= 706)

### Synthesis Example 1-25

(6-Chlorodibenzo[b,d]furan-1-yl)boronic acid (15 g, 60.9 mmol) and Compound Trz23 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.7 g of Compound 1-25_P1. (Yield: 63 %, MS: [M+H]⁺= 540)

Compound 1-25_P1 (15 g, 27.8 mmol) and dibenzo[b,d]furan-1-ylboronic acid (6.2 g, 29.2 mmol) were added to 300 ml of THF, and the mixture was stirred and refluxed. Then, potassium carbonate (11.5 g, 83.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.4 g of Compound 1-25_P2. (Yield: 61 %, MS: [M+H]⁺= 672)

Compound 1-25_P2 (10 g, 14.9 mmol), PtO₂ (1 g, 4.5 mmol) and D₂O (74 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.7 g of Compound 1-25. (Yield: 36 %, MS: [M+H]⁺= 695)

### Synthesis Example 1-26

(7-Chlorodibenzo[b,d]furan-1-yl)boronic acid (15 g, 60.9 mmol) and Compound Trz19 (20.3 g, 63.9 mmol) were added to 300 ml of **THF,** and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 17.6 g of Compound 1-26_P1. (Yield: 60 %, MS: [M+H]⁺= 484)

Compound 1-26_P1 (15 g, 31 mmol and naphthalen-2-ylboronic acid (5.6 g, 32.5 mmol) were added to 300 ml of THF, and the mixture was stirred and refluxed. Then, potassium carbonate (12.9 g, 93 mmol) was dissolved in 39 ml of water and added thereto, and the mixture was sufficiently stirred and then bis(tri-tert-butylphosphine)palladium(0) (0.2 g, 0.3 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 13 g of Compound 1-26. (Yield: 73 %, MS: [M+H]⁺= 576)

### Synthesis Example 1-27

(7-Chlorodibenzo[b,d]furan-1-yl)boronic acid (15 g, 60.9 mmol) and Compound Trz24 (22.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.4 g of Compound 1-27_P1. (Yield: 64 %, MS: [M+H]⁺= 524)

Compound 1-27_P1 (15 g, 28.6 mmol) and naphthalen-2-ylboronic acid (5.2 g, 30.1 mmol) were added to 300 ml of THF, and the mixture was stirred and refluxed. Then, potassium carbonate (11.9 g, 85.9 mmol) was dissolved in 36 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 10.9 g of Compound 1-27. (Yield: 62 %, MS: [M+H]⁺= 616)

### Synthesis Example 1-28

(7-Chlorodibenzo[b,d]furan-1-yl)boronic acid (15 g, 60.9 mmol) and Compound Trz25 (22.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.6 g of Compound 1-28_P1. (Yield: 71 %, MS: [M+H]⁺= 524)

Compound 1-28_P1 (15 g, 28.6 mmol) and phenanthren-3-ylboronic acid (6.7 g, 30.1 mmol) were added to 300 ml of THF, and the mixture was stirred and refluxed. Then, potassium carbonate (11.9 g, 85.9 mmol) was dissolved in 36 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12.9 g of Compound 1-28. (Yield: 68 %, MS: [M+H]⁺= 666)

### Synthesis Example 1-29

(7-Chlorodibenzo[b,d]furan-1-yl)boronic acid (15 g, 60.9 mmol) and Compound Trz26 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.1 g of Compound 1-29_P1. (Yield: 62 %, MS: [M+H]⁺= 560)

Compound 1-29_P1 (15 g, 26.8 mmol) and dibenzo[b,d]thiophen-4-ylboronic acid (6.4 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12.3 g of Compound 1-29. (Yield: 65 %, MS: [M+H]⁺= 708)

### Synthesis Example 1-30

(7-Chlorodibenzo[b,d]furan-1-yl)boronic acid (15 g, 60.9 mmol) and Compound Trz27 (38.6 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 29.1 g of Compound 1-30_P1. (Yield: 66 %, MS: [M+H]⁺= 726)

Compound 1-30_P1 (15 g, 20.7 mmol) and naphthalen-2-ylboronic acid (3.7 g, 21.7 mmol) were added to 300 ml of THF, and the mixture was stirred and refluxed. Then, potassium carbonate (8.6 g, 62 mmol) was dissolved in 26 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 10.6 g of Compound 1-30. (Yield: 63 %, MS: [M+H]⁺= 818)

### Synthesis Example 1-31

Trifluoromethanesulfonic anhydride (30.1 g, 106.6 mmol) and deuterium oxide (10.7 g, 532.8 mmol) were added at 0°C, and the mixture was stirred for 5 hours to prepare a solution. 1-Bromo-7-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-7-chlorodibenzo[b,d]furan and 1,2,4-trichlorobenzene, and the mixture was stirred while heating up to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6 g of Compound Sub3-1-1. (Yield: 40 %, MS: [M+H]⁺= 283)

Compound Sub3-1-1 (15 g, 52.9 mmol) and bis(pinacolato)diboron (14.8 g, 58.2 mmol) was added to 300 ml of 1,4-dioxane, and the mixture was stirred under reflux. Then, potassium acetate (7.8 g, 79.4 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 4 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 11.4 g of Compound Sub3-1-2. (Yield: 65 %, MS: [M+H]⁺= 331)

Compound Sub3-1-2 (15 g, 45.4 mmol) and Compound Trz28 (28.6 g, 47.6 mmol) were added to 300 ml of **THF,** and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.3 g of Compound 1-31_P1. (Yield: 62 %, MS: [M+H]⁺= 723)

Compound 1-31_P1 (15 g, 20.7 mmol) and phenanthren-3-ylboronic acid (4.8 g, 21.8 mmol) were added to 300 ml of THF, and the mixture was stirred and refluxed. Then, potassium carbonate (8.6 g, 62.2 mmol) was dissolved in 26 ml of water and added thereto, and the mixture was sufficiently stirred and then bis(tri-tert-butylphosphine)palladium(0) (0.1 g, 0.2 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.5 g of Compound 1-31. (Yield: 64 %, MS: [M+H]⁺= 866)

### Synthesis Example 1-32

Trifluoromethanesulfonic anhydride (60.1 g, 213.1 mmol) and deuterium oxide (21.4 g, 1065.6 mmol) were added at 0°C, and the mixture was stirred for 5 hours to prepare a solution. 1-bromo-7-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-7-chlorodibenzo[b,d]furan and 1,2,4-trichlorobenzene, and the mixture was stirred while heating up to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.7 g of Compound Sub3-2-1. (Yield: 44 %, MS: [M+H]⁺= 285)

Compound Sub3-2-1 (15 g, 52.5 mmol) and bis(pinacolato)diboron (14.7 g, 57.8 mmol) was added to 300 ml of 1,4-dioxane, and the mixture was stirred under reflux. Then, potassium acetate (7.7 g, 78.8 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 11.7 g of Compound Sub3-2-2. (Yield: 67 %, MS: [M+H]⁺= 333)

Compound Sub3-2-2 (15 g, 45.1 mmol) and Compound Trz29 (18.7 g, 47.4 mmol) were added to 300 ml of **THF,** and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18 g of Compound 1-32_P1. (Yield: 71 %, MS: [M+H]⁺= 564)

Compound 1-32_P1 (15 g, 26.6 mmol) and (phenyl-d5)boronic acid (3.5 g, 27.9 mmol) were added to 300 ml of **THF,** and the mixture was stirred and refluxed. Then, potassium carbonate (11 g, 79.8 mmol) was dissolved in 33 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.4 g of Compound 1-32. (Yield: 70 %, MS: [M+H]⁺= 611)

### Synthesis Example 1-33

Compound Sub3-2-2 (15 g, 45.1 mmol) and Compound Trz30 (24.8 g, 47.4 mmol) were added to 300 ml of **THF,** and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.4 g of Compound 1-33_P1. (Yield: 63 %, MS: [M+H]⁺= 650)

Compound 1-33_P1 (15 g, 23.1 mmol) and phenylboronic acid (3 g, 24.2 mmol) were added to 300 ml of **THF,** and the mixture was stirred and refluxed. Then, potassium carbonate (9.6 g, 69.2 mmol) was dissolved in 29 ml of water and added thereto, and the mixture was sufficiently stirred and then bis(tri-tert-butylphosphine)palladium(0) (0.1 g, 0.2 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.5 g of Compound 1-33. (Yield: 72 %, MS: [M+H]⁺= 692)

### Synthesis Example 1-34

Compound 1-26 (10 g, 17.4 mmol), PtO₂ (1.2 g, 5.2 mmol) and D₂O (87 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.9 g of Compound 1-34. (Yield: 38 %, MS: [M+H]⁺= 598)

### Synthesis Example 1-35

(7-Chlorodibenzo[b,d]furan-1-yl)boronic acid (15 g, 60.9 mmol) and Compound Trz29 (25.2 g, 63.9 mmol) were added to 300 ml of **THF,** and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.8 g of Compound 1-35_P1. (Yield: 70 %, MS: [M+H]⁺= 560)

Compound 1-35_P1 (15 g, 26.8 mmol) and phenylboronic acid (3.4 g, 28.1 mmol) were added to 300 ml of **THF,** and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.3 g of Compound 1-35_P2. (Yield:70 %, MS: [M+H]⁺= 602)

Compound 1-35_P2 (10 g, 16.6 mmol), PtO₂ (1.1 g, 5 mmol) and D₂O (83 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.7 g of Compound 1-35. (Yield: 36 %, MS: [M+H]⁺= 626)

### Synthesis Example 1-36

Compound 1-27 (10 g, 16.2 mmol), PtO₂ (1.1 g, 4.9 mmol) and D₂O (81 ml) were added to a shaker tube, and then the tuber was sealed and heated at 250°C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.9 g of Compound 1-36. (Yield: 38 %, MS: [M+H]⁺= 639)

### Synthesis Example 1-37

(8-Chlorodibenzo[b,d]furan-1-yl)boronic acid (15 g, 60.9 mmol) and Compound Trz31 (26.8 g, 63.9 mmol) were added to 300 ml of **THF,** and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.7 g of Compound 1-37_P1. (Yield: 75 %, MS: [M+H]⁺= 586)

Compound 1-37_P1 (15 g, 25.6 mmol) and naphthalen-2-ylboronic acid (4.6 g, 26.9 mmol) were added to 300 ml of THF, and the mixture was stirred and refluxed. Then, potassium carbonate (10.6 g, 76.8 mmol) was dissolved in 32 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12.7 g of Compound 1-37. (Yield: 73 %, MS: [M+H]⁺= 678)

### Synthesis Example 1-38

(8-Chlorodibenzo[b,d]furan-1-yl)boronic acid (15 g, 60.9 mmol) and Compound Trz5 (17.1 g, 63.9 mmol) were added to 300 ml of **THF,** and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 16.3 g of Compound 1-38_P1. (Yield: 62 %, MS: [M+H]⁺= 434)

Compound 1-38_P1 (15 g, 34.6 mmol) and triphenylen-2-ylboronic acid (9.9 g, 36.3 mmol) were added to 300 ml of THF, and the mixture was stirred and refluxed. Then, potassium carbonate (14.3 g, 103.7 mmol) was dissolved in 43 ml of water and added thereto, and the mixture was sufficiently stirred and then bis(tri-tert-butylphosphine)palladium(0) (0.2 g, 0.3 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 14.7 g of Compound 1-38. (Yield: 68 %, MS: [M+H]⁺= 626)

### Synthesis Example 1-39

(8-Chlorodibenzo[b,d]furan-1-yl)boronic acid (15 g, 60.9 mmol) and Compound Trz32 (32.9 g, 63.9 mmol) were added to 300 ml of **THF,** and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.8 g of Compound 1-39_P1. (Yield: 72 %, MS: [M+H]⁺= 636)

Compound 1-39_P1 (15 g, 23.6 mmol) and dibenzo[b,d]furan-4-ylboronic acid (5.2 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.6 g of Compound 1-39. (Yield: 64 %, MS:

### [M+H]⁺= 769)

### Synthesis Example 1-40

Trifluoromethanesulfonic anhydride (60.1 g, 213.1 mmol) and deuterium oxide (21.4 g, 1065.6 mmol) were added at 0°C, and the mixture was stirred for 5 hours to prepare a solution. 1-bromo-8-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-8-chlorodibenzo[b,d]furan and 1,2,4-trichlorobenzene, and the mixture was stirred while heating up to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.4 g of Compound Sub4-1-1. (Yield: 42 %, MS: [M+H]⁺= 285)

Compound Sub4-1-1 (15 g, 52.5 mmol) and bis(pinacolato)diboron (14.7 g, 57.8 mmol) was added to 300 ml of 1,4-dioxane, and the mixture was stirred under reflux. Then, potassium acetate (7.7 g, 78.8 mmol) was added thereto, and the mixture was sufficiently stirred, and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 12 g of Compound Sub4-1-2. (Yield: 69 %, MS:

### [M+H]⁺= 333)

Compound Sub4-1-2 (15 g, 45.1 mmol) and Compound Trz33 (17.8 g, 47.4 mmol) were added to 300 ml of **THF,** and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 16 g of Compound 1-40_P1. (Yield:65 %, MS: [M+H]⁺= 546)

Compound 1-40_P1 (15 g, 27.5 mmol) and dibenzo[b,d]furan-4-ylboronic acid (6.1 g, 28.8 mmol) were added to 300 ml of THF, and the mixture was stirred and refluxed. Then, potassium carbonate (11.4 g, 82.4 mmol) was dissolved in 34 ml of water and added thereto, and the mixture was sufficiently stirred and then bis(tri-tert-butylphosphine)palladium(0) (0.1 g, 0.3 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.5 g of Compound 1-40. (Yield: 62 %, MS: [M+H]⁺= 678)

### Synthesis Example 1-41

Compound Sub4-1-2 (15 g, 45.1 mmol) and Compound Trz34 (20.3 g, 47.4 mmol) were added to 300 ml of **THF,** and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.4 g of Compound 1-41_P1. (Yield: 72 %, MS: [M+H]⁺= 599)

Compound 1-41_P1 (15 g, 25 mmol) and phenylboronic acid (3.2 g, 26.3 mmol) were added to 300 ml of THF, and the mixture was stirred and refluxed. Then, potassium carbonate (10.4 g, 75.1 mmol) was dissolved in 31 ml of water and added thereto, and the mixture was sufficiently stirred and then bis(tri-tert-butylphosphine)palladium(0) (0.1 g, 0.3 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 9.8g of Compound 1-41. (Yield: 61 %, MS: [M+H]⁺= 641)

### Synthesis Example 1-42

Compound Sub4-1-2 (15 g, 45.1 mmol) and Compound Trz35 (21.3 g, 47.4 mmol) were added to 300 ml of **THF,** and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 17 g of Compound 1-42_P1. (Yield: 61 %, MS: [M+H]⁺= 619)

Compound 1-42_P1 (15 g, 24.2 mmol) and (phenyl-d5)boronic acid (3.2 g, 25.4 mmol) were added to 300 ml of THF, and the mixture was stirred and refluxed. Then, potassium carbonate (10 g, 72.7 mmol) was dissolved in 30 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 11.1 g of Compound 1-42. (Yield: 69 %, MS: [M+H]⁺= 666)

### Synthesis Example 1-43

Compound 1-38 (10 g, 16 mmol), PtO₂ (1.1 g, 4.8 mmol) and D₂O (80 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.5 g of Compound 1-43. (Yield: 34 %, MS: [M+H]⁺= 649)

### Synthesis Example 1-44

Trifluoromethanesulfonic anhydride (24 g, 85 mmol) and deuterium oxide (8.5 g, 424.9 mmol) were added at 0°C, and the mixture was stirred for 5 hours to prepare a solution. 1-bromodibenzo[b,d]furan (15 g, 60.7 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromodibenzo[b,d]furan and 1,2,4-trichlorobenzene, and the mixture was stirred while heating up to 140°C and then keeping that temperature. After the reaction for 5 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.7 g of Compound Sub5-1-1. (Yield:38 %, MS: [M+H]⁺= 248)

Compound Sub5-1-1 (15 g, 60.5 mmol) and bis(pinacolato)diboron (16.9 g, 66.5 mmol) was added to 300 ml of 1,4-dioxane, and the mixture was stirred under reflux. Then, potassium acetate (8.9 g, 90.7 mmol) was added thereto, and the mixture was sufficiently stirred, and then bis(dibenzylideneacetone)palladium(0) (1 g, 1.8 mmol) and tricyclohexylphosphine(1 g, 3.6 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 13.4 g of Compound Sub5-1-2. (Yield: 75 %, MS: [M+H]⁺= 296)

Compound Sub5-1-2 (15 g, 50.8 mmol) and Compound Trz36 (25.8 g, 53.4 mmol) were added to 300 ml of THF, and the mixture was stirred and refluxed. Then, potassium carbonate (21.1 g, 152.5 mmol) was dissolved in 63 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.9 g of Compound 1-44. (Yield: 72 %, MS: [M+H]⁺= 518)

### Synthesis Example 1-45

Trifluoromethanesulfonic anhydride (48 g, 170 mmol) and deuterium oxide (17 g, 849.9 mmol) were added at 0°C, and the mixture was stirred for 5 hours to prepare a solution. 1-bromodibenzo[b,d]furan (15 g, 60.7 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromodibenzo[b,d]furan and 1,2,4-trichlorobenzene, and the mixture was stirred while heating up to 140°C and then keeping that temperature. After the reaction for 8 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6 g of Compound Sub5-2-1. (Yield: 40 %, MS: [M+H]⁺= 249)

Compound Sub5-2-1 (15 g, 60.2 mmol) and bis(pinacolato)diboron (16.8 g, 66.2 mmol) was added to 300 ml of 1,4-dioxane, and the mixture was stirred under reflux. Then, potassium acetate (8.9 g, 90.3 mmol) was added thereto, and the mixture was sufficiently stirred, and then bis(dibenzylideneacetone)palladium(0) (1 g, 1.8 mmol) and tricyclohexylphosphine (1 g, 3.6 mmol) were added. After the reaction for 4 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 12.5 g of Compound Sub5-2-2. (Yield: 70 %, MS: [M+H]⁺= 297)

Compound Sub5-2-2 (15 g, 50.6 mmol) and Compound Trz37 (23.9 g, 53.2 mmol) were added to 300 ml of **THF,** and the mixture was stirred and refluxed. Then, potassium carbonate (21 g, 151.9 mmol) was dissolved in 63 ml of water and added thereto, and the mixture was sufficiently stirred and then bis(tri-tert-butylphosphine)palladium(0) (0.3 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.5 g of Compound 1-45. (Yield: 66 %, MS: [M+H]⁺= 583)

### Synthesis Example 1-46

Compound Sub5-2-2 (15 g, 50.6 mmol) and Compound Trz38 (28 g, 53.2 mmol) were added to 300 ml of **THF,** and the mixture was stirred and refluxed. Then, potassium carbonate (21 g, 151.9 mmol) was dissolved in 63 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.4 g of Compound 1-46. (Yield: 64 %, MS: [M+H]⁺= 660)

### Synthesis Example 1-47

Compound Sub5-2-2 (15 g, 50.6 mmol) and Compound Trz39 (21.9 g, 53.2 mmol) were added to 300 ml of THF, and the mixture was stirred and refluxed. Then, potassium carbonate (21 g, 151.9 mmol) was dissolved in 63 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.1g of Compound 1-47. (Yield: 69 %, MS: [M+H]⁺= 546)

### Synthesis Example 1-48

Compound Sub5-2-2 (15 g, 50.6 mmol) and Compound Trz40 (31.7 g, 53.2 mmol) were added to 300 ml of THF, and the mixture was stirred and refluxed. Then, potassium carbonate (21 g, 151.9 mmol) was dissolved in 63 ml of water and added thereto, and the mixture was sufficiently stirred and then bis(tri-tert-butylphosphine)palladium(0) (0.3 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.9 g of Compound 1-48. (Yield: 69 %, MS: [M+H]⁺= 685)

### Synthesis Example 1-49

Compound Sub5-2-2 (15 g, 50.6 mmol) and Compound Trz41 (25.4 g, 53.2 mmol) were added to 300 ml of **THF,** and the mixture was stirred and refluxed. Then, potassium carbonate (21 g, 151.9 mmol) was dissolved in 63 ml of water and added thereto, and the mixture was sufficiently stirred and then bis(tri-tert-butylphosphine)palladium(0) (0.3 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.5g of Compound 1-49. (Yield: 75 %, MS: [M+H]⁺= 568)

### Synthesis Example 1-50

Trifluoromethanesulfonic anhydride (71.9 g, 255 mmol) and deuterium oxide (25.5 g, 1274.8 mmol) were added at 0°C, and the mixture was stirred for 5 hours to prepare a solution. 1-bromodibenzo[b,d]furan (15 g, 60.7 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromodibenzo[b,d]furan and 1,2,4-trichlorobenzene, and the mixture was stirred while heating up to 140°C and then keeping that temperature. After the reaction for 14 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.3 g of Compound Sub5-3-1. (Yield: 42 %, MS: [M+H]⁺= 250)

Compound Sub5-3-1 (15 g, 60 mmol) and bis(pinacolato)diboron (16.8 g, 66 mmol) was added to 300 ml of 1,4-dioxane, and the mixture was stirred under reflux. Then, potassium acetate (8.8 g, 90 mmol) was added thereto, and the mixture was sufficiently stirred, and then bis(dibenzylideneacetone)palladium(0) (1 g, 1.8 mmol) and tricyclohexylphosphine (1 g, 3.6 mmol) were added. After the reaction for 6 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 11.4 g of Compound Sub5-3-2. (Yield: 64%, MS: [M+H]⁺= 298)

Compound Sub5-3-2 (15 g, 50.5 mmol) and Compound Trz42 (25.2 g, 53 mmol) were added to 300 ml of THF, and the mixture was stirred and refluxed. Then, potassium carbonate (20.9 g, 151.4 mmol) was dissolved in 63 ml of water and added thereto, and the mixture was sufficiently stirred and then bis(tri-tert-butylphosphine)palladium(0) (0.3 g, 0.5 mmol) was added. After the reaction for 2 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.3 g of Compound 1-50. (Yield: 66 %, MS: [M+H]⁺= 610)

### Synthesis Example 1-51

Compound Sub5-3-2 (15 g, 50.5 mmol) and Compound Trz43 (23.5 g, 53 mmol) were added to 300 ml of THF, and the mixture was stirred and refluxed. Then, potassium carbonate (20.9 g, 151.4 mmol) was dissolved in 63 ml of water and added thereto, and the mixture was sufficiently stirred and then bis(tri-tert-butylphosphine)palladium(0) (0.3 g, 0.5 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.6 g of Compound 1-51. (Yield: 69 %, MS: [M+H]⁺= 534)

### Synthesis Example 1-52

Compound Sub5-3-2 (15 g, 50.5 mmol) and Compound Trz44 (22.8 g, 53 mmol) were added to 300 ml of THF, and the mixture was stirred and refluxed. Then, potassium carbonate (20.9 g, 151.4 mmol) was dissolved in 63ml of water and added thereto, and the mixture was sufficiently stirred and then bis(tri-tert-butylphosphine)palladium(0) (0.3 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.1 g of Compound 1-52. (Yield: 74 %, MS: [M+H]⁺= 565)

### Synthesis Example 1-53

Trifluoromethanesulfonic anhydride (95.9 g, 340 mmol) and deuterium oxide (34 g, 1699.8 mmol) were added at 0°C, and the mixture was stirred for 5 hours to prepare a solution. 1-bromodibenzo[b,d]furan (15 g, 60.7 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromodibenzo[b,d]furan and 1,2,4-trichlorobenzene, and the mixture was stirred while heating up to 140°C and then keeping that temperature. After the reaction for 20 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.6 g of Compound Sub5-4-1. (Yield: 37 %, MS: [M+H]⁺= 251)

Compound Sub5-4-1 (15 g, 59.7 mmol) and bis(pinacolato)diboron (16.7 g, 65.7 mmol) was added to 300 ml of 1,4-dioxane, and the mixture was stirred under reflux. Then, potassium acetate (8.8 g, 89.6 mmol) was added thereto, and the mixture was sufficiently stirred, and then bis(dibenzylideneacetone)palladium(0) (1 g, 1.8 mmol) and tricyclohexylphosphine (1 g, 3.6 mmol) were added. After the reaction for 5 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 12.5 g of Compound Sub5-4-2. (Yield: 70 %, MS: [M+H]⁺= 299)

Compound Sub5-4-2 (15 g, 50.3 mmol) and Compound Trz45 (28.1 g, 52.8 mmol) were added to 300 ml of **THF,** and the mixture was stirred and refluxed. Then, potassium carbonate (20.9 g, 150.9 mmol) was dissolved in 63 ml of water and added thereto, and the mixture was sufficiently stirred and then bis(tri-tert-butylphosphine)palladium(0) (0.3 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.8 g of Compound 1-53. (Yield: 71 %, MS: [M+H]⁺= 668)

### Synthesis Example 1-54

Trifluoromethanesulfonic anhydride (119.9 g, 424.9 mmol) and deuterium oxide (42.6 g, 2124.7 mmol) were added at 0°C, and the mixture was stirred for 5 hours to prepare a solution. 1-bromodibenzo[b,d]furan (15 g, 60.7 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromodibenzo[b,d]furan and 1,2,4-trichlorobenzene, and the mixture was stirred while heating up to 140°C and then keeping that temperature. After the reaction for 24 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.9 g of Compound Sub5-5-1. (Yield: 39 %, MS: [M+H]⁺= 252)

Compound Sub5-5-1 (15 g, 59.5 mmol) and bis(pinacolato)diboron (16.6 g, 65.4 mmol) was added to 300 ml of 1,4-dioxane, and the mixture was stirred under reflux. Then, potassium acetate (8.8 g, 89.2 mmol) was added thereto, and the mixture was sufficiently stirred, and then bis(dibenzylideneacetone)palladium(0) (1 g, 1.8 mmol) and tricyclohexylphosphine(1 g, 3.6 mmol) were added. After the reaction for 4 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 11.2 g of Compound Sub5-5-2. (Yield: 63 %, MS: [M+H]⁺= 300)

Compound Sub5-5-2 (15 g, 50.1 mmol) and Compound Trz46 (27.6 g, 52.6 mmol) were added to 300 ml of THF, and the mixture was stirred and refluxed. Then, potassium carbonate (20.8 g, 150.4 mmol) was dissolved in 62 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.2 g of Compound 1-54. (Yield: 73 %, MS: [M+H]⁺= 581)

### Synthesis Example 1-55

Compound Sub5-5-2 (15 g, 50.1 mmol) and Compound Trz47 (27.6 g, 52.6 mmol) were added to 300 ml of THF, and the mixture was stirred and refluxed. Then, potassium carbonate (20.8 g, 150.4 mmol) was dissolved in 62 ml of water and added thereto, and the mixture was sufficiently stirred and then bis(tri-tert-butylphosphine)palladium(0) (0.3 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.9 g of Compound 1-55. (Yield:75 %, MS: [M+H]⁺= 662)

### Synthesis Example 1-56

Compound Sub5-5-2 (15 g, 50.1 mmol) and Compound Trz22 (29.7 g, 52.6 mmol) were added to 300 ml of THF, and the mixture was stirred and refluxed. Then, potassium carbonate (20.8 g, 150.4 mmol) was dissolved in 62 ml of water and added thereto, and the mixture was sufficiently stirred and then bis(tri-tert-butylphosphine)palladium(0) (0.3 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.4 g of Compound 1-56. (Yield:71 %, MS: [M+H]⁺= 657)

### Synthesis Example 1-57

Compound Sub5-5-2 (15 g, 50.1 mmol) and Compound Trz48 (27.3 g, 52.6 mmol) were added to 300 ml of **THF,** and the mixture was stirred and refluxed. Then, potassium carbonate (20.8 g, 150.4 mmol) was dissolved in 62 ml of water and added thereto, and the mixture was sufficiently stirred and then bis(tri-tert-butylphosphine)palladium(0) (0.3 g, 0.5 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19 g of Compound 1-57. (Yield: 62 %, MS: [M+H]⁺= 612)

### Synthesis Example 1-58

Compound Sub5-5-2 (15 g, 50.1 mmol) and Compound Trz49 (27.1 g, 52.6 mmol) were added to 300 ml of THF, and the mixture was stirred and refluxed. Then, potassium carbonate (20.8 g, 150.4 mmol) was dissolved in 62 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.5 g of Compound 1-58. (Yield: 64 %, MS: [M+H]⁺= 607)

### Synthesis Example 1-59

Trifluoromethanesulfonic anhydride (167.8 g, 594.9 mmol) and deuterium oxide (59.6 g, 2974.6 mmol) were added at 0°C, and the mixture was stirred for 5 hours to prepare a solution. 1-bromodibenzo[b,d]furan (15 g, 60.7 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromodibenzo[b,d]furan and 1,2,4-trichlorobenzene, and the mixture was stirred while heating up to 140°C and then keeping that temperature. After the reaction for 36 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.1 g of Compound Sub5-6-1. (Yield: 40 %, MS: [M+H]⁺= 254)

Compound Sub5-6-1 (15 g, 59 mmol) and bis(pinacolato)diboron (16.5 g, 64.9 mmol) was added to 300 ml of 1,4-dioxane, and the mixture was stirred under reflux. Then, potassium acetate (8.7 g, 88.5 mmol) was added thereto, and the mixture was sufficiently stirred, and then bis(dibenzylideneacetone)palladium(0) (1 g, 1.8 mmol) and tricyclohexylphosphine (1 g, 3.5 mmol) were added. After the reaction for 4 hours, the reaction mixture was cooled to room temperature, the organic layer was separated using chloroform and water, and then the organic layer was distilled. This was dissolved again in chloroform, washed twice with water, and the organic layer was then separated. Anhydrous magnesium sulfate was added thereto, stirred, then filtered, and the filtrate was distilled under reduced pressure. The concentrated compound was purified by silica gel column chromatography to prepare 11.6 g of Compound Sub5-6-2. (Yield: 65 %, MS: [M+H]⁺= 302)

Compound Sub5-6-2 (15 g, 50 mmol) and Compound Trz50 (24.2 g, 52.5 mmol) were added to 300 ml of THF, and the mixture was stirred and refluxed. Then, potassium carbonate (20.7 g, 149.9 mmol) was dissolved in 62 ml of water and added thereto, and the mixture was sufficiently stirred and then bis(tri-tert-butylphosphine)palladium(0) (0.3 g, 0.5 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.5 g of Compound 1-59. (Yield: 75 %, MS: [M+H]⁺= 601)

### Synthesis Example 1-60

Compound Sub5-6-2 (15 g, 50 mmol) and Compound Trz51 (24.1 g, 52.5 mmol) were added to 300 ml of THF, and the mixture was stirred and refluxed. Then, potassium carbonate (20.7 g, 149.9 mmol) was dissolved in 62 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.1 g of Compound 1-60. (Yield: 74 %, MS: [M+H]⁺= 599)

### Synthesis Example 1-61

Compound Sub5-6-2 (15 g, 50 mmol) and Compound Trz52 (25.3 g, 52.5 mmol) were added to 300 ml of THF, and the mixture was stirred and refluxed. Then, potassium carbonate (20.7 g, 149.9 mmol) was dissolved in 62 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.6 g of Compound 1-61. (Yield:75 %, MS: [M+H]⁺= 577)

### Synthesis Example 1-62

Compound Sub5-6-2 (15 g, 50 mmol) and Compound Trz53 (32 g, 52.5 mmol) were added to 300 ml of THF, and the mixture was stirred and refluxed. Then, potassium carbonate (20.7 g, 149.9 mmol) was dissolved in 62 ml of water and added thereto, and the mixture was sufficiently stirred and then bis(tri-tert-butylphosphine)palladium(0) (0.3 g, 0.5 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26 g of Compound 1-62. (Yield: 74 %, MS: [M+H]⁺= 704)

### Synthesis Example 1-63

Compound Sub5-6-2 (15 g, 50 mmol) and Compound Trz54 (27.3 g, 52.5 mmol) were added to 300 ml of THF, and the mixture was stirred and refluxed. Then, potassium carbonate (20.7 g, 149.9 mmol) was dissolved in 62 ml of water and added thereto, and the mixture was sufficiently stirred and then bis(tri-tert-butylphosphine)palladium(0) (0.3 g, 0.5 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.4 g of Compound 1-63. (Yield: 60 %, MS: [M+H]⁺= 615)

### Synthesis Example 1-64

Dibenzo[b,d]furan-1-ylboronic acid (15 g, 70.8 mmol) and Compound Trz55 (45.7 g, 74.3 mmol) were added to 300 ml of THF, and the mixture was stirred and refluxed. Then, potassium carbonate (29.3 g, 212.3 mmol) was dissolved in 88 ml of water and added thereto, and the mixture was sufficiently stirred and then bis(tri-tert-butylphosphine)palladium(0) (0.4 g, 0.7 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 32.2 g of Compound 1-64_P1. (Yield: 65 %, MS: [M+H]⁺= 702)

Compound 1-64_P1 (10 g, 14.2 mmol), PtO₂ (1 g, 4.3 mmol) and D₂O (71 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4 g of Compound 1-64. (Yield: 39 %, MS: [M+H]⁺= 727)

### Synthesis Example 1-65

Dibenzo[b,d]furan-1-ylboronic acid (15 g, 70.8 mmol) and Compound Trz56 (33 g, 74.3 mmol) were added to 300 ml of THF, and the mixture was stirred and refluxed. Then, potassium carbonate (29.3 g, 212.3 mmol) was dissolved in 88 ml of water and added thereto, and the mixture was sufficiently stirred and then bis(tri-tert-butylphosphine)palladium(0) (0.4 g, 0.7 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 29.7 g of Compound 1-65_P1. (Yield:73 %, MS: [M+H]⁺= 576)

Compound 1-65_P1 (10 g, 17.4 mmol), PtO₂(1.2 g, 5.2 mmol), and D₂O (87 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 5.1 g of Compound 1-65. (Yield: 49 %, MS: [M+H]⁺= 599)

### Synthesis Example 1-66

Dibenzo[b,d]furan-1-ylboronic acid (15 g, 70.8 mmol) and Compound Trz46 (33 g, 74.3 mmol) were added to 300 ml of THF, and the mixture was stirred and refluxed. Then, potassium carbonate (29.3 g, 212.3 mmol) was dissolved in 88 ml of water and added thereto, and the mixture was sufficiently stirred and then bis(tri-tert-butylphosphine)palladium(0) (0.4 g, 0.7 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.8 g of Compound 1-66_P1. (Yield: 61 %, MS: [M+H]⁺= 576)

Compound 1-66_P1 (10 g, 17.4 mmol), PtO₂ (1.2 g, 5.2 mmol) and D₂O (87 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 5 g of Compound 1-66. (Yield: 48 %, MS: [M+H]⁺= 598)

### Synthesis Example 1-67

Dibenzo[b,d]furan-1-ylboronic acid (15 g, 70.8 mmol) and Compound Trz57 (33 g, 74.3 mmol) were added to 300 ml of THF, and the mixture was stirred and refluxed. Then, potassium carbonate (29.3 g, 212.3 mmol) was dissolved in 88 ml of water and added thereto, and the mixture was sufficiently stirred and then bis(tri-tert-butylphosphine)palladium(0) (0.4 g, 0.7 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.5 g of Compound 1-67_P1. (Yield:65 %, MS: [M+H]⁺= 576)

Compound 1-67_P1 (10 g, 17.4 mmol), PtO₂ (1.2 g, 5.2 mmol)1and D₂O (87 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4.4 g of Compound 1-67. (Yield: 42 %, MS: [M+H]⁺= 598)

### Synthesis Example 1-68

Dibenzo[b,d]furan-1-ylboronic acid (15 g, 70.8 mmol) and Compound Trz58 (33 g, 74.3 mmol) were added to 300 ml of THF, and the mixture was stirred and refluxed. Then, potassium carbonate (29.3 g, 212.3 mmol) was dissolved in 88 ml of water and added thereto, and the mixture was sufficiently stirred and then bis(tri-tert-butylphosphine)palladium(0) (0.4 g, 0.7 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.5 g of Compound 1-68_P1. (Yield: 65 %, MS: [M+H]⁺= 576)

Compound 1-68_P1 (10 g, 17.4 mmol), PtO₂ (1.2 g, 5.2 mmol) and D₂O (87 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.6 g of Compound 1-68. (Yield: 35%, MS: [M+H]⁺= 598)

### (Synthesis Scheme of Compound 2-AA to Compound 2-AS)

Compound 2-AA to Compound 2-AS are as follows.

### Preparation Example 2-1: Preparation of Compound 2-AA

1-Bromo-3-chloronaphthalen-2-amine (15 g, 58.5 mmol) and benzoyl chloride (9.9 g, 70.2 mmol) were added to 300 ml of chloroform under a nitrogen atmosphere, and the mixture was stirred. Then, pyridine (6.9 g, 87.7 mmol) was added dropwise thereto. After the reaction for 9 hours at room temperature, 600 ml of ethanol was added and solidified. The solid was filtered, then dissolved in chloroform again, and washed twice with water. The organic layer was separated, and anhydrous magnesium sulfate was added, stirred, and then filtered, and the filtrate was distilled under reduced pressure. The concentrated compound was purified by a silica gel column chromatography to prepare 17 g of Compound 2-AA_P1. (Yield: 81%, MS: [M+H]⁺=360).

Compound 2-AA_P1 (15 g, 41.6 mmol) and potassium carbonate (17.2 g, 124.8 mmol) were added to 150 ml of DMF under a nitrogen atmosphere, and the mixture was stirred and refluxed. Then, the mixture was sufficiently stirred, and then copper iodide (0.1 g, 0.4 mmol) and 1,10-phenanthroline (0.1 g, 0.8 mmol) were added. After the reaction for 11 hours, the reaction mixture was cooled to room temperature, poured into 300 ml of water and solidified. The solid was filtered, and then dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 9.6 g of Compound 2-AA. (Yield: 83 %, MS: [M+H]⁺= 280)

### Preparation Example 2-2: Preparation of Compound 2-AB

Compound 2-AB was prepared in the same manner as in Preparation Example 2-1, except that 1-bromo-4-chloronaphthalen-2-amine was used instead of 1-bromo-3-chloronaphthalen-2-amine.

### Preparation Example 2-3: Preparation of Compound 2-AC

Compound 2-AC was prepared in the same manner as in Preparation Example 2-1, except that 1-bromo-5-chloronaphthalen-2-amine was used instead of 1-bromo-3-chloronaphthalen-2-amine.

### Preparation Example 2-4: Preparation of Compound 2-AD

Compound 2-AD was prepared in the same manner as in Preparation Example 2-1, except that 1-bromo-6-chloronaphthalen-2-amine was used instead of 1-bromo-3-chloronaphthalen-2-amine.

### Preparation Example 2-5: Preparation of Compound 2-AE

Compound 2-AE was prepared in the same manner as in Preparation Example 2-1, except that 1-bromo-7-chloronaphthalen-2-amine was used instead of 1-bromo-3-chloronaphthalen-2-amine.

### Preparation Example 2-6: Preparation of Compound 2-AF

Compound 2-AF was prepared in the same manner as in Preparation Example 2-1, except that 1-bromo-8-chloronaphthalen-2-amine was used instead of 1-bromo-3-chloronaphthalen-2-amine.

### Preparation Example 2-7: Preparation of Compound 2-AG

Compound 2-AG was prepared in the same manner as in Preparation Example 2-1, except that [1,1'-biphenyl]-4-carbonyl chloride was used instead of benzoyl chloride.

### Preparation Example 2-8: Preparation of Compound 2-AH

Compound 2-AH was prepared in the same manner as in Preparation Example 2-1, except that [1,1'-biphenyl]-4-carbonyl chloride was used instead of benzoyl chloride, and 1-bromo-4-chloronaphthalen-2-amine was used instead of 1-bromo-3-chloronaphthalen-2-amine.

### Preparation Example 2-9: Preparation of Compound 2-AI

Compound 2-AH was prepared in the same manner as in Preparation Example 2-1, except that [1,1'-biphenyl]-4-carbonyl chloride was used instead of benzoyl chloride, and 1-bromo-5-chloronaphthalen-2-amine was used instead of 1-bromo-3-chloronaphthalen-2-amine.

### Preparation Example 2-10: Preparation of Compound 2-AJ

Compound 2-AJ was prepared in the same manner as in Preparation Example 2-1, except that [1,1'-biphenyl]-4-carbonyl chloride was used instead of benzoyl chloride, and 1-bromo-6-chloronaphthalen-2-amine was used instead of 1-bromo-3-chloronaphthalen-2-amine.

### Preparation Example 2-11: Preparation of Compound 2-AK

Compound 2-AK was prepared in the same manner as in Preparation Example 2-1, except that [1,1'-biphenyl]-4-carbonyl chloride was used instead of benzoyl chloride, and 1-bromo-7-chloronaphthalen-2-amine was used instead of 1-bromo-3-chloronaphthalen-2-amine.

### Preparation Example 2-12: Preparation of Compound 2-AL

Compound 2-AL was prepared in the same manner as in Preparation Example 2-1, except that [1,1'-biphenyl]-4-carbonyl chloride was used instead of benzoyl chloride, and 1-bromo-8-chloronaphthalen-2-amine was used instead of 1-bromo-3-chloronaphthalen-2-amine.

### Preparation Example 2-13: Preparation of Compound 2-AM

Compound 2-AM was prepared in the same manner as in Preparation Example 2-1, except that 2-naphthoyl chloride was used instead of benzoyl chloride.

### Preparation Example 2-14: Preparation of Compound 2-AN

Compound 2-AN was prepared in the same manner as in Preparation Example 2-1, except that 2-naphthoyl chloride was used instead of benzoyl chloride, and 1-bromo-4-chloronaphthalen-2-amine was used instead of 1-bromo-3-chloronaphthalen-2-amine.

### Preparation Example 2-15: Preparation of Compound 2-AO

Compound 2-AO was prepared in the same manner as in Preparation Example 2-1, except that 2-naphthoyl chloride was used instead of benzoyl chloride, and 1-bromo-5-chloronaphthalen-2-amine was used instead of 1-bromo-3-chloronaphthalen-2-amine.

### Preparation Example 2-16: Preparation of Compound 2-AP

Compound 2-AP was prepared in the same manner as in Preparation Example 2-1, except that 2-naphthoyl chloride was used instead of benzoyl chloride, and 1-bromo-6-chloronaphthalen-2-amine was used instead of 1-bromo-3-chloronaphthalen-2-amine.

### Preparation Example 2-17: Preparation of Compound 2-AQ

Compound 2-AQ was prepared in the same manner as in Preparation Example 2-1, except that 2-naphthoyl chloride was used instead of benzoyl chloride, and 1-bromo-7-chloronaphthalen-2-amine was used instead of 1-bromo-3-chloronaphthalen-2-amine.

### Preparation Example 2-18: Preparation of Compound 2-AR

Compound 2-AR was prepared in the same manner as in Preparation Example 2-1, except that 2-naphthoyl chloride was used instead of benzoyl chloride, and 1-bromo-8-chloronaphthalen-2-amine was used instead of 1-bromo-3-chloronaphthalen-2-amine.

### Preparation Example 2-19: Preparation of Compound 2-AS

Compound 2-AS was prepared in the same manner as in Preparation Example 2-1, except that 4-chlorobenzoyl chloride was used instead of benzoyl chloride, and 1-bromonaphthalen-2-amine was used instead of 1-bromo-3-chloronaphthalen-2-amine.

### (Synthesis Scheme of Compound 2-BA to Compound 2-BT)

Compound 2-BA to Compound 2-BT are as follows.

### Preparation Example 2-20: Preparation of Compound 2-BA

Compound 2-BA was prepared in the same manner as in Preparation Example 2-1, except that 2-bromo-3-chloronaphthalen-1-amine was used instead of 1-bromo-3-chloronaphthalen-2-amine.

### Preparation Example 2-21: Preparation of Compound 2-BB

Compound 2-BB was prepared in the same manner as in Preparation Example 2-1, except that 2-bromo-4-chloronaphthalen-1-amine was used instead of 1-bromo-3-chloronaphthalen-2-amine.

### Preparation Example 2-22: Preparation of Compound 2-BC

Compound 2-BC was prepared in the same manner as in Preparation Example 2-1, except that 2-bromo-5-chloronaphthalen-1-am ine was used instead of 1-bromo-3-chloronaphthalen-2-amine.

### Preparation Example 2-23: Preparation of Compound 2-BD

Compound 2-BD was prepared in the same manner as in Preparation Example 2-1, except that 2-bromo-6-chloronaphthalen-1-am ine was used instead of 1-bromo-3-chloronaphthalen-2-amine.

### Preparation Example 2-24: Preparation of Compound 2-BE

Compound 2-BE was prepared in the same manner as in Preparation Example 2-1, except that 2-bromo-7-chloronaphthalen-1-amine was used instead of 1-bromo-3-chloronaphthalen-2-amine.

### Preparation Example 2-25: Preparation of Compound 2-BF

Compound 2-BF was prepared in the same manner as in Preparation Example 2-1, except that 2-bromo-8-chloronaphthalen-1-amine was used instead of 1-bromo-3-chloronaphthalen-2-amine.

### Preparation Example 2-26: Preparation of Compound 2-BG

Compound 2-BG was prepared in the same manner as in Preparation Example 2-1, except that [1,1'-biphenyl]-4-carbonyl chloride was used instead of benzoyl chloride, and 2-bromo-3-chloronaphthalen-1-amine was used instead of 1-bromo-3-chloronaphthalen-2-amine.

### Preparation Example 2-27: Preparation of Compound 2-BH

Compound 2-BH was prepared in the same manner as in Preparation Example 2-1, except that [1,1'-biphenyl]-4-carbonyl chloride was used instead of benzoyl chloride, and 2-bromo-4-chloronaphthalen-1-amine was used instead of 1-bromo-3-chloronaphthalen-2-amine.

### Preparation Example 2-28: Preparation of Compound 2-BI

Compound 2-BI was prepared in the same manner as in Preparation Example 2-1, except that [1,1'-biphenyl]-4-carbonyl chloride was used instead of benzoyl chloride, and 2-bromo-5-chloronaphthalen-1-amine was used instead of 1-bromo-3-chloronaphthalen-2-amine.

### Preparation Example 2-29: Preparation of Compound 2-BJ

Compound 2-BJ was prepared in the same manner as in Preparation Example 2-1, except that [1,1'-biphenyl]-4-carbonyl chloride was used instead of benzoyl chloride, and 2-bromo-6-chloronaphthalen-1-amine was used instead of 1-bromo-3-chloronaphthalen-2-amine.

### Preparation Example 2-30: Preparation of Compound 2-BK

Compound 2-BK was prepared in the same manner as in Preparation Example 2-1, except that [1,1'-biphenyl]-4-carbonyl chloride was used instead of benzoyl chloride, and 2-bromo-7-chloronaphthalen-1-amine was used instead of 1-bromo-3-chloronaphthalen-2-amine.

### Preparation Example 2-31: Preparation of Compound 2-BL

Compound 2-BL was prepared in the same manner as in Preparation Example 2-1, except that [1,1'-biphenyl]-4-carbonyl chloride was used instead of benzoyl chloride, and 2-bromo-8-chloronaphthalen-1-amine was used instead of 1-bromo-3-chloronaphthalen-2-amine.

### Preparation Example 2-32: Preparation of Compound 2-BM

Compound 2-BM was prepared in the same manner as in Preparation Example 2-1, except that 2-naphthoyl chloride was used instead of benzoyl chloride, and 2-bromo-3-chloronaphthalen-1-amine was used instead of 1-bromo-3-chloronaphthalen-2-amine.

### Preparation Example 2-33: Preparation of Compound 2-BN

Compound 2-BN was prepared in the same manner as in Preparation Example 2-1, except that 2-naphthoyl chloride was used instead of benzoyl chloride, and 2-bromo-4-chloronaphthalen-1-amine was used instead of 1-bromo-3-chloronaphthalen-2-amine.

### Preparation Example 2-34: Preparation of Compound 2-BO

Compound 2-BO was prepared in the same manner as in Preparation Example 2-1, except that 2-naphthoyl chloride was used instead of benzoyl chloride, and 2-bromo-5-chloronaphthalen-1-amine was used instead of 1-bromo-3-chloronaphthalen-2-amine.

### Preparation Example 2-35: Preparation of Compound 2-BP

Compound 2-BP was prepared in the same manner as in Preparation Example 2-1, except that 2-naphthoyl chloride was used instead of benzoyl chloride, and 2-bromo-6-chloronaphthalen-1-amine was used instead of 1-bromo-3-chloronaphthalen-2-amine.

### Preparation Example 2-36: Preparation of Compound 2-BQ

Compound 2-BQ was prepared in the same manner as in Preparation Example 2-1, except that 2-naphthoyl chloride was used instead of benzoyl chloride, and 2-bromo-7-chloronaphthalen-1-amine was used instead of 1-bromo-3-chloronaphthalen-2-amine.

### Preparation Example 2-37: Preparation of Compound 2-BR

Compound 2-BR was prepared in the same manner as in Preparation Example 2-1, except that 2-naphthoyl chloride was used instead of benzoyl chloride, and 2-bromo-8-chloronaphthalen-1-amine was used instead of 1-bromo-3-chloronaphthalen-2-amine.

### Preparation Example 2-38: Preparation of Compound 2-BS

Compound 2-BS was prepared in the same manner as in Preparation Example 2-1, except that 4-chlorobenzoyl chloride was used instead of benzoyl chloride, and 2-bromonaphthalen-1-amine was used instead of 1-bromo-3-chloronaphthalen-2-amine.

### Preparation Example 2-39: Preparation of Compound 2-BT

Compound 2-BT was prepared in the same manner as in Preparation Example 2-1, except that 4-chloro-1-naphtoyl chloride was used instead of benzoyl chloride, and 2-bromonaphthalen-1-amine was used instead of 1-bromo-3-chloronaphthalen-2-amine.

### Synthesis Example 2-1

Compound 2-AA (10 g, 35.8 mmol), Compound amine1 (16 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 16.8 g of Compound 2-1. (Yield: 68%, MS: [M+H]+= 691)

### Synthesis Example 2-2

Compound 2-AB (10 g, 35.8 mmol), Compound amine2 (12.9 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.2 g of Compound 2-2. (Yield: 61%, MS: [M+H]⁺= 605)

### Synthesis Example 2-3

Compound 2-AC (10 g, 35.8 mmol), Compound amine3 (16 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 17.3 g of Compound 2-3. (Yield: 70%, MS: [M+H]⁺= 691)

### Synthesis Example 2-4

Compound 2-AD (10 g, 35.8 mmol), Compound amine4 (10.6 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 12.7 g of Compound 2-4. (Yield: 66%, MS: [M+H]⁺= 539)

### Synthesis Example 2-5

Compound 2-AE (10 g, 35.8 mmol), Compound amine5 (13.3 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.4 g of Compound 2-5. (Yield: 61%, MS: [M+H]⁺= 615)

### Synthesis Example 2-6

Compound 2-AE (10 g, 35.8 mmol), Compound amine6 (12 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.4 g of Compound 2-6. (Yield: 65%, MS: [M+H]⁺= 579)

### Synthesis Example 2-7

Compound 2-AF (10 g, 35.8 mmol), Compound amine7 (12.3 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.5 g of Compound 2-7. (Yield: 64%, MS: [M+H]⁺= 589)

### Synthesis Example 2-8

Compound 2-AA (15 g, 53.6 mmol) and Compound amine8 (25.6 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.9 g of Compound 2-8. (Yield: 68%, MS: [M+H]⁺ = 655)

### Synthesis Example 2-9

Compound 2-AB (15 g, 53.6 mmol) and Compound amine9 (29.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.9 g of Compound 2-9. (Yield: 61%, MS: [M+H]⁺= 730)

### Synthesis Example 2-10

Compound 2-AC (15 g, 53.6 mmol) and Compound amine10 (29.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.2 g of Compound 2-10. (Yield: 62%, MS: [M+H]⁺= 730)

### Synthesis Example 2-11

Compound 2-AD (15 g, 53.6 mmol) and Compound amine11 (24.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.9 g of Compound 2-11. (Yield: 61%, MS: [M+H]⁺= 641)

### Synthesis Example 2-12

Compound 2-AD (15 g, 53.6 mmol) and Compound amine12 (30.5 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.8 g of Compound 2-12. (Yield: 65%, MS: [M+H]⁺= 741)

### Synthesis Example 2-13

Compound 2-AE (15 g, 53.6 mmol) and Compound amine13 (21.4 g, 56.3 mmol) were added to 300 ml of **THF** under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.6 g of Compound 2-13. (Yield: 60%, MS: [M+H]⁺= 579)

### Synthesis Example 2-14

Compound 2-AE (15 g, 53.6 mmol) and Compound amine14 (23.4 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.1 g of Compound 2-14. (Yield: 67%, MS: [M+H]⁺= 615)

### Synthesis Example 2-15

Compound 2-AE (15 g, 53.6 mmol) and Compound amine15 (29.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.2 g of Compound 2-15. (Yield: 62%, MS: [M+H]⁺= 730)

### Synthesis Example 2-16

Compound 2-AE (15 g, 53.6 mmol) and Compound amine11 (24.9 g, 56.3 mmol) were added to 300 ml of **THF** under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23 g of Compound 2-16. (Yield: 67%, MS: [M+H]⁺= 641)

### Synthesis Example 2-17

Compound 2-AF (15 g, 53.6 mmol) and Compound amine16 (27.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.5 g of Compound 2-17. (Yield: 63%, MS: [M+H]⁺= 695)

### Synthesis Example 2-18

Compound 2-AA (15 g, 53.6 mmol) and Compound amine17 (36.2 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 28.5 g of Compound 2-18. (Yield: 63%, MS: [M+H]⁺= 843)

### Synthesis Example 2-19

Compound 2-AD (15 g, 53.6 mmol) and Compound amine18 (24.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.3 g of Compound 2-19. (Yield: 68%, MS: [M+H]⁺= 641)

### Synthesis Example 2-20

Compound 2-AF (15 g, 53.6 mmol) and Compound amine19 (34.8 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.6 g of Compound 2-20. (Yield: 63%, MS: [M+H]⁺= 817)

### Synthesis Example 2-21

Compound 2-AA (15 g, 53.6 mmol) and Compound amine20 (33.3 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.5 g of Compound 2-21. (Yield: 65%, MS: [M+H]⁺= 791)

### Synthesis Example 2-22

Compound 2-AD (15 g, 53.6 mmol) and Compound amine21 (32 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.9 g of Compound 2-22. (Yield: 68%, MS: [M+H]⁺= 767)

### Synthesis Example 2-23

Compound 2-AE (15 g, 53.6 mmol) and Compound amine22 (23.4 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.4 g of Compound 2-23. (Yield: 68%, MS: [M+H]⁺= 615)

### Synthesis Example 2-24

Compound 2-AH (10 g, 28.1 mmol), Compound amine23 (11.2 g, 28.1 mmol) and sodium tert-butoxide (8.9 g, 42.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 14.1 g of Compound 2-24. (Yield: 70%, MS: [M+H]⁺= 717)

### Synthesis Example 2-25

Compound 2-AJ (10 g, 28.1 mmol), Compound amine24 (12.6 g, 28.1 mmol) and sodium tert-butoxide (8.9 g, 42.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.1 g of Compound 2-25. (Yield: 61%, MS: [M+H]⁺= 767)

### Synthesis Example 2-26

Compound 2-AJ (10 g, 28.1 mmol), Compound amine25 (10.4 g, 28.1 mmol) and sodium tert-butoxide (8.9 g, 42.2 mmol were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 11.8 g of Compound 2-26. (Yield: 61%, MS: [M+H]⁺= 691)

### Synthesis Example 2-27

Compound 2-AK (10 g, 28.1 mmol), Compound amine26 (9.8 g, 28.1 mmol) and sodium tert-butoxide (8.9 g, 42.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 11.6 g of Compound 2-27. (Yield: 62%, MS: [M+H]⁺= 669)

### Synthesis Example 2-28

Compound 2-AK (15 g, 42.2 mmol) and Compound amine27 (16.2 g, 44.3 mmol) were added to 300 ml of **THF** under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 16.2 g of Compound 2-28. (Yield: 60%, MS: [M+H]⁺= 641)

### Synthesis Example 2-29

Compound 2-AI (15 g, 42.2 mmol) and Compound amine28 (19.5 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.1 g of Compound 2-29. (Yield: 60%, MS: [M+H]⁺= 717)

### Synthesis Example 2-30

Compound 2-AG (15 g, 42.2 mmol) and Compound amine29 (25.1 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.7 g of Compound 2-30. (Yield: 64%, MS: [M+H]⁺= 843)

### Synthesis Example 2-31

Compound 2-AJ (15 g, 42.2 mmol) and Compound amine30 (22.9 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.4 g of Compound 2-31. (Yield: 67%, MS: [M+H]⁺= 793)

### Synthesis Example 2-32

Compound 2-AI (15 g, 42.2 mmol) and Compound amine31 (21.8 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.6 g of Compound 2-32. (Yield: 70%, MS: [M+H]⁺= 767)

### Synthesis Example 2-33

Compound 2-AL (15 g, 42.2 mmol) and Compound amine32 (22.9 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.4 g of Compound 2-33. (Yield: 70%, MS: [M+H]⁺= 793)

### Synthesis Example 2-34

Compound 2-AK (15 g, 42.2 mmol) and Compound amine33 (25.1 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.3 g of Compound 2-34. (Yield: 60%, MS: [M+H]⁺= 843)

### Synthesis Example 2-35

Compound 2-AI (15 g, 42.2 mmol) and Compound amine34 (22.4 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.7 g of Compound 2-35. (Yield: 69%, MS: [M+H]⁺= 781)

### Synthesis Example 2-36

Compound 2-AH (15 g, 42.2 mmol) and Compound amine35 (22.8 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23 g of Compound 2-36. (Yield: 69%, MS: [M+H]⁺= 791)

### Synthesis Example 2-37

Compound 2-AQ (10 g, 30.3 mmol), Compound amine36 (11.1 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.6 g of Compound 2-37. (Yield: 68%, MS: [M+H]⁺= 659)

### Synthesis Example 2-38

Compound 2-AO (10 g, 30.3 mmol), Compound amine37 (13.6 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 14.4 g of Compound 2-38. (Yield: 64%, MS: [M+H]⁺= 741)

### Synthesis Example 2-39

Compound 2-AQ (10 g, 30.3 mmol), Compound amine38 (10.2 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 12 g of Compound 2-39. (Yield: 63%, MS: [M+H]⁺= 629)

### Synthesis Example 2-40

Compound 2-AQ (15 g, 45.5 mmol) and Compound amine27 (17.4 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.4 g of Compound 2-40. (Yield: 66%, MS: [M+H]⁺= 615)

### Synthesis Example 2-41

Compound 2-AN (15 g, 45.5 mmol) and Compound amine39 (24.7 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.9 g of Compound 2-41. (Yield: 60%, MS: [M+H]⁺= 767)

### Synthesis Example 2-42

Compound 2-AR (15 g, 45.5 mmol) and Compound amine40 (21.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.7 g of Compound 2-42. (Yield: 66%, MS: [M+H]⁺= 691)

### Synthesis Example 2-43

Compound 2-AP (15 g, 45.5 mmol) and Compound amine41 (27.8 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.1 g of Compound 2-43. (Yield: 69%, MS: [M+H]⁺= 831)

### Synthesis Example 2-44

Compound 2-AQ (15 g, 45.5 mmol) and Compound amine42 (23.5 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.9 g of Compound 2-44. (Yield: 68%, MS: [M+H]⁺= 741)

### Synthesis Example 2-45

Compound 2-AN (15 g, 45.5 mmol) and Compound amine43 (27.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26 g of Compound 2-45. (Yield: 70%, MS: [M+H]⁺= 817)

### Synthesis Example 2-46

Compound 2-AQ (15 g, 45.5 mmol) and Compound amine44 (27.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.3 g of Compound 2-46. (Yield: 60%, MS: [M+H]⁺= 817)

### Synthesis Example 2-47

Compound 2-AO (15 g, 43.4 mmol) and Compound amine45 (25.8 g, 45.5 mmol) were added to 300 ml of THF under a nitrogen atmosphere, and the mixture was stirred and refluxed. Then, potassium carbonate (18 g, 130.1 mmol) was dissolved in 54 ml of water and added thereto, and the mixture was sufficiently stirred and then bis(tri-tert-butylphosphine)palladium(0) (0.5 g, 0.4 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.5 g of Compound 2-47. (Yield:54%, MS: [M+H]⁺= 833)

### Synthesis Example 2-48

Compound 2-AP (15 g, 45.5 mmol) and Compound amine46 (23.5 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.2 g of Compound 2-48. (Yield: 60%, MS: [M+H]⁺= 741)

### Synthesis Example 2-49

Compound 2-AN (15 g, 45.5 mmol) and Compound amine47 (23.5 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.5 g of Compound 2-49. (Yield: 64%, MS: [M+H]⁺= 741)

### Synthesis Example 2-50

Compound 2-BA (10 g, 30.3 mmol), Compound amine48 (12.1 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 11.8 g of Compound 2-50. (Yield: 61%, MS: [M+H]⁺= 641)

### Synthesis Example 2-51

Compound 2-BA (10 g, 30.3 mmol), Compound amine49 (11.3 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 11.7 g of Compound 2-51. (Yield: 63%, MS: [M+H]⁺= 615)

### Synthesis Example 2-52

Compound 2-BB (10 g, 30.3 mmol), Compound amine50 (12.9 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 14 g of Compound 2-52. (Yield: 69%, MS: [M+H]⁺= 668)

### Synthesis Example 2-53

Compound 2-BC (10 g, 30.3 mmol), Compound amine51 (14 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 12.8 g of Compound 2-53. (Yield: 60%, MS: [M+H]⁺= 704)

### Synthesis Example 2-54

Compound 2-BD (10 g, 30.3 mmol), Compound amine52 (13.6 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 12.6 g of Compound 2-54. (Yield: 60%, MS: [M+H]⁺= 691)

### Synthesis Example 2-55

Compound 2-BE (10 g, 30.3 mmol), Compound amine53 (12.1 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.2 g of Compound 2-55. (Yield: 68%, MS: [M+H]⁺= 641)

### Synthesis Example 2-56

Compound 2-BA (15 g, 53.6 mmol) and Compound amine54 (27.1 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.9 g of Compound 2-56. (Yield: 60%, MS: [M+H]⁺= 681)

### Synthesis Example 2-57

Compound 2-BC (15 g, 53.6 mmol) and Compound amine55 (26.5 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23 g of Compound 2-57. (Yield: 64%, MS: [M+H]⁺= 671)

### Synthesis Example 2-58

Compound 2-BC (15 g, 53.6 mmol) and Compound amine56 (24.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.7 g of Compound 2-58. (Yield: 66%, MS: [M+H]⁺= 641)

### Synthesis Example 2-59

Compound 2-BE (15 g, 53.6 mmol) and Compound amine57 (22.3 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.3 g of Compound 2-59. (Yield: 70%, MS: [M+H]⁺= 595)

### Synthesis Example 2-60

Compound 2-BF (15 g, 53.6 mmol) and Compound amine58 (32.7 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.5 g of Compound 2-60. (Yield: 61%, MS: [M+H]⁺= 780)

### Synthesis Example 2-61

Compound 2-BE (15 g, 53.6 mmol) and Compound amine59 (36.2 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 31.6 g of Compound 2-61. (Yield: 70%, MS: [M+H]⁺= 843)

### Synthesis Example 2-62

Compound 2-BC (15 g, 53.6 mmol) and Compound amine60 (29.9 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.2 g of Compound 2-62. (Yield: 67%, MS: [M+H]⁺= 730)

### Synthesis Example 2-63

Compound 2-BD (15 g, 53.6 mmol) and Compound amine61 (27.7 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.2 g of Compound 2-63. (Yield: 60%, MS: [M+H]⁺= 691)

### Synthesis Example 2-64

Compound 2-BE (15 g, 53.6 mmol) and Compound amine62 (23.4 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.1g of Compound 2-64. (Yield: 64%, MS: [M+H]⁺= 615)

### Synthesis Example 2-65

Compound 2-BD (15 g, 53.6 mmol) and Compound amine63 (22.8 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.7 g of Compound 2-65. (Yield:67%, MS: [M+H]⁺= 605)

### Synthesis Example 2-66

Compound 2-BF (15 g, 53.6 mmol) and Compound amine64 (31.6 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.9 g of Compound 2-66. (Yield: 66%, MS: [M+H]⁺= 760)

### Synthesis Example 2-67

Compound 2-BB (15 g, 53.6 mmol) and Compound amine65 (32 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.1 g of Compound 2-67. (Yield: 66%, MS: [M+H]⁺= 767)

### Synthesis Example 2-68

Compound 2-BC (15 g, 53.6 mmol) and Compound amine66 (32 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.8 g of Compound 2-68. (Yield: 65%, MS: [M+H]⁺= 569)

### Synthesis Example 2-69

Compound 2-BB (15 g, 53.6 mmol) and Compound amine67 (29.1 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.5 g of Compound 2-69. (Yield: 69%, MS: [M+H]⁺= 717)

### Synthesis Example 2-70

Compound 2-BF (15 g, 53.6 mmol) and Compound amine68 (30.5 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25 g of Compound 2-70. (Yield: 63%, MS: [M+H]⁺= 741)

### Synthesis Example 2-71

Compound 2-BC (15 g, 53.6 mmol) and Compound amine69 (26.2 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.1 g of Compound 2-71. (Yield: 62%, MS: [M+H]⁺= 665)

### Synthesis Example 2-72

Compound 2-BF (15 g, 53.6 mmol) and Compound amine70 (23.4 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.7 g of Compound 2-72. (Yield: 66%, MS: [M+H]⁺= 615)

### Synthesis Example 2-73

Compound 2-BE (15 g, 53.6 mmol) and Compound amine71 (32 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.5 g of Compound 2-73. (Yield: 62%, MS: [M+H]⁺= 767)

### Synthesis Example 2-74

Compound 2-BD (15 g, 53.6 mmol) and Compound amine72 (36.2 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 30.7g of Compound 2-74. (Yield: 68%, MS: [M+H]⁺= 843)

### Synthesis Example 2-75

Compound 2-BC (15 g, 53.6 mmol) and Compound amine73 (39.1 g, 56.3 mmol) were added to 300 ml of THF under a nitrogen atmosphere, and the mixture was stirred and refluxed. Then, potassium carbonate (22.2 g, 160.9 mmol) was dissolved in 67 ml of water and added thereto, and the mixture was sufficiently stirred and then bis(tri-tert-butylphosphine)palladium(0) (0.6 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 29.7 g of Compound 2-75. (Yield: 62%, MS: [M+H]⁺= 893)

### Synthesis Example 2-76

Compound 2-BG (10 g, 28.1 mmol), Compound amine74 (10.4 g, 28.1 mmol) and sodium tert-butoxide (8.9 g, 42.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 12.6 g of Compound 2-76. (Yield: 65%, MS: [M+H]⁺= 691)

### Synthesis Example 2-77

Compound 2-BI (10 g, 28.1 mmol), Compound amine75 (9.4 g, 28.1 mmol) and sodium tert-butoxide (8.9 g, 42.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 11 g of Compound 2-77. (Yield: 60%, MS: [M+H]⁺= 655)

### Synthesis Example .2-78

Compound 2-BJ (10 g, 28.1 mmol), Compound amine76 (10.4 g, 28.1 mmol) and sodium tert-butoxide (8.9 g, 42.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 11.8 g of Compound 2-78. (Yield: 61%, MS: [M+H]⁺= 691)

### Synthesis Example 2-79

Compound 2-BK (10 g, 28.1 mmol), Compound amine77 (11.8 g, 28.1 mmol) and sodium tert-butoxide (8.9 g, 42.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.1 g of Compound 2-79. (Yield: 63%, MS: [M+H]⁺= 741)

### Synthesis Example 2-80

Compound 2-BJ (15 g, 42.2 mmol) and Compound amine78 (16.2 g, 44.3 mmol) were added to 300 ml of **THF** under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 18.1 g of Compound 2-80. (Yield: 67%, MS: [M+H]⁺= 641)

### Synthesis Example 2-81

Compound 2-BG (15 g, 42.2 mmol) and Compound amine79 (21.8 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.7 g of Compound 2-81. (Yield: 61%, MS: [M+H]⁺= 767)

### Synthesis Example 2-82

Compound 2-BI (15 g, 42.2 mmol) and Compound amine80 (26.3 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.9 g of Compound 2-82. (Yield: 68%, MS: [M+H]⁺= 869)

### Synthesis Example 2-83

Compound 2-BH (15 g, 42.2 mmol) and Compound amine81 (20.2 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.7 g of Compound 2-83. (Yield: 64%, MS: [M+H]⁺= 731)

### Synthesis Example 2-84

Compound 2-BG (15 g, 42.2 mmol) and Compound amine82 (21.8 g, 44.3 mmol) were added to 300 ml of **THF** under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20 g of Compound 2-84. (Yield: 62%, MS: [M+H]⁺= 767)

### Synthesis Example 2-85

Compound 2-BL (15 g, 42.2 mmol) and Compound amine83 (22.9 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20 g of Compound 2-85. (Yield: 60%, MS: [M+H]⁺= 793)

### Synthesis Example 2-86

Compound 2-BG (15 g, 42.2 mmol) and Compound amine84 (23.5 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.5 g of Compound 2-86. (Yield: 69%, MS: [M+H]⁺= 807)

### Synthesis Example 2-87

Compound 2-BI (15 g, 42.2 mmol) and Compound amine85 (22.4 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.7 g of Compound 2-87. (Yield: 69%, MS: [M+H]⁺= 781)

### Synthesis Example 2-88

Compound 2-BJ (15 g, 42.2 mmol) and Compound amine86 (20.6 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.6 g of Compound 2-88. (Yield: 66%, MS: [M+H]⁺= 741)

### Synthesis Example 2-89

Compound 2-BI (15 g, 42.2 mmol) and Compound amine87 (22.4 g, 44.3 mmol) were added to 300 ml of THF under a nitrogen atmosphere, and the mixture was stirred and refluxed. Then, potassium carbonate (17.5 g, 126.5 mmol) was dissolved in 52 ml of water and added thereto, and the mixture was sufficiently stirred and then bis(tri-tert-butylphosphine)palladium(0) (0.5 g, 0.4 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.4 g of Compound 2-89. (Yield: 62%, MS: [M+H]⁺= 781)

### Synthesis Example 2-90

Compound 2-BN (10 g, 30.3 mmol), Compound amine88 (11.3 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.3 g of Compound 2-90. (Yield: 66%, MS: [M+H]⁺= 665)

### Synthesis Example 2-91

Compound 2-BM (10 g, 30.3 mmol), Compound amine89 (12.8 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.4 g of Compound 2-91. (Yield: 62%, MS: [M+H]⁺= 715)

### Synthesis Example 2-92

Compound 2-BP (10 g, 30.3 mmol), Compound amine90 (12.1 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.8 g of Compound 2-92. (Yield: 66%, MS: [M+H]⁺= 691)

### Synthesis Example 2-93

Compound 2-BQ (10 g, 30.3 mmol), Compound amine91 (12.1 g, 30.3 mmol) and sodium tert-butoxide (9.7 g, 45.5 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 13.4 g of Compound 2-93. (Yield: 64%, MS: [M+H]⁺= 691)

### Synthesis Example 2-94

Compound 2-BP (15 g, 45.5 mmol) and Compound amine92 (25.6 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.8 g of Compound 2-94. (Yield: 61%, MS: [M+H]⁺= 785)

### Synthesis Example 2-95

Compound 2-BN (15 g, 45.5 mmol) and Compound amine93 (26 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 9 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.6 g of Compound 2-95. (Yield: 68%, MS: [M+H]⁺= 795)

### Synthesis Example 2-96

Compound 2-BP (15 g, 45.5 mmol) and Compound amine94 (27.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.6 g of Compound 2-96. (Yield: 69%, MS: [M+H]⁺= 817)

### Synthesis Example 2-97

Compound 2-BN (15 g, 45.5 mmol) and Compound amine95 (30.7 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.2 g of Compound 2-97. (Yield: 62%, MS: [M+H]⁺= 893)

### Synthesis Example 2-98

Compound 2-BR (15 g, 45.5 mmol) and Compound amine96 (21.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 20.1 g of Compound 2-98. (Yield: 64%, MS: [M+H]⁺= 691)

### Synthesis Example 2-99

Compound 2-BP (15 g, 45.5 mmol) and Compound amine97 (27.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23 g of Compound 2-99. (Yield: 62%, MS: [M+H]⁺= 817)

### Synthesis Example 2-100

Compound 2-BN (15 g, 45.5 mmol) and Compound amine98 (24.7 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.3 g of Compound 2-100. (Yield: 64%, MS: [M+H]⁺= 767)

### Synthesis Example 2-101

Compound 2-BP (15 g, 45.5 mmol) and Compound amine99 (27.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.3 g of Compound 2-101. (Yield: 60%, MS: [M+H]⁺= 817)

### Synthesis Example 2-102

Compound 2-BM (15 g, 45.5 mmol) and Compound amine100 (25.9 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.6 g of Compound 2-102. (Yield: 60%, MS: [M+H]⁺= 791)

### Synthesis Example 2-103

Compound 2-BO (15 g, 45.5 mmol) and Compound amine101 (27.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 8 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26 g of Compound 2-103. (Yield: 70%, MS: [M+H]⁺= 817)

### Synthesis Example 2-104

Compound 2-BO (15 g, 45.5 mmol) and Compound amine102 (24.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 10 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.6 g of Compound 2-104. (Yield: 63%, MS: [M+H]⁺= 791)

### Synthesis Example 2-105

Compound 2-BN (15 g, 45.5 mmol) and Compound amine103 (27.1 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 11 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.7 g of Compound 2-105. (Yield: 69%, MS: [M+H]⁺= 755)

### Synthesis Example 2-106

Compound 2-AS (10 g, 35.8 mmol), Compound amine104 (13.8 g, 35.8 mmol) and sodium tert-butoxide (11.4 g, 53.6 mmol) were added to 200 ml of xylene under a nitrogen atmosphere, and the mixture was stirred and refluxed. Then, bis(tri-tert-butylphosphine)palladium(0) (0.2 g, 0.4 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 14.1 g of Compound 2-106. (Yield: 63%, MS: [M+H]⁺= 629)

### Synthesis Example 2-107

Compound 2-AS (15 g, 45.5 mmol) and Compound amine105 (21.2 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.2 g of Compound 2-107. (Yield: 61%, MS: [M+H]⁺= 691)

### Synthesis Example 2-108

Compound 2-BS (15 g, 53.6 mmol), Compound amine106 (23.1 g, 56.3 mmol) and sodium tert-butoxide (7.7 g, 80.4 mmol) were added to 300 ml of xylene under a nitrogen atmosphere, and the mixture was stirred and refluxed. Then, bis(tri-tert-butylphosphine)palladium(0) (0.3 g, 0.5 mmol) was added thereto. When the reaction was completed after 5 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 22.4 g of Compound 2-108. (Yield: 64%, MS: [M+H]⁺= 654)

### Synthesis Example 2-109

Compound 2-BT (15 g, 45.5 mmol) and Compound amine107 (21.2 g, 47.8 mmol) were added to 300 ml of THF under a nitrogen atmosphere, and the mixture was stirred and refluxed. Then, potassium carbonate (18.9 g, 136.5 mmol) was dissolved in 57 ml of water and added thereto, and the mixture was sufficiently stirred and then bis(tri-tert-butylphosphine)palladium(0) (0.5 g, 0.5 mmol) was added. After the reaction for 12 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.2 g of Compound 2-109. (Yield: 61%, MS: [M+H]⁺= 691)

### Synthesis Example 3-1

1-Bromo-7-chloronaphthalen-2-ol (15 g, 58.3 mmol) and (2-fluorophenyl)boronic acid (8.6 g, 61.2 mmol) were added to 300 ml of THF, and the mixture was stirred and refluxed. Then, potassium carbonate (24.2 g, 174.8 mmol) was dissolved in 72 ml of water and added thereto, and the mixture was sufficiently stirred and then bis(tri-tert-butylphosphine)palladium(0) (0.7 g, 0.6 mmol) was added. After the reaction for 6 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 12.4 g of Compound A_P1. (Yield: 78%, MS: [M+H]⁺= 273)

Compound A_P1 (15 g, 55 mmol) and potassium carbonate (22.8 g, 165 mmol) were added to 150 ml of DMAc, and the mixture was stirred and refluxed. After the reaction for 5 hours, the reaction mixture was cooled to room temperature, poured into 300 ml of water, solidified and filtered to obtain a solid. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 8.5 g of Compound A. (Yield: 61 %, MS: [M+H]⁺= 253)

Compound A (15 g, 59.4 mmol) and Compound amine3-1(30.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.6 g of Compound 3-1. (Yield: 70%, MS: [M+H]⁺= 664)

### Synthesis Example 3-2

Compound A (15 g, 59.4 mmol) and Compound amine3-2 (27.5 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.2 g of Compound 3-2. (Yield: 72%, MS: [M+H]⁺= 614)

### Synthesis Example 3-3

Compound A (15 g, 59.4 mmol) and Compound amine3-3 (25.9 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.4 g of Compound 3-3. (Yield: 67%, MS: [M+H]⁺= 588)

### Synthesis Example 3-4

Compound A (15 g, 59.4 mmol) and Compound amine3-4 (23.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.2 g of Compound 3-4. (Yield: 74%, MS: [M+H]⁺= 552)

### Synthesis Example 3-5

Compound A (15 g, 59.4 mmol) and Compound amine3-5 (32.3 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.6 g of Compound 3-5. (Yield: 65%, MS: [M+H]⁺= 690)

### Synthesis Example 3-6

Compound A (15 g, 59.4 mmol) and Compound amine3-6 (30.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 29.1 g of Compound 3-6. (Yield: 74%, MS: [M+H]⁺= 664)

### Synthesis Example 3-7

Compound A (15 g, 59.4 mmol) and Compound amine3-7 (33.7 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.9 g of Compound 3-7. (Yield: 66%, MS: [M+H]⁺= 714)

### Synthesis Example 3-8

Compound A (15 g, 59.4 mmol) and Compound amine3-8 (34 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 30.7 g of Compound 3-8. (Yield: 72%, MS: [M+H]⁺= 718)

### Synthesis Example 3-9

Trifluoromethanesulfonic anhydride (33.5 g, 118.7 mmol) and deuterium oxide (11.9 g, 593.6 mmol) were added at 0°C, and the mixture was stirred for 5 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating up to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.4 g of Compound subA-1. (Yield: 36%, MS: [M+H]⁺= 255)

Compound subA-1(15 g, 59.6 mmol) and Compound amine3-9 (30.7 g, 62.6 mmol) were added to 300 ml of **THF,** and the mixture was stirred and refluxed. Then, potassium carbonate (24.7 g, 178.8 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 28.9 g of Compound 3-9. (Yield: 73%, MS: [M+H]⁺= 666)

### Synthesis Example 3-10

Trifluoromethanesulfonic anhydride (67 g, 237.4 mmol) and deuterium oxide (23.8 g, 1187.2 mmol) were added at 0°C, and the mixture was stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating up to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.2 g of Compound subA-2. (Yield: 41%, MS: [M+H]⁺= 258)

Compound subA-2 (15 g, 58.9 mmol) and Compound amine3-10 (29 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.4 g of Compound 3-10. (Yield: 67%, MS: [M+H]⁺= 645)

### Synthesis Example 3-11

Compound subA-2 (15 g, 58.9 mmol and Compound amine3-11 (30.9 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.3 g of Compound 3-11. (Yield: 66%, MS: [M+H]⁺= 677)

### Synthesis Example 3-12

Trifluoromethanesulfonic anhydride (83.7 g, 296.8 mmol) and deuterium oxide (29.7 g, 1484 mmol) were added at 0°C, and the mixture was stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating up to 140°C and then keeping that temperature. After the reaction for 14 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.9 g of Compound subA-3. (Yield: 45%, MS: [M+H]⁺= 259)

Compound subA-3 (15 g, 58 mmol) and Compound amine3-12 (31.8 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.4 g of Compound 3-12. (Yield: 65%, MS: [M+H]⁺= 701)

### Synthesis Example 3-13

Compound subA-3 (15 g, 58 mmol) and Compound amine3-13 (23.4 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 21.5 g of Compound 3-13. (Yield: 66%, MS: [M+H]⁺= 563)

### Synthesis Example 3-14

Compound subA-3 (15 g, 58 mmol) and Compound amine3-14 (26 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.3 g of Compound 3-14. (Yield: 72%, MS: [M+H]⁺= 606)

### Synthesis Example 3-15

Trifluoromethanesulfonic anhydride (117.2 g, 415.5 mmol) and deuterium oxide (41.6 g, 2077.6 mmol) were added at 0°C, and the mixture was stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating up to 140°C and then keeping that temperature. After the reaction for 20 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.8 g of Compound subA-4. (Yield: 38%, MS: [M+H]⁺= 260)

Compound subA-4 (15 g, 57.8 mmol) and Compound amine3-15 (27 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.8 g of Compound 3-15. (Yield: 66%, MS: [M+H]⁺= 625)

### Synthesis Example 3-16

Compound subA-4 (15 g, 57.8 mmol) and Compound amine3-16 (32.4 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.8 g of Compound 3-16. (Yield: 65%, MS: [M+H]⁺= 714)

### Synthesis Example 3-17

Compound subA-4 (15 g, 57.8 mmol) and Compound amine3-17 (28.7 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.9 g of Compound 3-17. (Yield: 66%, MS: [M+H]⁺= 653)

### Synthesis Example 3-18

Trifluoromethanesulfonic anhydride (150.7 g, 534.2 mmol) and deuterium oxide (53.5 g, 2671.2 mmol) were added at 0°C, and the mixture was stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating up to 140°C and then keeping that temperature. After the reaction for 28 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound subA-5. (Yield: 42%, MS: [M+H]⁺= 262)

Compound subA-5 (15 g, 57.3 mmol) and Compound amine3-18 (32.9 g, 60.2 mmol) were added to 300 ml of THF, and the mixture was stirred and refluxed. Then, potassium carbonate (23.8 g, 171.9 mmol) was dissolved in 71 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 31.3 g of Compound 3-18. (Yield: 75%, MS: [M+H]⁺= 729)

### Synthesis Example 3-19

Compound subA-5 (15 g, 57.3 mmol) and Compound amine3-19 (36.6 g, 60.2 mmol) were added to 300 ml of THF, and the mixture was stirred and refluxed. Then, potassium carbonate (23.8 g, 171.9 mmol) was dissolved in 71 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 30.3 g of Compound 3-19. (Yield: 67%, MS: [M+H]⁺= 789)

### Synthesis Example 3-20

Compound 3-1 (10 g, 15.1 mmol), PtO₂ (1 g, 4.5 mmol) and D₂O (75 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.2 g of Compound 3-20. (Yield: 31%, MS: [M+H]⁺= 694)

### Synthesis Example 3-21

Compound 3-2 (10 g, 16.3 mmol), PtO₂ (1.1 g, 4.9 mmol) and D₂O (81 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4.7 g of Compound 3-21. (Yield: 45%, MS: [M+H]⁺= 641)

### Synthesis Example 3-22

Compound 3-3 (10 g, 17 mmol), PtO₂ (1.2 g, 5.1 mmol) and D₂O (85 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4.4 g of Compound 3-22. (Yield: 42%, MS: [M+H]⁺= 615)

### Synthesis Example 3-23

Compound A (15 g, 59.4 mmol) and Compound amine3-20 (28.4 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 24.6 g of Compound 3-23_P1. (Yield:66%, MS: [M+H]⁺= 628)

Compound 3-23_P1 (10 g, 15.9 mmol), PtO₂ (1.1 g, 4.8 mmol) and D₂O (80 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4.4 g of Compound 3-23. (Yield: 42%, MS: [M+H]⁺= 655)

### Synthesis Example 3-24

Compound A (15 g, 59.4 mmol) and Compound amine3-21 (35.4 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 28.5 g of Compound 3-24_P1. (Yield:65%, MS: [M+H]⁺= 740)

Compound 3-24_P1 (10 g, 13.5 mmol), PtO₂ (0.9 g, 4.1 mmol) and D₂O (68 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4.4 g of Compound 3-24. (Yield: 42%, MS: [M+H]⁺= 774)

### Synthesis Example 3-25

1-Bromo-6-chloronaphthalen-2-ol (15 g, 58.3 mmol) and (2-fluorophenyl)boronic acid (8.6 g, 61.2 mmol) were added to 300 ml of THF, and the mixture was stirred and refluxed. Then, potassium carbonate (24.2 g, 174.8 mmol) was dissolved in 72 ml of water and added thereto, and the mixture was sufficiently stirred, and then tetrakis(triphenylphosphine)palladium(0) (0.7 g, 0.6 mmol) was added. After the reaction for 6 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 10.5 g of Compound B_P1. (Yield:66%, MS: [M+H]⁺= 273)

Compound B_P1 (15 g, 55 mmol) and potassium carbonate (22.8 g, 165 mmol) were added to 150ml of DMAc, and the mixture was stirred and refluxed. After the reaction for 5 hours, the mixture was cooled to room temperature, and poured into 300 ml of water, solidified and filtered to obtain a solid. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 8.5 g of Compound B. (Yield: 65 %, MS: [M+H]⁺= 253)

Compound B (15 g, 59.4 mmol) and Compound amine3-22 (25.9 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.7 g of Compound 3-25. (Yield:68%, MS: [M+H]⁺= 588)

### Synthesis Example 3-26

Compound B (15 g, 59.4 mmol) and Compound amine3-23 (33.1 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.9 g of Compound 3-26. (Yield: 67%, MS: [M+H]⁺= 703)

### Synthesis Example 3-27

Compound B (15 g, 59.4 mmol) and Compound amine3-24 (25.9 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.4 g of Compound 3-27. (Yield: 73%, MS: [M+H]⁺= 588)

### Synthesis Example 3-28

Compound B (15 g, 59.4 mmol) and Compound amine3-25 (24.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.9 g of Compound 3-28. (Yield: 68%, MS: [M+H]⁺= 568)

### Synthesis Example 3-29

Compound B (15 g, 59.4 mmol) and Compound amine3-26 (30.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.4 g of Compound 3-29. (Yield: 67%, MS: [M+H]⁺= 664)

### Synthesis Example 3-30

Compound B (15 g, 59.4 mmol) and Compound amine3-27 (33.7 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 29.6 g of Compound 3-30. (Yield: 70%, MS: [M+H]⁺= 714)

### Synthesis Example 3-31

Compound B (15 g, 59.4 mmol) and Compound amine3-28 (33.1 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.5 g of Compound 3-31. (Yield: 66%, MS: [M+H]⁺= 703)

### Synthesis Example 3-32

Compound B (15 g, 59.4 mmol) and Compound amine3-29 (31.3 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26 g of Compound 3-32. (Yield: 65%, MS: [M+H]⁺= 675)

### Synthesis Example 3-33

Trifluoromethanesulfonic anhydride (33.5 g, 118.7 mmol) and deuterium oxide (11.9 g, 593.6 mmol) were added at 0°C, and the mixture was stirred for 5 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating up to 140°C and then keeping that temperature. After the reaction for 4 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound subB-1. (Yield: 43%, MS: [M+H]⁺= 255)

Compound subB-1 (15 g, 58.9 mmol) and Compound amine3-30 (30.4 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.8 g of Compound 3-33. (Yield: 71%, MS: [M+H]⁺= 666)

### Synthesis Example 3-34

Compound subB-1 (15 g, 58.9 mmol) and Compound amine3-31 (35.6 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 33.1 g of Compound 3-34. (Yield:75%, MS: [M+H]⁺= 750)

### Synthesis Example 3-35

Trifluoromethanesulfonic anhydride (50.2 g, 178.1 mmol) and deuterium oxide (17.8 g, 890.4 mmol) were added at 0°C, and the mixture was stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating up to 140°C and then keeping that temperature. After the reaction for 7 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.7 g of Compound subB-2. (Yield: 44%, MS: [M+H]⁺= 256)

Compound subB-2 (15 g, 58.7 mmol) and Compound amine3-32 (25.9 g, 61.6 mmol) were added to 300 ml of THF, and the mixture was stirred and refluxed. Then, potassium carbonate (24.3 g, 176 mmol) was dissolved in 73 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.2 g of Compound 3-35. (Yield: 75%, MS: [M+H]⁺= 596)

### Synthesis Example 3-36

Compound subB-2 (15 g, 58.7 mmol) and Compound amine3-33 (30.6 g, 61.6 mmol) were added to 300 ml of THF, and the mixture was stirred and refluxed. Then, potassium carbonate (24.3 g, 176 mmol) was dissolved in 73 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.6 g of Compound 3-36. (Yield: 70%, MS: [M+H]⁺= 672)

### Synthesis Example 3-37

Trifluoromethanesulfonic anhydride (67 g, 237.4 mmol) and deuterium oxide (23.8 g, 1187.2 mmol) were added at 0°C, and the mixture was stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound B and 1,2,4-trichlorobenzene, and the mixture was stirred while heating up to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.9 g of Compound subB-3. (Yield: 39%, MS: [M+H]⁺= 258)

Compound subB-3 (15 g, 58.4 mmol) and Compound amine3-34 (33.9 g, 61.4 mmol) were added to 300 ml of THF, and the mixture was stirred and refluxed. Then, potassium carbonate (24.2 g, 175.3 mmol) was dissolved in 73 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 30.6 g of Compound 3-37. (Yield: 72%, MS: [M+H]⁺= 729)

### Synthesis Example 3-38

Trifluoromethanesulfonic anhydride (100.5 g, 356.2 mmol) and deuterium oxide (35.7 g, 1780.8 mmol) were added at 0°C, and the mixture was stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound B and 1,2,4-trichlorobenzene, and the mixture was stirred while heating up to 140°C and then keeping that temperature. After the reaction for 17 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.4 g of Compound subB-4. (Yield: 35%, MS: [M+H]⁺= 259)

Compound subB-4 (15 g, 58 mmol) and Compound amine3-35 (25.8 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.7 g of Compound 3-38. (Yield:65%, MS: [M+H]⁺= 603)

### Synthesis Example 3-39

Trifluoromethanesulfonic anhydride (117.2 g, 415.5 mmol) and deuterium oxide (41.6 g, 2077.6 mmol) were added at 0°C, and the mixture was stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound B and 1,2,4-trichlorobenzene, and the mixture was stirred while heating up to 140°C and then keeping that temperature. After the reaction for 21 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.7 g of Compound subB-5. (Yield: 37%, MS: [M+H]⁺= 260)

Compound subB-5 (15 g, 57.8 mmol) and Compound amine3-36 (22.5 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.2 g of Compound 3-39. (Yield: 70%, MS: [M+H]⁺= 550)

### Synthesis Example 3-40

Compound subB-5(15 g, 57.8 mmol) and Compound amine3-37(34.4 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 30.2 g of Compound 3-40. (Yield: 70%, MS: [M+H]⁺= 747)

### Synthesis Example 3-41

Trifluoromethanesulfonic anhydride (134 g, 474.9 mmol) and deuterium oxide (47.6 g, 2374.4 mmol) were added at 0°C, and the mixture was stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound B and 1,2,4-trichlorobenzene, and the mixture was stirred while heating up to 140°C and then keeping that temperature. After the reaction for 25 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.6 g of Compound subB-6. (Yield: 43%, MS: [M+H]⁺= 261)

Compound subB-6 (15 g, 57.5 mmol) and Compound amine3-38 (24.1 g, 60.4 mmol) were added to 300 ml of THF, and the mixture was stirred and refluxed. Then, potassium carbonate (23.9 g, 172.6 mmol) was dissolved in 72 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 22.3 g of Compound 3-41. (Yield: 67%, MS: [M+H]⁺= 579)

### Synthesis Example 3-42

Compound subB-6 (15 g, 57.5 mmol) and Compound amine3-39 (33.3 g, 60.4 mmol) were added to 300 ml of THF, and the mixture was stirred and refluxed. Then, potassium carbonate (23.9 g, 172.6 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 30.3 g of Compound 3-42. (Yield: 72%, MS: [M+H]⁺= 732)

### Synthesis Example 3-43

Compound subB-6 (15 g, 57.5 mmol) and Compound amine3-40 (30.3 g, 60.4 mmol) were added to 300 ml of THF, and the mixture was stirred and refluxed. Then, potassium carbonate (23.9 g, 172.6 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.7 g of Compound 3-43. (Yield:68%, MS: [M+H]⁺= 684)

### Synthesis Example 3-44

Compound B (15 g, 59.4 mmol) and Compound amine3-41 (35.4 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 32.5 g of Compound 3-44_P1. (Yield: 74%, MS: [M+H]⁺= 740)

Compound 3-44_P1 (10 g, 13.5 mmol), PtO₂ (0.9 g, 4.1 mmol) and D₂O (68 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4.6 g of Compound 3-44. (Yield: 44%, MS: [M+H]⁺= 772)

### Synthesis Example 3-45

Compound 3-26 (10 g, 14.2 mmol), PtO₂ (1 g, 4.3 mmol) and D₂O (71 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.4 g of Compound 3-45. (Yield: 33%, MS: [M+H]⁺= 734)

### Synthesis Example 3-46

Compound B (15 g, 59.4 mmol) and Compound amine3-42 (29.3 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 27.8 g of Compound 3-46_P1. (Yield: 73%, MS: [M+H]⁺= 642)

Compound 3-46_P1 (10 g, 15.6 mmol), PtO₂ (1.1 g, 4.7 mmol) and D₂O (78 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 3.2 g of Compound 3-46. (Yield: 31%, MS: [M+H]⁺= 666)

### Synthesis Example 3-47

Compound B (15 g, 59.4 mmol) and Compound amine3-43 (30 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 26.4 g of Compound 3-47_P1. (Yield:68%, MS: [M+H]⁺= 654)

Compound 3-47_P1 (10 g, 15.3 mmol), PtO₂ (1 g, 4.6 mmol) and D₂O (76 ml) were added to a shaker tube, and then the tuber was sealed and heated at 250 °C and 600 psi for 12 hours. When the reaction was completed, chloroform was added, and the reaction solution was transferred to a separatory funnel, and extracted. The extract was dried over MgSO₄ and concentrated, and then the sample was purified by silica gel column chromatography to prepare 4.6 g of Compound 3-47. (Yield: 44%, MS: [M+H]⁺= 684)

### Synthesis Example 3-48

Compound C (15 g, 59.4 mmol), Compound amine3-44 (20.5 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 4 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 21.3 g of Compound 3-48. (Yield: 64%, MS: [M+H]⁺= 562)

### Synthesis Example 3-49

Compound C (15 g, 59.4 mmol), Compound amine3-45 (28.7 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 5 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 26.1 g of Compound 3-49. (Yield: 63%, MS: [M+H]⁺= 700)

### Synthesis Example 3-50

Compound C (15 g, 59.4 mmol), Compound amine3-46 (25.4 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 28.3 g of Compound 3-50. (Yield: 74%, MS: [M+H]⁺= 644)

### Synthesis Example 3-51

Compound C (15 g, 59.4 mmol) and Compound amine3-47 (27.9 g, 62.3 mmol) were added to 300 ml of THF, and the mixture was stirred and refluxed. Then, potassium carbonate (24.6 g, 178.1 mmol) was dissolved in 100 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 19.5 g of Compound 3-51. (Yield: 61%, MS: [M+H]⁺= 538)

### Synthesis Example 3-52

Compound D (15 g, 59.4 mmol), Compound amine3-48 (19.1 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 21.7 g of Compound 3-52. (Yield: 68%, MS: [M+H]⁺= 538)

### Synthesis Example 3-53

Compound D (15 g, 59.4 mmol), Compound amine3-49 (21.7 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 25.2 g of Compound 3-53. (Yield: 73%, MS: [M+H]⁺= 582)

### Synthesis Example 3-54

Compound D (15 g, 59.4 mmol) and Compound amine3-50 (35.7 g, 62.3 mmol) were added to 300 ml of THF, and the mixture was stirred and refluxed. Then, potassium carbonate (24.6 g, 178.1 mmol) was dissolved in 100 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 28.3 g of Compound 3-54. (Yield:72%, MS: [M+H]⁺= 664)

### Synthesis Example 3-55

Compound D (15 g, 59.4 mmol) and Compound amine3-51 (37.4 g, 62.3 mmol) were added to 300 ml of THF, and the mixture was stirred and refluxed. Then, potassium carbonate (24.6 g, 178.1 mmol) was dissolved in 100 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 28.2 g of Compound 3-55. (Yield: 69%, MS: [M+H]⁺= 690)

### Synthesis Example 3-56

Compound E (15 g, 59.4 mmol), Compound amine3-52 (26 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 4 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 25.6 g of Compound 3-56. (Yield: 66%, MS: [M+H]⁺= 654)

### Synthesis Example 3-57

Compound E (15 g, 59.4 mmol), Compound amine3-53 (19.9 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 23.6 g of Compound 3-57. (Yield: 72%, MS: [M+H]⁺= 552)

### Synthesis Example 3-58

Compound E (15 g, 59.4 mmol) and Compound amine3-54 (34.1 g, 62.3 mmol) were added to 300 ml of THF, and the mixture was stirred and refluxed. Then, potassium carbonate (24.6 g, 178.1 mmol) was dissolved in 100 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.5 g of Compound 3-58. (Yield: 62%, MS: [M+H]⁺= 638)

### Synthesis Example 3-59

Compound E (15 g, 59.4 mmol) and Compound amine3-55 (32.6 g, 62.3 mmol) were added to 300 ml of THF, and the mixture was stirred and refluxed. Then, potassium carbonate (24.6 g, 178.1 mmol) was dissolved in 100 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 25.8 g of Compound 3-59. (Yield: 71%, MS: [M+H]⁺= 614)

### Synthesis Example 3-60

Compound F (15 g, 59.4 mmol), Compound amine3-56 (23.6 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 5 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 24.8 g of Compound 3-60. (Yield: 68%, MS: [M+H]⁺= 614)

### Synthesis Example 3-61

Compound F (15 g, 59.4 mmol), Compound amine3-57 (21.5 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 5 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 21.9 g of Compound 3-61. (Yield: 64%, MS: [M+H]⁺= 578)

### Synthesis Example 3-62

Compound F (15 g, 59.4 mmol), Compound amine3-58(20.7 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 23.8 g of Compound 3-62. (Yield: 71%, MS: [M+H]⁺= 566)

### Synthesis Example 3-63

Compound F (15 g, 59.4 mmol) and Compound amine3-59 (34.5 g, 62.3 mmol) were added to 300 ml of THF, and the mixture was stirred and refluxed. Then, potassium carbonate (24.6 g, 178.1 mmol) was dissolved in 100 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 23.7 g of Compound 3-63. (Yield: 62%, MS: [M+H]⁺= 644)

### Synthesis Example 3-64

Compound G (15 g, 59.4 mmol), Compound amine3-60(22.1 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 24.4 g of Compound 3-64. (Yield: 70%, MS: [M+H]⁺= 588)

### Synthesis Example 3-65

Compound G (15 g, 59.4 mmol), Compound amine3-61 (24.4 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 24.9 g of Compound 3-65. (Yield: 67%, MS: [M+H]⁺= 627)

### Synthesis Example 3-66

Compound G (15 g, 59.4 mmol), Compound amine3-62 (21.5 g, 59.4 mmol) and sodium tert-butoxide (8.6 g, 89 mmol) were added to 300 ml of xylene under a nitrogen atmosphere, and the mixture was stirred and refluxed. Then, bis(tri-tert-butylphosphine)palladium(0) (0.3 g, 0.6 mmol) was added thereto. When the reaction was completed after 5 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by a silica gel column chromatography to prepare 24.3 g of Compound 3-66. (Yield: 71%, MS: [M+H]⁺= 578)

### Synthesis Example 3-67

Compound G (15 g, 59.4 mmol) and Compound amine3-63 (34.5 g, 62.3 mmol) were added to 300 ml of THF, and the mixture was stirred and refluxed. Then, potassium carbonate (24.6 g, 178.1 mmol) was dissolved in 100 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and then the organic layer and the aqueous layer were separated, and the organic layer was distilled. This was again dissolved in chloroform, washed twice with water, and then the organic layer was separated, anhydrous magnesium sulfate was added, stirred, then filtered, and the filtrate was distilled under reduced pressure. The concentrated compound was purified by a silica gel column chromatography to prepare 29.4 g of Compound 3-67. (Yield: 77%, MS: [M+H]⁺= 644)

### Example 1-1: Manufacture of organic light emitting device

A glass substrate on which a thin film of ITO (indium tin oxide) was coated in a thickness of 1000 Å was put into distilled water containing the detergent dissolved therein and washed by the ultrasonic wave. In this case, the used detergent was a product commercially available from Fisher Co. and the distilled water was one which had been twice filtered by using a filter commercially available from Millipore Co. The ITO was cleaned for 30 minutes, and ultrasonic cleaning was then repeated twice for 10 minutes by using distilled water. After the cleaning with distilled water was completed, the substrate was ultrasonically washed with the solvents of isopropyl alcohol, acetone, and methanol, and dried, after which it was transported to a plasma cleaner. Then, the substrate was cleaned with oxygen plasma for 5 minutes, and then transferred to a vacuum evaporator.

On the ITO transparent electrode thus prepared, the following compound HI-1 was formed to a thickness of 1150Â as a hole injection layer, wherein the following compound A-1was p-doped at a concentration of 1.5 wt.%. The following compound HT-1 was vacuum deposited on the hole injection layer to form a hole transport layer with a layer thickness of 800Å. Then, the following compound EB-1 was vacuum deposited on the hole transport layer to a layer thickness of 150 Å to form an electron blocking layer.

Then, a host in which Compound 1-1 as a first host, Compound 2-5 as a second host and Compound 3-1 as a third host were mixed at a weight ratio of 40:40:20, and a dopant material Dp-7 was vacuum deposited at a weight ratio of 98:2 on the EB-1 deposited layer to form a red light emitting layer with a thickness of 400Å.

The following compound HB-1 was vacuum deposited on the light emitting layer to a layer thickness of 30 Å to form a hole blocking layer. Then, the following compound ET-1 and the following compound LiQ were vacuum deposited at a weight ratio of 2:1 on the hole blocking layer to form an electron injection and transport layer with a layer thickness of 300Å. Lithium fluoride (LiF) and aluminum were sequentially deposited to have a thickness of 12Â and 1,000Å, respectively, on the electron injection and transport layer, thereby forming a cathode.

In the above-mentioned processes, the deposition rates of the organic materials were maintained at 0.4-0.7 Å/sec, the deposition rates of lithium fluoride and aluminum of the cathode were maintained at 0.3 Å/sec and 2 Å/sec, respectively, and the degree of vacuum during the deposition was maintained at 2x10⁻⁷ ~ 5x10⁻⁶ torr, thereby manufacturing an organic light emitting device.

### Examples 1-2 to 1-107

The organic light emitting devices of Examples 1-2 to 1-107 were respectively manufactured in the same manner as in Example 1-1, except that the host materials were changed as shown in Table 1 to Table 6 below. In this case, the ratio means a weight ratio of the first host, the second host, and the third host.

### Examples 2-1 to 2-107

The organic light emitting devices of Examples 2-1 to 2-107 were respectively manufactured in the same manner as in Example 1-1, except that the host materials were changed as shown in Table 7 to Table 12 below, the first host and the third host used the same materials among the materials synthesized in Chemical Formula 1, and the second host and the fourth host were used as shown in Tables. In this case, the ratio means a weight ratio of the first host, the second host, the third host, and the fourth host.

### Examples 3-1 to 3-107

The organic light emitting devices of Examples 3-1 to 3-107 were respectively manufactured in the same manner as in Example 1-1, except that the host materials were changed as shown in Table 13 to Table 18 below, the first host and the third host used mutually different materials among the materials synthesized in Chemical Formula 1, and the second host and the fourth host were used as shown in Tables. In this case, the ratio means a weight ratio of the first host, the second host, the third host, and the fourth host.

### Comparative Examples 1 to 11

The organic light emitting devices of Comparative Examples 1 to 11were respectively manufactured in the same manner as in Example 1-1, except that the host was used as shown Table 19 below. In this case, the ratio means a weight ratio of the first host, the second host, and the third host.

### Experimental Example 1: Evaluation of device characteristics

The voltage, efficiency (based on 10mA/cm²) and lifetime (based on 20mA/cm²) were measured by applying a current to the organic light emitting devices manufactured in Example 1-1 to Example 1-107, and the results are shown in Tables 1 to 6 below. Here, lifetime T95 means the time required for the luminance to be reduced to 95% of the initial luminance (5,000 nit).

**[Table 1]**

| | First host | Second host | Third host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 1-1 | Compoun d 1-1 | Compound 2-5 | Compound 3-1 | 40:40:20 | 3.51 | 23.3 | 188 |
| Example 1-2 | | Compound 2-14 | Compound 3-3 | 40:40:20 | 3.48 | 23.2 | 189 |
| Example 1-3 | | Compound 2-36 | Compound 3-5 | 40:40:20 | 3.33 | 23.1 | 188 |
| Example 1-4 | Compoun d 1-2 | Compound 2-45 | Compound 3-6 | 40:40:20 | 3.47 | 22.8 | 187 |
| Example 1-5 | | Compound 2-61 | Compound 3-7 | 40:40:20 | 3.61 | 22.9 | 179 |
| Example 1-6 | | Compound 2-78 | Compound 3-8 | 40:40:20 | 3.50 | 23.6 | 188 |
| Example 1-7 | Compoun d 1-4 | Compound 2-85 | Compound 3-9 | 20:60:20 | 3.33 | 23.4 | 189 |
| Example 1-8 | | Compound 2-93 | Compound 3-11 | 20:60:20 | 3.64 | 23.9 | 192 |
| Example 1-9 | | Compound 2-102 | Compound 3-15 | 20:60:20 | 3.51 | 24.1 | 195 |
| Example 1-10 | Compoun d 1-6 | Compound 2-105 | Compound 3-20 | 40:40:20 | 3.38 | 23.9 | 183 |
| Example 1-11 | | Compound 2-109 | Compound 3-26 | 40:40:20 | 3.41 | 24.6 | 196 |
| Example 1-12 | | Compound 2-1 | Compound 3-32 | 40:40:20 | 3.44 | 24.9 | 180 |
| Example 1-13 | Compoun d 1-8 | Compound 2-4 | Compound 3-34 | 40:40:20 | 3.54 | 24.0 | 196 |
| Example 1-14 | | Compound 2-8 | Compound 3-40 | 40:40:20 | 3.60 | 23.9 | 190 |
| Example 1-15 | | Compound 2-12 | Compound 3-41 | 40:40:20 | 3.33 | 23.3 | 177 |
| Example 1-16 | Compoun d 1-11 | Compound 2-18 | Compound 3-43 | 40:40:20 | 3.45 | 23.5 | 186 |
| Example 1-17 | | Compound 2-21 | Compound 3-46 | 40:40:20 | 3.54 | 23.6 | 184 |
| Example 1-18 | | Compound 2-23 | Compound 3-49 | 40:40:20 | 3.50 | 24.1 | 185 |
| Example 1-19 | Compoun d 1-13 | Compound 2-26 | Compound 3-50 | 40:40:20 | 3.51 | 24.0 | 184 |
| Example 1-20 | | Compound 2-33 | Compound 3-51 | 40:40:20 | 3.49 | 24.6 | 179 |
| Example 1-21 | | Compound 2-42 | Compound 3-52 | 40:40:20 | 3.38 | 24.1 | 191 |

**[Table 2]**

| | First host | Second host | Third host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 1-22 | Compoun d 1-15 | Compound 2-44 | Compound 3-53 | 40:40:20 | 3.56 | 24.5 | 190 |
| Example 1-23 | | Compound 2-30 | Compound 3-56 | 40:40:20 | 3.57 | 24.1 | 195 |
| Example 1-24 | Compoun d 1-16 | Compound 2-38 | Compound 3-57 | 40:40:20 | 3.49 | 24.0 | 193 |
| Example 1-25 | | Compound 2-49 | Compound 3-58 | 40:40:20 | 3.44 | 24.6 | 190 |
| Example 1-26 | | Compound 2-52 | Compound 3-60 | 40:40:20 | 3.56 | 24.8 | 186 |
| Example 1-27 | Compoun d 1-18 | Compound 2-55 | Compound 3-62 | 40:40:20 | 3.55 | 23.2 | 189 |
| Example 1-28 | | Compound 2-58 | Compound 3-64 | 40:40:20 | 3.48 | 22.9 | 193 |
| Example 1-29 | | Compound 2-41 | Compound 3-65 | 40:40:20 | 3.49 | 23.6 | 198 |
| Example 1-30 | Compoun d 1-19 | Compound 2-47 | Compound 3-66 | 40:40:20 | 3.60 | 23.3 | 197 |
| Example 1-31 | | Compound 2-50 | Compound 3-67 | 40:40:20 | 3.57 | 23.1 | 183 |
| Example 1-32 | | Compound 2-74 | Compound 3-2 | 40:40:20 | 3.51 | 23.8 | 187 |
| Example 1-33 | Compoun d 1-21 | Compound 2-88 | Compound 3-3 | 40:40:20 | 3.50 | 24.1 | 185 |
| Example 1-34 | | Compound 2-17 | Compound 3-4 | 40:40:20 | 3.50 | 23.9 | 180 |
| Example 1-35 | | Compound 2-81 | Compound 3-13 | 40:40:20 | 3.33 | 23.3 | 188 |
| Example 1-36 | Compoun d 1-23 | Compound 2-66 | Compound 3-16 | 40:40:20 | 3.54 | 24.1 | 178 |
| Example 1-37 | | Compound 2-60 | Compound 3-17 | 40:40:20 | 3.48 | 23.6 | 179 |
| Example 1-38 | | Compound 2-63 | Compound 3-18 | 40:40:20 | 3.36 | 23.5 | 180 |

**[Table 3]**

| | First host | Second host | Third host | Ratio | @10 mA/cm2 | | @20 mA/cm² |
|---|---|---|---|---|---|---|---|
| | | | | | Volta ge (V) | Effici ency (cd/A ) | Lifetime (T95, hr) |
| Example 1-39 | Compoun d 1-24 | Compound 2-29 | Compound 3-19 | 40:40:20 | 3.56 | 23.6 | 189 |
| Example 1-40 | | Compound 2-32 | Compound 3-21 | 40:40:20 | 3.54 | 24.5 | 191 |
| Example 1-41 | Compoun d 1-26 | Compound 2-14 | Compound 3-3 | 40:40:20 | 3.33 | 25.1 | 201 |
| Example 1-42 | | Compound 2-14 | Compound 3-14 | 40:40:20 | 3.34 | 25.0 | 199 |
| Example 1-43 | | Compound 2-71 | Compound 3-22 | 40:40:20 | 3.40 | 25.6 | 198 |
| Example 1-44 | Compoun d 1-27 | Compound 2-14 | Compound 3-3 | 40:40:20 | 3.38 | 25.0 | 199 |
| Example 1-45 | Compoun d 1-27 | Compound 2-69 | Compound 3-10 | 40:40:20 | 3.37 | 25.5 | 205 |
| Example 1-46 | | Compound 2-14 | Compound 3-14 | 40:40:20 | 3.39 | 24.9 | 203 |
| Example 1-47 | Compoun d 1-30 | Compound 2-73 | Compound 3-23 | 40:40:20 | 3.51 | 23.4 | 188 |
| Example 1-48 | | Compound 2-91 | Compound 3-24 | 40:40:20 | 3.45 | 24.0 | 187 |
| Example 1-49 | | Compound 2-97 | Compound 3-25 | 40:40:20 | 3.39 | 23.5 | 186 |
| Example 1-50 | Compoun d 1-32 | Compound 2-14 | Compound 3-3 | 40:40:20 | 3.37 | 24.6 | 195 |
| Example 1-51 | | Compound 2-14 | Compound 3-14 | 40:40:20 | 3.40 | 25.5 | 198 |
| Example 1-52 | | Compound 2-67 | Compound 3-63 | 40:40:20 | 3.37 | 26.1 | 200 |
| Example 1-53 | Compoun d 1-34 | Compound 2-14 | Compound 3-3 | 40:40:20 | 3.34 | 25.4 | 201 |
| Example 1-54 | | Compound 2-14 | Compound 3-14 | 40:40:20 | 3.33 | 25.1 | 205 |
| Example 1-55 | | Compound 2-56 | Compound 3-15 | 40:40:20 | 3.41 | 25.0 | 203 |

**[Table 4]**

| | First host | Second host | Third host | Ratio | @10 mA/cm² | | @20 mA/cm2 |
|---|---|---|---|---|---|---|---|
| | | | | | Volta ge (V) | Effici ency (cd/A ) | Lifetime (T95, hr) |
| Example 1-56 | Compoun d 1-35 | Compound 2-14 | Compound 3-3 | 40:40:20 | 3.41 | 25.9 | 199 |
| Example 1-57 | | Compound 2-14 | Compound 3-14 | 40:40:20 | 3.45 | 25.2 | 203 |
| Example 1-58 | Compoun d 1-36 | Compound 2-14 | Compound 3-3 | 40:40:20 | 3.33 | 25.0 | 204 |
| Example 1-59 | | Compound 2-14 | Compound 3-14 | 40:40:20 | 3.37 | 25.4 | 205 |
| Example 1-60 | | Compound 2-10 | Compound 3-33 | 40:40:20 | 3.40 | 25.6 | 201 |
| Example 1-61 | Compoun d 1-40 | Compound 2-2 | Compound 3-27 | 40:40:20 | 3.35 | 24.9 | 205 |
| Example 1-62 | | Compound 2-9 | Compound 3-28 | 40:40:20 | 3.60 | 24.3 | 191 |
| Example 1-63 | | Compound 2-54 | Compound 3-29 | 40:40:20 | 3.54 | 24.8 | 194 |
| Example 1-64 | Compoun d 1-41 | Compound 2-3 | Compound 3-30 | 40:40:20 | 3.50 | 23.9 | 189 |
| Example 1-65 | | Compound 2-6 | Compound 3-31 | 40:40:20 | 3.54 | 24.0 | 199 |
| Example 1-66 | | Compound 2-20 | Compound 3-35 | 40:40:20 | 3.33 | 24.3 | 187 |
| Example 1-67 | Compoun d 1-44 | Compound 2-7 | Compound 3-36 | 40:40:20 | 3.54 | 24.1 | 182 |
| Example 1-68 | | Compound 2-11 | Compound 3-37 | 40:40:20 | 3.45 | 24.5 | 183 |
| Example 1-69 | | Compound 2-22 | Compound 3-38 | 40:40:20 | 3.46 | 24.3 | 188 |
| Example 1-70 | Compoun d 1-46 | Compound 2-15 | Compound 3-39 | 40:40:20 | 3.57 | 24.9 | 185 |
| Example 1-71 | | Compound 2-16 | Compound 3-42 | 40:40:20 | 3.39 | 23.8 | 187 |
| Example 1-72 | | Compound 2-19 | Compound 3-44 | 40:40:20 | 3.31 | 23.9 | 189 |

**[Table 5]**

| | First host | Second host | Third host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 1-73 | Compoun d 1-49 | Compound 2-24 | Compound 3-45 | 40:40:20 | 3.48 | 24.5 | 190 |
| Example 1-74 | | Compound 2-25 | Compound 3-47 | 40:40:20 | 3.38 | 24.1 | 184 |
| Example 1-75 | Compoun d 1-50 | Compound 2-27 | Compound 3-48 | 40:40:20 | 3.40 | 24.5 | 188 |
| Example 1-76 | | Compound 2-31 | Compound 3-55 | 40:40:20 | 3.55 | 24.3 | 191 |
| Example 1-77 | | Compound 2-39 | Compound 3-59 | 40:40:20 | 3.44 | 23.9 | 190 |
| Example 1-78 | Compoun d 1-52 | Compound 2-13 | Compound 3-61 | 40:40:20 | 3.58 | 23.3 | 191 |
| Example 1-79 | | Compound 2-28 | Compound 3-1 | 40:40:20 | 3.57 | 23.8 | 195 |
| Example 1-80 | | Compound 2-34 | Compound 3-3 | 40:40:20 | 3.39 | 24.0 | 194 |
| Example 1-81 | Compoun d 1-54 | Compound 2-14 | Compound 3-3 | 40:40:20 | 3.40 | 25.1 | 199 |
| Example 1-82 | | Compound 2-14 | Compound 3-12 | 40:40:20 | 3.44 | 25.6 | 198 |
| Example 1-83 | | Compound 2-14 | Compound 3-14 | 40:40:20 | 3.41 | 25.5 | 203 |
| Example 1-84 | Compoun d 1-58 | Compound 2-40 | Compound 3-6 | 40:40:20 | 3.45 | 24.6 | 194 |
| Example 1-85 | | Compound 2-43 | Compound 3-10 | 40:40:20 | 3.43 | 24.9 | 186 |
| Example 1-86 | | Compound 2-46 | Compound 3-15 | 40:40:20 | 3.49 | 24.7 | 188 |
| Example 1-87 | Compoun d 1-60 | Compound 2-14 | Compound 3-3 | 40:40:20 | 3.38 | 25.3 | 192 |
| Example 1-88 | | Compound 2-14 | Compound 3-14 | 40:40:20 | 3.41 | 25.0 | 199 |
| Example 1-89 | | Compound 2-70 | Compound 3-54 | 40:40:20 | 3.34 | 25.9 | 204 |

**[Table 6]**

| | First host | Second host | Third host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 1-90 | Compound 1-61 | Compound 2-64 | Compound 3-21 | 40:40:20 | 3.51 | 24.8 | 201 |
| Example 1-91 | | Compound 2-68 | Compound 3-28 | 40:40:20 | 3.48 | 24.5 | 189 |
| Example 1-92 | Compound 1-63 | Compound 2-72 | Compound 3-32 | 40:40:20 | 3.50 | 24.4 | 191 |
| 92 Example 1-93 | | Compound 2-77 | Compound 3-33 | 40:40:20 | 3.48 | 24.3 | 193 |
| Example 1-94 | | Compound 2-80 | Compound 3-28 | 40:40:20 | 3.47 | 25.0 | 184 |
| Example 1-95 | Compound 1-64 | Compound 2-82 | Compound 3-40 | 40:40:20 | 3.46 | 24.8 | 185 |
| 95 Example 1-96 | | Compound 2-86 | Compound 3-48 | 40:40:20 | 3.44 | 24.4 | 184 |
| Example 1-97 | | Compound 2-95 | Compound 3-51 | 40:40:20 | 3.39 | 25.1 | 181 |
| Example 1-98 | Compound 1-65 | Compound 2-99 | Compound 3-55 | 40:40:20 | 3.40 | 24.5 | 192 |
| Example 1-99 | | Compound 2-100 | Compound 3-56 | 40:40:20 | 3.54 | 24.9 | 194 |
| Example 1-101 | | Compound 2-103 | Compound 3-58 | 40:40:20 | 3.51 | 24.8 | 191 |
| Example 1-102 | Compound 1-66 | Compound 2-14 | Compound 3-3 | 40:40:20 | 3.41 | 25.3 | 199 |
| Example 1-103 | | Compound 2-14 | Compound 3-14 | 40:40:20 | 3.33 | 25.4 | 203 |
| Example 1-104 | | Compound 2-104 | Compound 3-50 | 40:40:20 | 3.38 | 25.9 | 200 |
| Example 1-105 | Compound 1-68 | Compound 2-14 | Compound 3-3 | 40:40:20 | 3.39 | 25.2 | 201 |
| Example 1-106 | | Compound 2-14 | Compound 3-14 | 40:40:20 | 3.40 | 25.1 | 200 |
| Example 1-107 | | Compound 2-107 | Compound 3-61 | 40:40:20 | 3.36 | 25.6 | 205 |

### Experimental Example 2: Evaluation of device characteristics

The voltage, efficiency (based on 10mA/cm²) and lifetime (based on 20mA/cm²) were measured by applying a current to the organic light emitting devices manufactured in Example 2-1 to Example 2-107, and the results are shown in Tables 7 to 12 below. Here, lifetime T95 means the time required for the luminance to be reduced to 95% of the initial luminance (5,000 nit).

**[Table 7]**

| | First, third host | Second host | Fourth host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 2-1 | Compoun d 1-1 | Compound 2-5 | Compound 3-1 | 25:25:25:2 5 | 3.50 | 23.1 | 188 |
| Example 2-2 | | Compound 2-14 | Compound 3-3 | 25:25:25:2 5 | 3.49 | 23.2 | 189 |
| Example 2-3 | | Compound 2-36 | Compound 3-5 | 25:25:25:2 5 | 3.35 | 23.0 | 188 |
| Example 2-4 | Compoun d 1-2 | Compound 2-45 | Compound 3-6 | 25:25:25:2 5 | 3.48 | 22.8 | 187 |
| Example 2-5 | | Compound 2-61 | Compound 3-7 | 25:25:25:2 5 | 3.60 | 22.9 | 179 |
| Example 2-6 | | Compound 2-78 | Compound 3-8 | 25:25:25:2 5 | 3.51 | 23.6 | 188 |
| Example 2-7 | Compoun d 1-4 | Compound 2-85 | Compound 3-9 | 25:25:25:2 5 | 3.30 | 23.9 | 189 |
| Example 2-8 | | Compound 2-93 | Compound 3-11 | 25:25:25:2 5 | 3.60 | 23.8 | 192 |
| Example 2-9 | | Compound 2-102 | Compound 3-15 | 25:25:25:2 5 | 3.50 | 24.4 | 195 |
| Example 2-10 | Compoun d 1-6 | Compound 2-105 | Compound 3-20 | 25:25:25:2 5 | 3.39 | 23.5 | 183 |
| Example 2-11 | | Compound 2-109 | Compound 3-26 | 25:25:25:2 5 | 3.40 | 24.6 | 196 |
| Example 2-12 | | Compound 2-1 | Compound 3-32 | 25:25:25:2 5 | 3.42 | 24.8 | 180 |
| Example 2-13 | Compoun d 1-8 | Compound 2-4 | Compound 3-34 | 25:25:25:2 5 | 3.54 | 24.9 | 196 |
| Example 2-14 | | Compound 2-8 | Compound 3-40 | 25:25:25:2 5 | 3.59 | 23.2 | 190 |
| Example 2-15 | | Compound 2-12 | Compound 3-41 | 25:25:25:2 5 | 3.36 | 23.6 | 177 |
| Example 2-16 | Compoun d 1-11 | Compound 2-18 | Compound 3-43 | 25:25:25:2 5 | 3.41 | 23.3 | 186 |
| Example 2-17 | Compoun d 1-11 | Compound 2-21 | Compound 3-46 | 25:25:25:2 5 | 3.53 | 23.8 | 184 |
| Example 2-18 | | Compound 2-23 | Compound 3-49 | 25:25:25:2 5 | 3.51 | 24.6 | 185 |
| Example 2-19 | Compoun d 1-13 | Compound 2-26 | Compound 3-50 | 25:25:25:2 5 | 3.50 | 24.4 | 184 |
| Example 2-20 | | Compound 2-33 | Compound 3-51 | 25:25:25:2 5 | 3.48 | 24.3 | 179 |
| Example 2-21 | | Compound 2-42 | Compound 3-52 | 25:25:25:2 5 | 3.39 | 24.6 | 191 |

**[Table 8]**

| | First, third host | Second host | Fourth host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 2-22 | Compoun d 1-15 | Compound 2-44 | Compound 3-53 | 25:25:25:2 5 | 3.51 | 24.7 | 190 |
| Example 2-23 | | Compound 2-30 | Compound 3-56 | 25:25:25:2 5 | 3.52 | 24.8 | 195 |
| Example 2-24 | Compoun d 1-16 | Compound 2-38 | Compound 3-57 | 25:25:25:2 5 | 3.46 | 24.9 | 193 |
| Example 2-25 | | Compound 2-49 | Compound 3-58 | 25:25:25:2 5 | 3.44 | 24.3 | 190 |
| Example 2-26 | | Compound 2-52 | Compound 3-60 | 25:25:25:2 5 | 3.55 | 24.6 | 186 |
| Example 2-27 | Compoun d 1-18 | Compound 2-55 | Compound 3-62 | 25:25:25:2 5 | 3.56 | 23.4 | 189 |
| Example 2-28 | | Compound 2-58 | Compound 3-64 | 25:25:25:2 5 | 3.48 | 22.2 | 193 |
| Example 2-29 | | Compound 2-41 | Compound 3-65 | 25:25:25:2 5 | 3.43 | 23.6 | 198 |
| Example 2-30 | Compoun d 1-19 | Compound 2-47 | Compound 3-66 | 25:25:25:2 5 | 3.54 | 23.9 | 197 |
| Example 2-31 | | Compound 2-50 | Compound 3-67 | 25:25:25:2 5 | 3.58 | 23.5 | 183 |
| Example 2-32 | | Compound 2-74 | Compound 3-2 | 25:25:25:2 5 | 3.50 | 23.2 | 187 |
| Example 2-33 | Compoun d 1-21 | Compound 2-88 | Compound 3-3 | 25:25:25:2 5 | 3.49 | 24.4 | 185 |
| Example 2-34 | | Compound 2-17 | Compound 3-4 | 25:25:25:2 5 | 3.51 | 23.3 | 180 |
| Example 2-35 | | Compound 2-81 | Compound 3-13 | 25:25:25:2 5 | 3.36 | 23.3 | 188 |
| Example 2-36 | Compoun d 1-23 | Compound 2-66 | Compound 3-16 | 25:25:25:2 5 | 3.50 | 24.6 | 178 |
| Example 2-37 | | Compound 2-60 | Compound 3-17 | 25:25:25:2 5 | 3.47 | 23.7 | 179 |
| Example 2-38 | | Compound 2-63 | Compound 3-18 | 25:25:25:2 5 | 3.37 | 23.8 | 180 |

**[Table 9]**

| | First, third host | Second host | Fourth host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 2-39 | Compoun d 1-24 | Compound 2-29 | Compound 3-19 | 25:25:25:2 5 | 3.51 | 23.8 | 189 |
| Example 2-40 | | Compound 2-32 | Compound 3-21 | 25:25:25:2 5 | 3.52 | 24.6 | 191 |
| Example 2-41 | Compoun d 1-26 | Compound 2-14 | Compound 3-3 | 25:25:25:2 5 | 3.31 | 25.2 | 201 |
| Example 2-42 | | Compound 2-14 | Compound 3-14 | 25:25:25:2 5 | 3.30 | 25.6 | 199 |
| Example 2-43 | | Compound 2-71 | Compound 3-22 | 25:25:25:2 5 | 3.39 | 25.9 | 198 |
| Example 2-44 | Compoun d 1-27 | Compound 2-14 | Compound 3-3 | 25:25:25:2 5 | 3.37 | 25.2 | 199 |
| Example 2-45 | | Compound 2-69 | Compound 3-10 | 25:25:25:2 5 | 3.36 | 25.3 | 205 |
| Example 2-46 | | Compound 2-14 | Compound 3-14 | 25:25:25:2 5 | 3.38 | 24.6 | 203 |
| Example 2-47 | Compoun d 1-30 | Compound 2-73 | Compound 3-23 | 25:25:25:2 5 | 3.49 | 23.4 | 188 |
| Example 2-48 | | Compound 2-91 | Compound 3-24 | 25:25:25:2 5 | 3.46 | 24.2 | 187 |
| Example 2-49 | | Compound 2-97 | Compound 3-25 | 25:25:25:2 5 | 3.40 | 23.6 | 186 |
| Example 2-50 | Compoun d 1-32 | Compound 2-14 | Compound 3-3 | 25:25:25:2 5 | 3.34 | 24.3 | 195 |
| Example 2-51 | | Compound 2-14 | Compound 3-14 | 25:25:25:2 5 | 3.41 | 25.9 | 198 |
| Example 2-52 | | Compound 2-67 | Compound 3-63 | 25:25:25:2 5 | 3.39 | 26.4 | 200 |
| Example 2-53 | Compoun d 1-34 | Compound 2-14 | Compound 3-3 | 25:25:25:2 5 | 3.35 | 25.1 | 201 |
| Example 2-54 | | Compound 2-14 | Compound 3-14 | 25:25:25:2 5 | 3.37 | 25.5 | 205 |
| Example 2-55 | | Compound 2-56 | Compound 3-15 | 25:25:25:2 5 | 3.47 | 25.8 | 203 |

**[Table 10]**

| | First, third host | Second host | Fourth host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 2-56 | Compoun d 1-35 | Compound 2-14 | Compound 3-3 | 25:25:25:2 5 | 3.40 | 25.7 | 198 |
| Example 2-57 | | Compound 2-14 | Compound 3-14 | 25:25:25:2 5 | 3.49 | 25.9 | 209 |
| Example 2-58 | Compoun d 1-36 | Compound 2-14 | Compound 3-3 | 25:25:25:2 5 | 3.39 | 25.3 | 203 |
| Example 2-59 | | Compound 2-14 | Compound 3-14 | 25:25:25:2 5 | 3.41 | 25.1 | 204 |
| Example 2-60 | | Compound 2-10 | Compound 3-33 | 25:25:25:2 5 | 3.41 | 25.6 | 201 |
| Example 2-61 | Compoun d 1-40 | Compound 2-2 | Compound 3-27 | 25:25:25:2 5 | 3.33 | 24.8 | 203 |
| Example 2-62 | | Compound 2-9 | Compound 3-28 | 25:25:25:2 5 | 3.66 | 24.3 | 193 |
| Example 2-63 | | Compound 2-54 | Compound 3-29 | 25:25:25:2 5 | 3.59 | 24.6 | 196 |
| Example 2-64 | Compoun d 1-41 | Compound 2-3 | Compound 3-30 | 25:25:25:2 5 | 3.57 | 23.8 | 181 |
| Example 2-65 | | Compound 2-6 | Compound 3-31 | 25:25:25:2 5 | 3.55 | 24.1 | 195 |
| Example 2-66 | | Compound 2-20 | Compound 3-35 | 25:25:25:2 5 | 3.36 | 24.3 | 187 |
| Example 2-67 | Compoun d 1-44 | Compound 2-7 | Compound 3-36 | 25:25:25:2 5 | 3.51 | 24.6 | 182 |
| Example 2-68 | | Compound 2-11 | Compound 3-37 | 25:25:25:2 5 | 3.44 | 24.9 | 186 |
| Example 2-69 | | Compound 2-22 | Compound 3-38 | 25:25:25:2 5 | 3.41 | 24.6 | 189 |
| Example 2-70 | Compoun d 1-46 | Compound 2-15 | Compound 3-39 | 25:25:25:2 5 | 3.53 | 24.8 | 183 |
| Example 2-71 | | Compound 2-16 | Compound 3-42 | 25:25:25:2 5 | 3.36 | 23.9 | 180 |
| Example 2-72 | | Compound 2-19 | Compound 3-44 | 25:25:25:2 5 | 3.31 | 24.0 | 182 |

**[Table 11]**

| | First, third host | Second host | Fourth host | Ratio | @10 mA/cm² | | @20 mA/cm² |
|---|---|---|---|---|---|---|---|
| | | | | | Volta ge (V) | Effici ency (cd/A ) | Lifetime (T95, hr) |
| Example 2-73 | Compound 1-49 | Compound 2-24 | Compound 3-45 | 25:25:25:2 5 | 3.49 | 24.9 | 192 |
| Example 2-74 | | Compound 2-25 | Compound 3-47 | 25:25:25:2 5 | 3.32 | 24.5 | 183 |
| Example 2-75 | Compound 1-50 | Compound 2-27 | Compound 3-48 | 25:25:25:2 5 | 3.43 | 24.4 | 181 |
| Example 2-76 | | Compound 2-31 | Compound 3-55 | 25:25:25:2 5 | 3.51 | 24.2 | 196 |
| Example 2-77 | | Compound 2-39 | Compound 3-59 | 25:25:25:2 5 | 3.45 | 23.3 | 199 |
| Example 2-78 | Compound 1-52 | Compound 2-13 | Compound 3-61 | 25:25:25:2 5 | 3.52 | 23.8 | 194 |
| Example 2-79 | | Compound 2-28 | Compound 3-1 | 25:25:25:2 5 | 3.56 | 23.9 | 195 |
| Example 2-80 | | Compound 2-34 | Compound 3-3 | 25:25:25:2 5 | 3.39 | 24.1 | 196 |
| Example 2-81 | Compound 1-54 | Compound 2-14 | Compound 3-3 | 25:25:25:2 5 | 3.41 | 25.3 | 190 |
| Example 2-82 | | Compound 2-14 | Compound 3-12 | 25:25:25:2 5 | 3.42 | 25.8 | 197 |
| Example 2-83 | | Compound 2-14 | Compound 3-14 | 25:25:25:2 5 | 3.43 | 25.9 | 209 |
| Example 2-84 | Compound 1-58 | Compound 2-40 | Compound 3-6 | 25:25:25:2 5 | 3.46 | 24.3 | 193 |
| Example 2-85 | | Compound 2-43 | Compound 3-10 | 25:25:25:2 5 | 3.40 | 24.6 | 182 |
| Example 2-86 | | Compound 2-46 | Compound 3-15 | 25:25:25:2 5 | 3.41 | 24.9 | 186 |
| Example 2-87 | Compound 1-60 | Compound 2-14 | Compound 3-3 | 25:25:25:2 5 | 3.32 | 25.0 | 199 |
| Example 2-88 | | Compound 2-14 | Compound 3-14 | 25:25:25:2 5 | 3.43 | 25.2 | 195 |
| Example 2-89 | | Compound 2-70 | Compound 3-54 | 25:25:25:2 5 | 3.36 | 25.9 | 206 |

**[Table 12]**

| | First, third host | Second host | Fourth host | Ratio | @10 mA/cm² | | @20 mA/cm² |
|---|---|---|---|---|---|---|---|
| | | | | | Volta ge (V) | Effici ency (cd/ A) | Lifetime (T95, hr) |
| Example 2-90 | Compound 1-61 | Compound 2-64 | Compound 3-21 | 25:25:25:2 5 | 3.50 | 24.9 | 202 |
| Example 2-91 | | Compound 2-68 | Compound 3-28 | 25:25:25:2 5 | 3.46 | 24.8 | 183 |
| Example 2-92 | Compound 1-63 | Compound 2-72 | Compound 3-32 | 25:25:25:2 5 | 3.54 | 24.5 | 196 |
| Example 2-93 | | Compound 2-77 | Compound 3-33 | 25:25:25:2 5 | 3.41 | 24.6 | 194 |
| Example 2-94 | | Compound 2-80 | Compound 3-28 | 25:25:25:2 5 | 3.42 | 25.1 | 189 |
| Example 2-95 | Compound 1-64 | Compound 2-82 | Compound 3-40 | 25:25:25:2 5 | 3.43 | 24.2 | 187 |
| Example 2-96 | | Compound 2-86 | Compound 3-48 | 25:25:25:2 5 | 3.46 | 24.3 | 188 |
| Example 2-97 | | Compound 2-95 | Compound 3-51 | 25:25:25:2 5 | 3.38 | 25.9 | 189 |
| Example 2-98 | Compound 1-65 | Compound 2-99 | Compound 3-55 | 25:25:25:2 5 | 3.41 | 24.2 | 199 |
| Example 2-99 | | Compound 2-100 | Compound 3-56 | 25:25:25:2 5 | 3.56 | 24.6 | 193 |
| Example 2-101 | | Compound 2-103 | Compound 3-58 | 25:25:25:2 5 | 3.52 | 24.3 | 192 |
| Example 2-102 | Compound 1-66 | Compound 2-14 | Compound 3-3 | 25:25:25:2 5 | 3.43 | 25.8 | 191 |
| Example 2-103 | | Compound 2-14 | Compound 3-14 | 25:25:25:2 5 | 3.38 | 25.9 | 202 |
| Example 2-104 | | Compound 2-104 | Compound 3-50 | 25:25:25:2 5 | 3.31 | 25.5 | 203 |
| Example 2-105 | Compound 1-68 | Compound 2-14 | Compound 3-3 | 25:25:25:2 5 | 3.32 | 25.8 | 206 |
| Example 2-106 | | Compound 2-14 | Compound 3-14 | 25:25:25:2 5 | 3.38 | 25.1 | 209 |
| Example 2-107 | | Compound 2-107 | Compound 3-61 | 25:25:25:2 5 | 3.37 | 25.4 | 207 |

### Experimental Example 3: Evaluation of device characteristics

The voltage, efficiency (based on 10mA/cm²) and lifetime (based on 20mA/cm²) were measured by applying a current to the organic light emitting devices manufactured in Example 3-1 to Example 3-107, and the results are shown in Tables 13 to 18 below. Here, the ratio of the first host, second host, third host and fourth host is 25:25:25:25, and lifetime T95 means the time required for the luminance to be reduced to 95% of the initial luminance (5,000 nit).

**[Table 13]**

| | First host | Second host | Third host | Fourth host | @10 mA/cm² | | @20 mA/cm² |
|---|---|---|---|---|---|---|---|
| | | | | | Volta ge (V) | Effici ency (cd/A ) | Lifetime (T95, hr) |
| Example 3-1 | Compound 1-1 | Compound 2-5 | Compound 1-3 | Compound 3-1 | 3.49 | 23.5 | 189 |
| Example 3-2 | | Compound 2-14 | Compound 1-5 | Compound 3-3 | 3.45 | 23.3 | 192 |
| Example 3-3 | | Compound 2-36 | Compound 1-7 | Compound 3-5 | 3.30 | 23.6 | 189 |
| Example 3-4 | Compound 1-2 | Compound 2-45 | Compound 1-9 | Compound 3-6 | 3.42 | 22.9 | 188 |
| Example 3-5 | | Compound 2-61 | Compound 1-10 | Compound 3-7 | 3.55 | 23.0 | 181 |
| Example 3-6 | | Compound 2-78 | Compound 1-12 | Compound 3-8 | 3.50 | 23.7 | 192 |
| Example 3-7 | Compound 1-4 | Compound 2-85 | Compound 1-17 | Compound 3-9 | 3.31 | 24.1 | 190 |
| Example 3-8 | | Compound 2-93 | Compound 1-20 | Compound 3-11 | 3.55 | 23.9 | 193 |
| Example 3-9 | | Compound 2-102 | Compound 1-22 | Compound 3-15 | 3.48 | 24.6 | 197 |
| Example 3-10 | Compound 1-6 | Compound 2-105 | Compound 1-25 | Compound 3-20 | 3.31 | 23.7 | 188 |
| Example 3-11 | | Compound 2-109 | Compound 1-28 | Compound 3-26 | 3.39 | 24.8 | 199 |
| Example 3-12 | | Compound 2-1 | Compound 1-29 | Compound 3-32 | 3.40 | 24.9 | 182 |
| Example 3-13 | Compound 1-8 | Compound 2-4 | Compound 1-31 | Compound 3-34 | 3.52 | 25.2 | 197 |
| Example 3-14 | | Compound 2-8 | Compound 1-33 | Compound 3-40 | 3.55 | 23.6 | 193 |
| Example 3-15 | | Compound 2-12 | Compound 1-37 | Compound 3-41 | 3.31 | 24.1 | 180 |
| Example 3-16 | Compound 1-11 | Compound 2-18 | Compound 1-38 | Compound 3-43 | 3.43 | 23.8 | 189 |
| Example 3-17 | | Compound 2-21 | Compound 1-39 | Compound 3-46 | 3.52 | 24.2 | 187 |
| Example 3-18 | | Compound 2-23 | Compound 1-42 | Compound 3-49 | 3.50 | 24.7 | 187 |
| Example 3-19 | Compound 1-13 | Compound 2-26 | Compound 1-43 | Compound 3-50 | 3.47 | 24.6 | 186 |
| Example 3-20 | | Compound 2-33 | Compound 1-45 | Compound 3-51 | 3.49 | 24.7 | 180 |
| Example 3-21 | | Compound 2-42 | Compound 1-47 | Compound 3-52 | 3.38 | 24.9 | 193 |

**[Table 14]**

| | First host | Second host | Third host | Fourth host | @10 mA/cm² | | @20 mA/cm² |
|---|---|---|---|---|---|---|---|
| | | | | | Volta ge (V) | Effici ency (cd/A ) | Lifetime (T95, hr) |
| Example 3-22 | Compound 1-15 | Compound 2-44 | Compound 1-48 | Compound 3-53 | 3.47 | 25.0 | 192 |
| Example 3-23 | | Compound 2-30 | Compound 1-51 | Compound 3-56 | 3.51 | 25.1 | 197 |
| Example 3-24 | Compound 1-16 | Compound 2-38 | Compound 1-53 | Compound 3-57 | 3.45 | 25.3 | 195 |
| Example 3-25 | | Compound 2-49 | Compound 1-55 | Compound 3-58 | 3.42 | 24.9 | 193 |
| Example 3-26 | | Compound 2-52 | Compound 1-56 | Compound 3-60 | 3.52 | 24.9 | 189 |
| Example 3-27 | Compound 1-18 | Compound 2-55 | Compound 1-57 | Compound 3-62 | 3.53 | 24.1 | 190 |
| Example 3-28 | | Compound 2-58 | Compound 1-59 | Compound 3-64 | 3.44 | 23.0 | 192 |
| Example 3-29 | | Compound 2-41 | Compound 1-62 | Compound 3-65 | 3.41 | 23.8 | 200 |
| Example 3-30 | Compound 1-19 | Compound 2-47 | Compound 1-64 | Compound 3-66 | 3.51 | 24.3 | 201 |
| Example 3-31 | | Compound 2-50 | Compound 1-65 | Compound 3-67 | 3.57 | 23.7 | 185 |
| Example 3-32 | | Compound 2-74 | Compound 1-67 | Compound 3-2 | 3.46 | 23.8 | 189 |
| Example 3-33 | Compound 1-21 | Compound 2-88 | Compound 1-1 | Compound 3-3 | 3.45 | 24.9 | 187 |
| Example 3-34 | | Compound 2-17 | Compound 1-3 | Compound 3-4 | 3.50 | 23.5 | 183 |
| Example 3-35 | | Compound 2-81 | Compound 1-4 | Compound 3-13 | 3.35 | 23.6 | 190 |
| Example 3-36 | Compound 1-23 | Compound 2-66 | Compound 1-5 | Compound 3-16 | 3.49 | 24.8 | 181 |
| Example 3-37 | | Compound 2-60 | Compound 1-7 | Compound 3-17 | 3.45 | 23.9 | 183 |
| Example 3-38 | | Compound 2-63 | Compound 1-8 | Compound 3-18 | 3.33 | 23.9 | 185 |

**[Table 15]**

| | First host | Second host | Third host | Fourth host | @10 mA/cm² | | @20 mA/cm² |
|---|---|---|---|---|---|---|---|
| | | | | | Volta ge (V) | Effici ency (cd/A ) | Lifetime (T95, hr) |
| Example 3-39 | Compound 1-24 | Compound 2-29 | Compound 1-9 | Compound 3-19 | 3.50 | 23.9 | 191 |
| Example 3-40 | | Compound 2-32 | Compound 1-10 | Compound 3-21 | 3.51 | 24.7 | 192 |
| Example 3-41 | Compound 1-26 | Compound 2-14 | Compound 1-27 | Compound 3-3 | 3.30 | 25.6 | 203 |
| Example 3-42 | | Compound 2-14 | Compound 1-34 | Compound 3-14 | 3.29 | 25.9 | 205 |
| Example 3-43 | | Compound 2-71 | Compound 1-36 | Compound 3-22 | 3.31 | 26.0 | 201 |
| Example 3-44 | Compound 1-27 | Compound 2-14 | Compound 1-26 | Compound 3-3 | 3.35 | 25.9 | 201 |
| Example 3-45 | | Compound 2-69 | Compound 1-35 | Compound 3-10 | 3.30 | 25.6 | 207 |
| Example 3-46 | | Compound 2-14 | Compound 1-54 | Compound 3-14 | 3.31 | 24.9 | 205 |
| Example 3-47 | Compound 1-30 | Compound 2-73 | Compound 1-12 | Compound 3-23 | 3.50 | 23.5 | 189 |
| Example 3-48 | | Compound 2-91 | Compound 1-16 | Compound 3-24 | 3.45 | 24.6 | 189 |
| Example 3-49 | | Compound 2-97 | Compound 1-19 | Compound 3-25 | 3.43 | 23.7 | 188 |
| Example 3-50 | Compound 1-32 | Compound 2-14 | Compound 1-26 | Compound 3-3 | 3.35 | 24.6 | 197 |
| Example 3-51 | | Compound 2-14 | Compound 1-27 | Compound 3-14 | 3.40 | 26.0 | 200 |
| Example 3-52 | | Compound 2-67 | Compound 1-54 | Compound 3-63 | 3.36 | 26.5 | 202 |
| Example 3-53 | Compound 1-34 | Compound 2-14 | Compound 1-26 | Compound 3-3 | 3.37 | 25.5 | 203 |
| Example 3-54 | | Compound 2-14 | Compound 1-27 | Compound 3-14 | 3.35 | 25.6 | 207 |
| Example 3-55 | | Compound 2-56 | Compound 1-54 | Compound 3-15 | 3.43 | 25.9 | 205 |

**[Table 16]**

| | First host | Second host | Third host | Fourth host | @10 mA/cm² | | @20 mA/cm² |
|---|---|---|---|---|---|---|---|
| | | | | | Volta ge (V) | Effici ency (cd/A ) | Lifetime (T95, hr) |
| Example 3-56 | Compound 1-35 | Compound 2-14 | Compound 1-26 | Compound 3-3 | 3.36 | 25.9 | 200 |
| Example 3-57 | | Compound 2-14 | Compound 1-27 | Compound 3-14 | 3.48 | 26.0 | 211 |
| Example 3-58 | Compound 1-36 | Compound 2-14 | Compound 1-26 | Compound 3-3 | 3.35 | 25.6 | 205 |
| Example 3-59 | | Compound 2-14 | Compound 1-27 | Compound 3-14 | 3.40 | 25.5 | 206 |
| Example 3-60 | | Compound 2-10 | Compound 1-54 | Compound 3-33 | 3.37 | 25.9 | 203 |
| Example 3-61 | Compound 1-40 | Compound 2-2 | Compound 1-20 | Compound 3-27 | 3.36 | 24.9 | 205 |
| Example 3-62 | | Compound 2-9 | Compound 1-22 | Compound 3-28 | 3.60 | 24.6 | 195 |
| Example 3-63 | | Compound 2-54 | Compound 1-23 | Compound 3-29 | 3.51 | 24.7 | 197 |
| Example 3-64 | Compound 1-41 | Compound 2-3 | Compound 1-24 | Compound 3-30 | 3.53 | 23.9 | 186 |
| Example 3-65 | | Compound 2-6 | Compound 1-25 | Compound 3-31 | 3.52 | 24.3 | 199 |
| Example 3-66 | | Compound 2-20 | Compound 1-28 | Compound 3-35 | 3.33 | 24.5 | 189 |
| Example 3-67 | Compound 1-44 | Compound 2-7 | Compound 1-29 | Compound 3-36 | 3.56 | 24.8 | 185 |
| Example 3-68 | | Compound 2-11 | Compound 1-30 | Compound 3-37 | 3.45 | 25.2 | 188 |
| Example 3-69 | | Compound 2-22 | Compound 1-31 | Compound 3-38 | 3.40 | 24.7 | 190 |
| Example 3-70 | Compound 1-46 | Compound 2-15 | Compound 1-32 | Compound 3-39 | 3.52 | 24.9 | 185 |
| Example 3-71 | | Compound 2-16 | Compound 1-33 | Compound 3-42 | 3.33 | 24.2 | 187 |
| Example 3-72 | | Compound 2-19 | Compound 1-37 | Compound 3-44 | 3.29 | 24.2 | 184 |

**[Table 17]**

| | First host | Second host | Third host | Fourth host | @10 mA/cm² | | @20 mA/cm² |
|---|---|---|---|---|---|---|---|
| | | | | | Volta ge (V) | Effici ency (cd/A ) | Lifetime (T95, hr) |
| Example 3-73 | Compound 1-49 | Compound 2-24 | Compound 1-38 | Compound 3-45 | 3.33 | 25.1 | 195 |
| Example 3-74 | | Compound 2-25 | Compound 1-40 | Compound 3-47 | 3.36 | 24.6 | 185 |
| Example 3-75 | Compound 1-50 | Compound 2-27 | Compound 1-43 | Compound 3-48 | 3.42 | 24.7 | 183 |
| Example 3-76 | | Compound 2-31 | Compound 1-45 | Compound 3-55 | 3.50 | 24.5 | 197 |
| Example 3-77 | | Compound 2-39 | Compound 1-49 | Compound 3-59 | 3.43 | 23.6 | 201 |
| Example 3-78 | Compound 1-52 | Compound 2-13 | Compound 1-50 | Compound 3-61 | 3.51 | 23.9 | 195 |
| Example 3-79 | | Compound 2-28 | Compound 1-52 | Compound 3-1 | 3.55 | 24.0 | 196 |
| Example 3-80 | | Compound 2-34 | Compound 1-53 | Compound 3-3 | 3.36 | 24.2 | 198 |
| Example 3-81 | Compound 1-54 | Compound 2-14 | Compound 1-26 | Compound 3-3 | 3.37 | 25.6 | 192 |
| Example 3-82 | | Compound 2-14 | Compound 1-27 | Compound 3-12 | 3.40 | 25.9 | 199 |
| Example 3-83 | | Compound 2-14 | Compound 1-34 | Compound 3-14 | 3.38 | 26.2 | 211 |
| Example 3-84 | Compound 1-58 | Compound 2-40 | Compound 1-55 | Compound 3-6 | 3.38 | 24.5 | 195 |
| Example 3-85 | | Compound 2-43 | Compound 1-59 | Compound 3-10 | 3.32 | 24.9 | 185 |
| Example 3-86 | | Compound 2-46 | Compound 1-60 | Compound 3-15 | 3.39 | 25.2 | 187 |
| Example 3-87 | Compound 1-60 | Compound 2-14 | Compound 1-26 | Compound 3-3 | 3.30 | 25.1 | 201 |
| Example 3-88 | | Compound 2-14 | Compound 1-27 | Compound 3-14 | 3.35 | 25.3 | 196 |
| Example 3-89 | | Compound 2-70 | Compound 1-66 | Compound 3-54 | 3.31 | 26.0 | 209 |

**[Table 18]**

| | First host | Second host | Third host | Fourth host | @10 mA/cm² | | @20 mA/cm² |
|---|---|---|---|---|---|---|---|
| | | | | | Volta ge (V) | Effici ency (cd/A ) | Lifetime (T95, hr) |
| Example 3-90 | Compound 1-61 | Compound 2-64 | Compound 1-56 | Compound 3-21 | 3.42 | 25.2 | 206 |
| Example 3-91 | | Compound 2-68 | Compound 1-57 | Compound 3-28 | 3.40 | 25.0 | 188 |
| Example 3-92 | Compound 1-63 | Compound 2-72 | Compound 1-58 | Compound 3-32 | 3.51 | 24.7 | 199 |
| Example 3-93 | | Compound 2-77 | Compound 1-61 | Compound 3-33 | 3.40 | 24.8 | 198 |
| Example 3-94 | | Compound 2-80 | Compound 1-62 | Compound 3-28 | 3.39 | 25.3 | 192 |
| Example 2-95 | Compound 1-64 | Compound 2-82 | Compound 1-63 | Compound 3-40 | 3.42 | 24.5 | 189 |
| Example 3-96 | | Compound 2-86 | Compound 1-64 | Compound 3-48 | 3.45 | 24.6 | 192 |
| Example 3-97 | | Compound 2-95 | Compound 1-65 | Compound 3-51 | 3.39 | 26.2 | 193 |
| Example 3-98 | Compound 1-65 | Compound 2-99 | Compound 1-66 | Compound 3-55 | 3.40 | 24.4 | 203 |
| Example 3-99 | Compound 1-65 | Compound 2-100 | Compound 1-67 | Compound 3-56 | 3.53 | 24.9 | 195 |
| Example 3-101 | | Compound 2-103 | Compound 1-6 | Compound 3-58 | 3.51 | 24.6 | 197 |
| Example 3-102 | Compound 1-66 | Compound 2-14 | Compound 1-26 | Compound 3-3 | 3.40 | 25.9 | 192 |
| Example 3-103 | | Compound 2-14 | Compound 1-27 | Compound 3-14 | 3.37 | 26.1 | 205 |
| Example 3-104 | | Compound 2-104 | Compound 1-68 | Compound 3-1 | 3.30 | 25.6 | 209 |
| Example 3-105 | Compound 1-68 | Compound 2-14 | Compound 1-26 | Compound 3-3 | 3.31 | 25.9 | 207 |
| Example 3-106 | | Compound 2-14 | Compound 1-27 | Compound 3-14 | 3.35 | 25.3 | 212 |
| Example 3-107 | | Compound 2-107 | Compound 1-60 | Compound 3-61 | 3.32 | 25.8 | 209 |

### Experimental Example 4: Evaluation of device characteristics

The voltage, efficiency (based on 10mA/cm²) and lifetime (based on 20mA/cm²) were measured by applying a current to the organic light emitting devices manufactured in Comparative Example 1 to Comparative Example 11, and the results are shown in Table 19 below. Here, the ratio of the first host, second host, third host and fourth host is the same as shown in Table, and lifetime T95 means the time required for the luminance to be reduced to 95% of the initial luminance (5,000 nit).

**[Table 19]**

| | First host | Second host | Third host | Ratio | @10 mA/cm² | | @20 mA/cm² |
|---|---|---|---|---|---|---|---|
| | | | | | Voltag e (V) | Effici ency (cd/A ) | Lifetime (T95, hr) |
| Comparativ e Example 1-1 | Compound 1-27 | - | - | 100:0:0 | 3.97 | 17.9 | 99 |
| Comparativ e Example 1-2 | - | Compound 2-30 | - | 0:100:0 | 3.95 | 18.8 | 95 |
| Comparativ e Example 1-3 | - | - | Compound 3-15 | 0:0 :100 | 3.90 | 18.1 | 93 |
| Comparativ e Example 1-4 | Compound 1-26 | Compound 2-3 | - | 50:50:0 | 3.85 | 19.6 | 102 |
| Comparativ e Example 1-5 | Compound 1-27 | Compound 2-14 | - | 50:50:0 | 3.88 | 19.5 | 103 |
| Comparativ e Example 1-6 | Compound 1-54 | Compound 2-45 | - | 50:50:0 | 3.81 | 19.1 | 101 |
| Comparativ e Example 1-7 | Compound 1-26 | - | Compound 3-3 | 50:0:50 | 3.87 | 19.0 | 105 |
| Comparativ e Example 1-8 | Compound 1-27 | - | Compound 3-14 | 50:0:50 | 3.85 | 19.3 | 107 |
| Comparativ e Example 1-9 | Compound 1-54 | - | Compound 3-66 | 50:0:50 | 3.86 | 19.2 | 103 |
| Comparativ e Example 1-10 | - | Compound 2-2 | Compound 3-3 | 0:50:50 | 3.84 | 19.4 | 101 |
| Comparativ e Example 1-11 | - | Compound 2-14 | Compound 3-14 | 0:50:50 | 3.89 | 19.5 | 105 |

As shown in Tables 1 to 19, the organic light emitting devices of Examples in which three or more materials of Chemical Formulas 1, 2, and 3 were simultaneously used as the host material of the light emitting layer exhibited excellent driving voltage, luminous efficiency, and lifetime characteristics, as compared to the organic light emitting device of Comparative Examples using only one or two compounds represented by Chemical Formulas 1, 2, and 3.

**<Description of Symbols>**

| | | | |
|---|---|---|---|
| 1: | substrate | 2: | anode |
| 3: | light emitting layer | 4: | cathode |
| 5: | hole injection layer | 6: | hole transport layer |
| 7: | electron blocking layer | 8: | hole blocking layer |
| 9: | electron injection and trans port layer | | |

## Claims

1. An organic light emitting device comprising:
an anode (2); a cathode (4); and a light emitting layer (3) interposed between the anode and the cathode,
wherein the light emitting layer includes,
one or more compounds represented by the following Chemical Formula 1,
one or more compounds represented by the following Chemical Formula 2, and
one or more compounds represented by the following Chemical Formula 3:
in Chemical Formula 1,
Ar₁ and Ar₂ are each independently a substituted or unsubstituted C₆₋₆₀ aryl; or a substituted or unsubstituted C₂₋₆₀ heteroaryl containing one or more selected from the group consisting of N, O and S,
L₁ to L₃ are each independently a single bond; or a substituted or unsubstituted C₆₋₆₀ arylene,
each R₁ is independently hydrogen; deuterium; a substituted or unsubstituted C₆₋₆₀ aryl; or a substituted or unsubstituted C₂₋₆₀ heteroaryl containing one or more selected from the group consisting of N, O and S, and
a is an integer of 0 to 7,
in Chemical Formula 2,
X'₁ is N and X'₂ is O; or X'₁ is O, and X'₂ is N,
any one of R'₁ to R'₇ is linked with the following Chemical Formula 2A, and the rest are each independently hydrogen; deuterium; a substituted or unsubstituted C₆₋₆₀ aryl; or a substituted or unsubstituted C₂₋₆₀ heteroaryl containing one or more selected from the group consisting of N, O and S,
in Chemical Formula 2A,
L'₁ to L'₃ are each independently a single bond; or a substituted or unsubstituted C₆₋₆₀ arylene, and
Ar'₁ and Ar'₂ are each independently a substituted or unsubstituted C₆₋₆₀ aryl; or a substituted or unsubstituted C₂₋₆₀ heteroaryl containing one or more selected from the group consisting of N, O and S,
in Chemical Formula 3,
X" is O or S, and
any one of R"₁ to R"₁₀ is linked with the following Chemical formula 3A, and the rest are hydrogen or deuterium,
in Chemical Formula 3A,
L"₁ to L"₃ are each independently a single bond; or a substituted or unsubstituted C₆₋₆₀ arylene, and
Ar"₁ and Ar"₂ are each independently a substituted or unsubstituted C₆₋₆₀ aryl; or a substituted or unsubstituted C₂₋₆₀ heteroaryl containing one or more selected from the group consisting of N, O and S.

2. The organic light emitting device according to claim 1, wherein:
Ar₁ and Ar₂ are each independently phenyl, triphenylsilyl phenyl, biphenylyl, terphenylyl, naphthyl, phenanthrenyl, chrysenyl, benzo[c]phenanthrenyl, dibenzofuranyl, or dibenzothiophenyl,
wherein the Ar₁ and Ar₂ are each independently unsubstituted or substituted with at least one deuterium.

3. The organic light emitting device according to claim 1, wherein:
L₁ to L₃ are each independently a single bond, phenylene, biphenyldiyl, naphthalenediyl, phenyl naphthalenediyl, or naphthyl naphthalenediyl,
wherien when the L₁ to L₃ are phenylene, biphenyldiyl, naphthalenediyl, phenyl naphthalenediyl, or naphthyl naphthalenediyl, L₁ to L₃ are unsubstituted or substituted with at least one deuterium.

4. The organic light emitting device according to claim 1, wherein:
each R₁ is independently hydrogen, deuterium, phenyl, biphenylyl, terphenylyl, naphthyl, phenanthrenyl, triphenylenyl, naphthyl phenyl, phenyl naphthyl, fluoranthenyl, dibenzofuranyl, dibenzothiophenyl, benzonaphthofuranyl, or benzonaphthothiophenyl,
wherien when the R₁ is phenyl, biphenylyl, terphenylyl, naphthyl, phenanthrenyl, triphenylenyl, naphthyl phenyl, phenyl naphthyl, fluoranthenyl, dibenzofuranyl, dibenzothiophenyl, benzonaphthofuranyl, or benzonaphthothiophenyl, each R₁ is independently unsubstituted or substituted with at least one deuterium.

5. The organic light emitting device according to claim 1, wherein:
at least one of Ar₁, Ar₂ and R₁ is phenyl, naphthyl, phenyl naphthyl, naphthyl phenyl, phenanthrenyl, fluoranthenyl, dibenzofuranyl, dibenzothiophenyl, benzonaphthofuranyl, or benzonaphthothiophenyl,
wherein the Ar₁, Ar₂ and R₁ are each independently unsubstituted or substituted with at least one deuterium.

6. The organic light emitting device according to claim 1, wherein:
the compound represented by Chemical Formula 1 is any one selected from the group consisting of:

7. The organic light emitting device according to claim 1, wherein:
the compound represented by Chemical Formula 2 is represented by either the following Chemical Formula 2-1 or Chemical Formula 2-2:
in Chemical Formula 2-1 and Chemical Formula 2-2,
R'₁ to R'₆ are hydrogen or deuterium,
R'₇ is a substituted or unsubstituted C₆₋₆₀ aryl; or a substituted or unsubstituted C₂₋₆₀ heteroaryl containing one or more selected from the group consisting of N, O and S, and
X'₁, X'₂, L'₁ to L'₃, Ar'₁ and Ar'₂ are as defined in claim 1.

8. The organic light emitting device according to claim 1, wherein:
any one of R'₁ to R'₇ is Chemical Formula 2A, and the rest are each independently hydrogen, deuterium, phenyl, biphenylyl, or naphthyl,
wherein the phenyl, biphenylyl and naphthyl are each independently unsubstituted or substituted with at least one deuterium.

9. The organic light emitting device according to claim 1, wherein:
L'₁ to L'₃ are each independently a single bond, phenylene, biphenyldiyl, terphenyldiyl, naphthalenediyl, or phenyl naphthalenediyl,
wherein the phenylene, biphenyldiyl, terphenyldiyl, naphthalenediyl and phenyl naphthalenediyl are each independently unsubstituted or substituted with at least one deuterium.

10. The organic light emitting device according to claim 1, wherein:
Ar'₁ and Ar'₂ are each independently phenyl, biphenylyl, terphenylyl, naphthyl, phenyl naphthyl, phenanthrenyl, dimethylfluorenyl, dibenzofuranyl, dibenzothiophenyl, carbazolyl, or phenyl carbazolyl,
wherein the Ar'₁ and Ar'₂ are unsubstituted or substituted with at least one deuterium.

11. The organic light emitting device according to claim 1, wherein: the compound represented by Chemical Formula 2 is any one selected from the group consisting of:

12. The organic light emitting device according to claim 1, wherein:
the Chemical Formula 3A is linked with any one of R"₁, R"₂, R"₄, R"₅ and R"₈ to R"₁₀ of Chemical Formula 3.

13. The organic light emitting device according to claim 1, wherein:
L"₁ to L"₃ are each independently a single bond, phenylene, biphenyldiyl, naphthalenediyl, or dimethylfluorenediyl,
wherein the phenylene, biphenyldiyl, naphthalenediyl and dimethylfluorenediyl is each independently unsubstituted or substituted with at least one deuterium.

14. The organic light emitting device according to claim 1, wherein:
Ar"₁ and Ar"₂ are each independently phenyl, triphenylsilyl phenyl, biphenylyl, terphenylyl, naphthyl, phenanthrenyl, dimethylfluorenyl, spirobifluorenyl, dibenzofuranyl, dibenzothiophenyl, or phenylcarbazolyl,
wherein the Ar"₁ and Ar"₂ are each independently unsubstituted or substituted with at least one deuterium.

15. The organic light emitting device according to claim 1, wherein:
the compound represented by Chemical Formula 3 is any one selected from the group consisting of:

## Patentansprüche

1. Organische lichtemittierende Vorrichtung, umfassend:
eine Anode (2); eine Kathode (4); und eine lichtemittierende Schicht (3), die zwischen der Anode und der Kathode angeordnet ist,
wobei die lichtemittierende Schicht
eine oder mehrere Verbindungen, dargestellt durch die folgende Chemische Formel 1,
eine oder mehrere Verbindungen, dargestellt durch die folgende Chemische Formel 2, und
eine oder mehrere Verbindungen, dargestellt durch die folgende Chemische Formel 3, enthält:
wobei in der Chemischen Formel 1
Ar₁ und Ar₂ jeweils unabhängig voneinander ein substituiertes oder unsubstituiertes C₆₋₆₀-Aryl; oder ein substituiertes oder unsubstituiertes C₂₋₆₀-Heteroaryl, enthaltend eines oder mehrere, ausgewählt aus der Gruppe, bestehend aus N, O und S, sind,
L₁ bis L₃ jeweils unabhängig voneinander eine Einfachbindung; oder ein substituiertes oder unsubstituiertes C₆₋₆₀-Arylen sind,
jedes R₁ unabhängig Wasserstoff; Deuterium; ein substituiertes oder unsubstituiertes C₆₋₆₀-Aryl; oder ein substituiertes oder unsubstituiertes C₂₋₆₀-Heteroaryl, enthaltend eines oder mehrere, ausgewählt aus der Gruppe, bestehend aus N, O und S, ist, und
a eine ganze Zahl von 0 bis 7 ist,
wobei in der Chemischen Formel 2
X'₁ N ist und X'₂ O ist; oder X'₁ O ist und X'₂ N ist,
ein beliebiges von R'₁ bis R'₇ mit der folgenden Chemischen Formel 2A verknüpft ist und die übrigen jeweils unabhängig voneinander Wasserstoff; Deuterium; ein substituiertes oder unsubstituiertes C₆₋₆₀-Aryl; oder ein substituiertes oder unsubstituiertes C₂₋₆₀-Heteroaryl, enthaltend eines oder mehrere, ausgewählt aus der Gruppe, bestehend aus N, O und S, sind,
wobei in der Chemischen Formel 2A
L'₁ bis L'₃ jeweils unabhängig voneinander eine Einfachbindung; oder ein substituiertes oder unsubstituiertes C₆₋₆₀-Arylen sind, und
Ar'₁ und Ar'₂ jeweils unabhängig voneinander ein substituiertes oder unsubstituiertes C₆₋₆₀-Aryl; oder ein substituiertes oder unsubstituiertes C₂₋₆₀-Heteroaryl, enthaltend eines oder mehrere, ausgewählt aus der Gruppe, bestehend aus N, O und S, sind,
wobei in der Chemischen Formel 3
X" O oder S ist, und
ein beliebiges von R"₁ bis R"₁₀ mit der folgenden Chemischen Formel 3A verknüpft ist, und die übrigen Wasserstoff oder Deuterium sind,
wobei in der Chemischen Formel 3A L"₁ bis L"₃ jeweils unabhängig voneinander eine Einfachbindung; oder ein substituiertes oder unsubstituiertes C₆₋₆₀-Arylen sind, und
Ar"₁ und Ar"₂ jeweils unabhängig voneinander ein substituiertes oder unsubstituiertes C₆₋₆₀-Aryl; oder ein substituiertes oder unsubstituiertes C₂₋₆₀-Heteroaryl, enthaltend eines oder mehrere, ausgewählt aus der Gruppe, bestehend aus N, O und S, sind.

2. Organische lichtemittierende Vorrichtung gemäß Anspruch 1, wobei:
Ar₁ und Ar₂ jeweils unabhängig voneinander Phenyl, Triphenylsilylphenyl, Biphenylyl, Terphenylyl, Naphthyl, Phenanthrenyl, Chrysenyl, Benzo[c]phenanthrenyl, Dibenzofuranyl oder Dibenzothiophenyl sind,
wobei Ar₁ und Ar₂ jeweils unabhängig voneinander unsubstituiert oder mit mindestens einem Deuterium substituiert sind.

3. Organische lichtemittierende Vorrichtung gemäß Anspruch 1, wobei:
L₁ bis L₃ jeweils unabhängig voneinander eine Einfachbindung, Phenylen, Biphenyldiyl, Naphthalindiyl, Phenylnaphthalindiyl oder Naphthylnaphthalindiyl sind,
wobei, wenn L₁ bis L₃ Phenylen, Biphenyldiyl, Naphthalindiyl, Phenylnaphthalindiyl oder Naphthylnaphthalindiyl sind, L₁ bis L₃ unsubstituiert oder mit mindestens einem Deuterium substituiert sind.

4. Organische lichtemittierende Vorrichtung gemäß Anspruch 1, wobei:
jedes R₁ unabhängig Wasserstoff, Deuterium, Phenyl, Biphenylyl, Terphenylyl, Naphthyl, Phenanthrenyl, Triphenylenyl, Naphthylphenyl, Phenylnaphthyl, Fluoranthenyl, Dibenzofuranyl, Dibenzothiophenyl, Benzonaphthofuranyl oder Benzonaphthothiophenyl ist,
wobei, wenn R₁ Phenyl, Biphenylyl, Terphenylyl, Naphthyl, Phenanthrenyl, Triphenylenyl, Naphthylphenyl, Phenylnaphthyl, Fluoranthenyl, Dibenzofuranyl, Dibenzothiophenyl, Benzonaphthofuranyl oder Benzonaphthothiophenyl ist, jedes R₁ unabhängig unsubstituiert oder mit mindestens einem Deuterium substituiert ist.

5. Organische lichtemittierende Vorrichtung gemäß Anspruch 1, wobei:
mindestens eines von Ar₁, Ar₂ und R₁ Phenyl, Naphthyl, Phenylnaphthyl, Naphthylphenyl, Phenanthrenyl, Fluoranthenyl, Dibenzofuranyl, Dibenzothiophenyl, Benzonaphthofuranyl oder Benzonaphthothiophenyl ist,
wobei Ar₁, Ar₂ und R₁ jeweils unabhängig voneinander unsubstituiert oder mit mindestens einem Deuterium substituiert sind.

6. Organische lichtemittierende Vorrichtung gemäß Anspruch 1, wobei:
die durch die Chemische Formel 1 dargestellte Verbindung eine beliebige ist, die aus der Gruppe ausgewählt ist, die besteht aus:

7. Organische lichtemittierende Vorrichtung gemäß Anspruch 1, wobei:
die durch die Chemische Formel 2 dargestellte Verbindung entweder durch die folgende Chemische Formel 2-1 oder durch die folgende Chemische Formel 2-2 dargestellt wird:
wobei in der Chemischen Formel 2-1 und in der Chemischen Formel 2-2
R'₁ bis R'₆ Wasserstoff oder Deuterium sind,
R'₇ ein substituiertes oder unsubstituiertes C₆₋₆₀-Aryl ist; oder ein substituiertes oder unsubstituiertes C₂₋₆₀-Heteroaryl, enthaltend eines oder mehrere, ausgewählt aus der Gruppe, bestehend aus N, O und S, ist, und
X'₁, X'₂, L'₁ bis L'₃ Ar'₁ und Ar'₂ wie in Anspruch 1 definiert sind.

8. Organische lichtemittierende Vorrichtung gemäß Anspruch 1, wobei:
ein beliebiges von R'₁ bis R'₇ die Chemische Formel 2A aufweist und die übrigen jeweils unabhängig voneinander Wasserstoff, Deuterium, Phenyl, Biphenylyl oder Naphthyl sind,
wobei das Phenyl, Biphenylyl und Naphthyl jeweils unabhängig voneinander unsubstituiert oder mit mindestens einem Deuterium substituiert sind.

9. Organische lichtemittierende Vorrichtung gemäß Anspruch 1, wobei:
L'₁ bis L'₃ jeweils unabhängig voneinander eine Einfachbindung, Phenylen, Biphenyldiyl, Terphenyldiyl, Naphthalindiyl oder Phenylnaphthalindiyl sind,
wobei das Phenylen, Biphenyldiyl, Terphenyldiyl, Naphthalindiyl und Phenylnaphthalindiyl jeweils unabhängig voneinander unsubstituiert oder mit mindestens einem Deuterium substituiert sind.

10. Organische lichtemittierende Vorrichtung gemäß Anspruch 1, wobei:
Ar'₁ und Ar'₂ jeweils unabhängig voneinander Phenyl, Biphenylyl, Terphenylyl, Naphthyl, Phenylnaphthyl, Phenanthrenyl, Dimethylfluorenyl, Dibenzofuranyl, Dibenzothiophenyl, Carbazolyl oder Phenylcarbazolyl sind,
wobei Ar'₁ und Ar'₂ unsubstituiert oder mit mindestens einem Deuterium substituiert sind.

11. Organische lichtemittierende Vorrichtung gemäß Anspruch 1, wobei:
die durch die Chemische Formel 2 dargestellte Verbindung eine beliebige ist, die aus der Gruppe ausgewählt ist, die besteht aus:

12. Organische lichtemittierende Vorrichtung gemäß Anspruch 1, wobei:
die Chemische Formel 3A über ein beliebiges von R"₁, R"₂, R"₄, R"₅ und R"₈ bis R"₁₀ mit der Chemischen Formel 3 verknüpft ist.

13. Organische lichtemittierende Vorrichtung gemäß Anspruch 1, wobei:
L"₁ bis L"₃ jeweils unabhängig voneinander eine Einfachbindung, Phenylen, Biphenyldiyl, Naphthalindiyl oder Dimethylfluordiyl sind,
wobei das Phenylen, Biphenyldiyl, Naphthalindiyl und Dimethylfluordiyl jeweils unabhängig voneinander unsubstituiert oder mit mindestens einem Deuterium substituiert sind.

14. Organische lichtemittierende Vorrichtung gemäß Anspruch 1, wobei:
Ar"₁ und Ar"₂ jeweils unabhängig voneinander Phenyl, Triphenylsilylphenyl, Biphenylyl, Terphenylyl, Naphthyl, Phenanthrenyl, Dimethylfluorenyl, Spirobifluorenyl, Dibenzofuranyl, Dibenzothiophenyl oder Phenylcarbazolyl sind,
wobei Ar"₁ und Ar"₂ jeweils unabhängig voneinander unsubstituiert oder mit mindestens einem Deuterium substituiert sind.

15. Organische lichtemittierende Vorrichtung gemäß Anspruch 1, wobei:
die durch die Chemische Formel 3 dargestellte Verbindung eine beliebige ist, die aus der Gruppe ausgewählt ist, die besteht aus:

## Revendications

1. Dispositif électroluminescent organique comprenant :
une anode (2) ; une cathode (4) ; et une couche électroluminescente (3) interposée entre l'anode et la cathode,
dans lequel la couche électroluminescente inclut,
un ou plusieurs composés représentés par la formule chimique 1 suivante, un
ou plusieurs composés représentés par la formule chimique 2 suivante et un
ou plusieurs composés représentés par la formule chimique 3 suivante :
dans la formule chimique 1,
Ar₁ et Ar₂ sont chacun indépendamment un aryle en C₆₋₆₀ substitué ou non substitué ; ou un hétéroaryle en C₂₋₆₀ substitué ou non substitué contenant un ou plusieurs éléments sélectionnés parmi le groupe consistant en N, O et S,
L₁ à L₃ sont chacun indépendamment une liaison simple ; ou un arylène en C₆₋₆₀ substitué ou non substitué,
chaque R₁ est indépendamment un hydrogène ; un deutérium ; un aryle en C₆₋₆₀ substitué ou non substitué ; ou un hétéroaryle en C₂₋₆₀ substitué ou non substitué contenant un ou plusieurs éléments sélectionnés parmi le groupe consistant en N, O et S, et
a est un nombre entier de 0 à 7,
dans la formule chimique 2,
X'₁ est N et X'₂ est O ; ou X'₁ est O, et X'₂ est N,
l'un quelconque parmi R'₁ à R'₇ est lié à la formule chimique 2A suivante, et les autres sont chacun indépendamment un hydrogène ; un deutérium ; un aryle en C₆₋₆₀ substitué ou non substitué ; ou un hétéroaryle en C₂₋₆₀ substitué ou non substitué contenant un ou plusieurs éléments sélectionnés parmi le groupe consistant en N, O et S,
dans la formule chimique 2A,
L'₁ à L'₃ sont chacun indépendamment une liaison simple ; ou un arylène en C₆₋₆₀ substitué ou non substitué, et
Ar'₁ et Ar'₂ sont chacun indépendamment un aryle en C₆₋₆₀ substitué ou non substitué ; ou un hétéroaryle en C₂₋₆₀ substitué ou non substitué contenant un ou plusieurs éléments sélectionnés parmi le groupe consistant en N, O et S,
dans la formule chimique 3,
X" est O ou S, et
l'un quelconque parmi R"₁ à R"₁₀ est lié à la formule chimique 3A suivante, et les autres sont un hydrogène ou un deutérium,
dans la formule chimique 3A,
L"₁ à L"₃ sont chacun indépendamment une liaison simple ; ou un arylène en C₆₋₆₀ substitué ou non substitué, et
Ar"₁ et Ar"₂ sont chacun indépendamment un aryle en C₆₋₆₀ substitué ou non substitué ; ou un hétéroaryle en C₂₋₆₀ substitué ou non substitué contenant un ou plusieurs éléments sélectionnés parmi le groupe consistant en N, O et S.

2. Dispositif électroluminescent organique selon la revendication 1, dans lequel :
Ar₁ et Ar₂ sont chacun indépendamment un phényle, un triphénylsilylphényle, un biphénylyle, un terphénylyle, un naphtyle, un phénanthrényle, un chrysényle, un benzo[c]phénanthrényle, un dibenzofuranyle, ou un dibenzothiophényle,
dans lequel Ar₁ et Ar₂ sont chacun indépendamment non substitué ou substitué avec au moins un deutérium.

3. Dispositif électroluminescent organique selon la revendication 1, dans lequel :
L₁ à L₃ sont chacun indépendamment une liaison simple, un phénylène, un biphényldiyle, un naphtalènediyle, un phénylnaphtalènediyle, ou un naphthylnaphtalènediyle,
dans lequel lorsque L₁ à L₃ sont un phénylène, un biphényldiyle, un naphalènediyle, un phénylnaphtalènediyle, ou un naphtylnaphtalènediyle, L₁ à L₃ sont non substitués ou substitués avec au moins un deutérium.

4. Dispositif électroluminescent organique selon la revendication 1, dans lequel :
chaque R₁ est indépendamment un hydrogène, un deutérium, un phényle, un biphénylyle, un terphénylyl, un naphtyle, un phénanthrényle, un triphénylényle, un naphtylphényle, un phénylnaphtyle, un fluoranthényle, un dibenzofuranyle, un dibenzothiophényle, un benzonaphtofuranyle ou un benzonaphtothiophényle,
dans lequel lorsque R₁ est un phényle, un biphénylyle, un terphénylyle, un naphtyle, un phénanthrényle, un triphénylényle, un naphtylphényle, un phénylnaphtyle, un fluoranthényle, un dibenzofuranyle, un dibenzothiophényle, un benzonaphtofuranyle, ou un benzonaphtothiophényle, chaque R₁ est indépendamment non substitué ou substitué avec au moins un deutérium.

5. Dispositif électroluminescent organique selon la revendication 1, dans lequel :
au moins l'un parmi Ar₁, Ar₂ et R₁ est un phényle, un naphtyle, un phénylnaphtyle, un naphtylphényle, un phénanthrényle, un fluoranthényle, un dibenzofuranyle, un dibenzothiophényle, un benzonaphtofuranyle ou un benzonaphtothiophényle,
dans lequel Ar₁, Ar₂ et R₁ sont chacun indépendamment non substitués ou substitués avec au moins un deutérium.

6. Dispositif électroluminescent organique selon la revendication 1, dans lequel :
le composé représenté par la formule chimique 1 est un élément quelconque sélectionné parmi le groupe consistant en :

7. Dispositif électroluminescent organique selon la revendication 1, dans lequel :
le composé représenté par la formule chimique 2 est représenté soit par la formule chimique 2-1 suivante, soit par la formule chimique 2-2 suivante :
dans lequel, dans la formule chimique 2-1 et la formule chimique 2-2,
R'₁ à R'₆ sont un hydrogène ou un deutérium,
R'₇ est un aryle en C₆₋₆₀ substitué ou non substitué ; ou un hétéroaryle en C₂₋₆₀ substitué ou non substitué contenant un ou plusieurs éléments sélectionnés parmi le groupe consistant en N, O et S, et
X'₁, X'₂, L'₁ à L'₃, Ar'₁ et Ar'₂ sont tels que définis dans la revendication 1.

8. Dispositif électroluminescent organique selon la revendication 1, dans lequel :
l'un quelconque parmi R'₁ à R'₇ est de formule chimique 2A, et les autres sont chacun indépendamment un hydrogène, un deutérium, un phényle, un biphénylyle ou un naphtyle,
dans lequel le phényle, le biphénylyle et le naphtyle sont chacun indépendamment non substitués ou substitués avec au moins un deutérium.

9. Dispositif électroluminescent organique selon la revendication 1, dans lequel :
L'₁ à L'₃ sont chacun indépendamment une liaison simple, un phénylène, un biphényldiyle, un terphényldiyle, un naphtalènediyle, ou un phénylnaphtalènediyle,
dans lequel le phénylène, le biphényldiyle, le terphényldiyle, le naphtalènediyle et le phénylnaphtalènediyle sont chacun indépendamment non substitués ou substitués avec au moins un deutérium.

10. Dispositif électroluminescent organique selon la revendication 1, dans lequel :
Ar'₁ et Ar'₂ sont chacun indépendamment un phényle, un biphénylyle, un terphénylyle, un naphtyle, un phénylnaphtyle, un phénanthrényle, un diméthylfluorényle, un dibenzofuranyle, un dibenzothiophényle, un carbazolyle ou un phénylcarbazolyle,
dans lequel Ar'₁ et Ar'₂ sont non substitués ou substitués avec au moins un deutérium.

11. Dispositif électroluminescent organique selon la revendication 1, dans lequel :
le composé représenté par la formule chimique 2 est un élément quelconque sélectionné parmi le groupe consistant en :

12. Dispositif électroluminescent organique selon la revendication 1, dans lequel :
la formule chimique 3A est liée à l'un quelconque parmi R"₁, R"₂, R"₄, R"₅ et R"₈ à R"₁₀ de la formule chimique 3.

13. Dispositif électroluminescent organique selon la revendication 1, dans lequel :
L"₁ à L"₃ sont chacun indépendamment une liaison simple, un phénylène, un biphényldiyle, un naphtalènediyle, ou un diméthylfluorènediyle,
dans lequel le phénylène, le biphényldiyle, le naphtalènediyle et le diméthylfluorènediyle sont chacun indépendamment non substitués ou substitués avec au moins un deutérium.

14. Dispositif électroluminescent organique selon la revendication 1, dans lequel :
Ar"₁ et Ar"₂ sont chacun indépendamment un phényle, un triphénylsilylphényle, un biphénylyle, un terphénylyle, un naphtyle, un phénanthrényle, un diméthylfluorényle, un spirobifluorényle, un dibenzofuranyle, un dibenzothiophényle ou un phénylcarbazolyle,
dans lequel Ar"₁ et Ar"₂ sont chacun indépendamment non substitué ou substitué avec au moins un deutérium.

15. Dispositif électroluminescent organique selon la revendication 1, dans lequel :
le composé représenté par la formule chimique 3 est un élément quelconque sélectionné parmi le groupe consistant en :
